(19) Europäisches Patentamt
European Patent Office
Office européen des brevets

(11) EP 2 117 062 B1

(12) **EUROPEAN PATENT SPECIFICATION**

(45) Date of publication and mention of the grant of the patent:
**18.01.2017 Bulletin 2017/03**

(21) Application number: **08721478.9**

(22) Date of filing: **06.03.2008**

(51) Int Cl.:
***C09K 11/06*** (2006.01) ***H01L 51/50*** (2006.01)
***C08G 65/18*** (2006.01) ***H05B 33/14*** (2006.01)

(86) International application number:
**PCT/JP2008/054058**

(87) International publication number:
**WO 2008/108430 (12.09.2008 Gazette 2008/37)**

(54) **COMPOSITION FOR ORGANIC DEVICE, POLYMER MEMBRANE AND ORGANIC ELECTROLUMINESCENT DEVICE**

ZUSAMMENSETZUNG FÜR ORGANISCHES BAUELEMENT, POLYMERMEMBRAN UND ORGANISCHE ELEKTROLUMINESZENZVORRICHTUNG

COMPOSITION POUR UN DISPOSITIF ORGANIQUE, MEMBRANE POLYMÈRE ET DISPOSITIF ÉLECTROLUMINESCENT ORGANIQUE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **07.03.2007 JP 2007057363**

(43) Date of publication of application:
**11.11.2009 Bulletin 2009/46**

(73) Proprietor: **Mitsubishi Chemical Corporation**
**Chiyoda-ku**
**Tokyo 100-8251 (JP)**

(72) Inventors:
- **OKABE, Kazuki**
  **Yokohama-shi**
  **Kanagawa 227-8502 (JP)**
- **OGATA, Tomoyuki**
  **Yokohama-shi**
  **Kanagawa 227-8502 (JP)**
- **IIDA, Koichiro**
  **Yokohama-shi**
  **Kanagawa 227-8502 (JP)**

(74) Representative: **Hoffmann Eitle**
**Patent- und Rechtsanwälte PartmbB**
**Arabellastraße 30**
**81925 München (DE)**

(56) References cited:
**WO-A1-2005/052027 JP-A- 2002 194 070**
**JP-A- 2005 533 873**

- **O. NUYKEN ET.AL.: "Modern Trends in Organic Light-Emitting Devices (OLEDs)", MONATSHEFTE FÜR CHEMIE, vol. 137, 2006, pages 811-824, XP002636874,**
- **B. DOMERCQ ET.AL.: "Photo-patternable hole-transport polymers for organic light-emitting diodes", CHEM. MATER., vol. 15, 2003, pages 1491-1496, XP002636875,**
- **E. BACHER ET.AL.: "Photopatterning of crosslinkable hole-conducting materials for application in organic light-emitting devices", MACROMOL. RAPID COMMUN., vol. 25, 2004, pages 1191-1196, XP002636876,**
- **E. BACHER ET.AL.: "Synthesis and characterization of photo-cross-linkable hole-conducting polymers", MACROMOLECULES, vol. 38, 2005, pages 1640-1647, XP002636877,**
- **O. SOLOMESHCH ET.AL.: "Electronic formulations - photopatterning of luminescent conjugated polymers", ADV. FUNCT. MATER., vol. 16, 2006, pages 2095-2102, XP002636878,**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 117 062 B1

## Description

### Technical Field

The present invention relates to an organic electroluminescent element that comprises an anode and a cathode on a substrate and at least one organic layer disposed between the anode and the cathode, and a method for its production.

### Background Art

In recent years, electroluminescent devices that include an organic thin film (organic electroluminescent elements) have been developed. Examples of a method for forming an organic thin film in an organic electroluminescent element include a vacuum evaporation method and a wet deposition method.

Because the vacuum evaporation method allows for lamination, the vacuum evaporation method can improve charge injection from an anode and/or a cathode and facilitate the confinement of excitons in a light-emitting layer.

The wet deposition method advantageously obviates the need for a vacuum process, can easily provide a large deposition area, and can easily introduce a plurality of materials having various functions into a single layer (coating solution).

However, because the wet deposition method has difficulty in lamination, the wet deposition method is inferior in operation stability to the vacuum evaporation method. Thus, except for some cases, the wet deposition method has never been developed to a practical level.

In lamination by the wet deposition method, a first layer is formed using an aqueous solvent and a polymer that is insoluble in an organic solvent, and a second layer is formed on the first layer using an organic solvent. However, a third or upper layer is difficult to form.

To solve these problems, Patent Document 1 describes a method in which a compound having the following cross-linking group is polymerized after its application to form an insolubilized film.

[Formula 1]

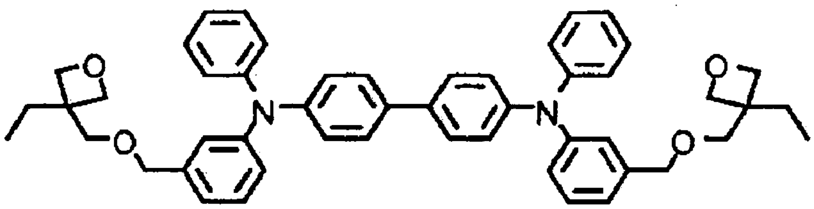

However, this method did not provide an organic electroluminescent element having high operation stability.

Bacher et. al. (Macromolecules, Volume 38, 2005, pages 1640-1647, "Synthesis and Characterization of Photo-Cross-Linkable Hole-Conducting Polymers") describe the synthesis and characterization of side-chain polymers functionalized with hole-transporting units and photo-cross-linkable groups, which can be used for solution-based preparation of multilayer organic light-emitting devices (OLEDs). The concept deals with triarylamine and oxetane-functionalized styrenes, which are copolymerized by radical polymerization.

Solomeshch et. al. (Adv. Funct. Mater., Vol. 16, 2006, pages 2095-2102, "Electronic Formulations - Photopatterning of Luminescent Conjugated Polymers") describe that the versatility of light-emitting conjugated polymers in terms of optoelectronic properties is enormous, yet that tailoring of other essential properties has been relatively limited. In other fields such a problem would be rectified using material formulations. However, the need to maintain high optoelectronic compatibility between components has hampered such development. The document proposes additive molecules that are compatible with a family of luminescent polymers, and their performance in a light-emitting diode configuration is demonstrated. This formulation is aimed to adjust the glass-transition temperature, maintain/improve film-forming ability, and introduce a crosslinking functionality.

[Patent Document 1] Japanese Unexamined Patent Application Publication No. 2004-199935

### Disclosure of Invention

It is an object of the present invention to provide an organic electroluminescent element having high operation stability.

As a result of diligent research, the present inventors completed the present invention by finding that the above-mentioned problems can be solved by using at least two cross-linking compounds having different numbers of cross-linking groups selected from

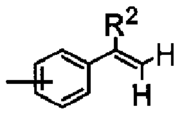

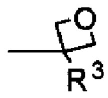

and

wherein $R^2$ and $R^3$ each independently denote a hydrogen atom or an alkyl group, and wherein the crosslinking compounds are compounds having a partial structure of the following formula [109]:

[Formula 109]

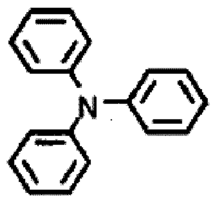

An organic electroluminescent element according to the present invention thus includes an anode and a cathode on a substrate and at least one organic layer disposed between the anode and the cathode, wherein the at least one organic layer is a layer that is produced by forming a film of a composition that comprises at least two cross-linking compounds and then polymerizing the cross-linking compounds, wherein at least two of the cross-linking compounds have different numbers of cross-linking groups selected from

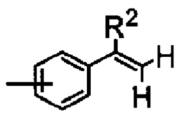

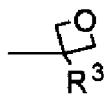

and

wherein $R^2$ and $R^3$ each independently denote a hydrogen atom or an alkyl group, and wherein the crosslinking compounds are compounds having a partial structure of the following formula [109]:

[Formula 109]

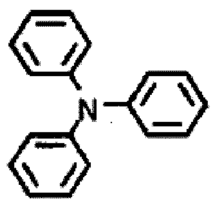

Because a composition that comprises at least two cross-linking compounds as defined above can provide a highly stable polymer film, an organic electroluminescent element that includes a layer produced by forming a film of the composition and then polymerizing the cross-linking compounds has high operation stability.

Thus, an organic electroluminescent element that includes a layer formed using the above-defined composition may be applied to flat-panel displays (for example, for use in office automation computers and wall-mounted television sets), light sources that utilize the characteristics of a surface illuminant (for example, light sources for use in copying machines and backlight sources for use in liquid crystal displays and measuring instruments), display boards, and marker lamps, and is therefore of great technical value. Brief Description of Drawings

[Fig. 1] Fig. 1 is a schematic cross-sectional view of the structure of an organic electroluminescent element according to an embodiment of the present invention.

Detailed Description

Embodiments of an organic electroluminescent element according to the present invention will now be described in detail. However, the following description of constituent features is an example (representative example) of aspects of the present invention.

[1] Composition that comprises at least two cross-linking compounds

As described above, conventional organic devices that include, as an organic layer, a film formed by polymerization of a cross-linking compound as in the present invention could not have high operation stability.

A study carried out by the present inventors suggested that only one cross-linking compound used in the conventional organic devices did not allow the control of the number of cross-linking groups, leaving many unreacted cross-linking groups after polymerization, and these unreacted cross-linking groups are responsible for low operation stability.

Thus, in the present invention, the present inventors tried to control the number of cross-linking groups by using at least two cross-linking compounds having different numbers of cross-linking groups, as further defined in claim 1, and successfully improved the operation stability. The present inventors assume that the number of cross-linking groups could be controlled to decrease the number of unreacted cross-linking groups.

While the composition for producing the at least one organic layer contains at least two cross-linking compounds, the composition typically contains 10 or less cross-linking compounds, preferably five or less, more preferably three or less, and particularly preferably two cross-linking compounds. At least two of the cross-linking compounds are compounds that have different numbers of cross-linking groups selected from

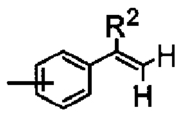

and

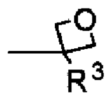

wherein $R^2$ and $R^3$ each independently denote a hydrogen atom or an alkyl group, and are compounds having a partial structure of the following formula [109]:

[Formula 109]

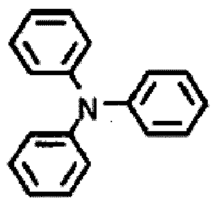

A composition for producing the organic layer generally contains the cross-linking compounds, a solvent, and various optional additive agents.

[Cross-Linking Compound]

A cross-linking compound in the present invention is a compound that has at least one cross-linking group. Examples of the cross-linking compound include monomers (compounds having a single molecular weight) having a cross-linking group, oligomers (low-molecular-weight polymeric substances having constitutional repeating units) having a cross-linking group, and polymers (high-molecular-weight polymeric substances having constitutional repeating units) having a cross-linking group.

Thus, a composition for producing the at least one organic layer of the organic electroluminescent element may contain the following (1) to (3) as cross-linking compounds.

(1) contains at least two compounds having a single molecular weight (monomers)
(2) contains at least two polymeric substances having constitutional repeating units (oligomers and/or polymers)
(3) contains at least one compound having a single molecular weight (monomer) and at least one polymeric substance having constitutional repeating units (oligomer and/or polymer)

A cross-linking compound is preferably a compound having a single molecular weight in terms of easy purification and consistent properties. A cross-linking compound is also preferably a polymeric substance having constitutional repeating units, such as an oligomer or a polymer, in terms of excellent film-forming properties.

A cross-linking compound contained in the composition for producing the at least one organic layer is preferably a cross-linking compound having a hole-transporting site, regardless of whether the cross-linking compound is a compound having a single molecular weight or a polymeric substance having constitutional repeating units.

In any aspect of (1) to (3) described above, when a cross-linking compound contained in the composition for producing the at least one organic layer has at least two cross-linking groups, a plurality of cross-linking groups in the cross-linking compound may be the same or different.

Likewise, for at least two cross-linking compounds contained in the composition for producing the at least one organic layer, cross-linking groups of each of the cross-linking compounds may be the same or different.

{A composition that contains a compound having a single molecular weight as a cross-linking compound}

A compound having a single molecular weight, as used herein, refers to a compound that has no molecular weight distribution, unlike a polymeric substance having constitutional repeating units, and whose molecular weight can be uniquely defined by the structure of the compound.

A compound having a single molecular weight as a cross-linking compound contained in a composition for use in an organic device according to the present invention typically has a molecular weight of 5000 or less, preferably 2500 or less, and preferably 300 or more, more preferably 500 or more.

At a molecular weight above this upper limit, impurities may have a high molecular weight and may be difficult to remove. At a molecular weight below this lower limit, the glass transition temperature, melting point, and vaporization temperature may be decreased, and therefore the heat resistance may deteriorate greatly.

The number of cross-linking groups in one molecule of cross-linking compound having a single molecular weight is at least one, preferably eight or less, and more preferably four or less.

When a composition for producing the at least one organic layer contains cross-linking compounds having a single molecular weight, to facilitate the control of the number of cross-linking groups to decrease unreacted cross-linking groups after polymerization, the composition preferably contains a cross-linking compound having one cross-linking group and a cross-linking compound having at least two cross-linking groups, in particular, a cross-linking compound having one cross-linking group and a cross-linking compound having two cross-linking groups.

The amount of each of cross-linking compounds having different numbers of cross-linking groups contained in the composition for producing the at least one organic layer can be appropriately determined. When cross-linking compounds having a single molecular weight are used, the number of moles of cross-linking compound having a smaller number of cross-linking groups is preferably larger than the number of moles of cross-linking compound having a larger number of cross-linking groups, because unreacted cross-linking groups after polymerization can be decreased under this condition. In particular, when a composition for producing the at least one organic layer contains only two cross-linking compounds having different numbers of cross-linking groups, the molar ratio of the two cross-linking compounds, (the cross-linking compound having a smaller number of cross-linking groups):(the cross-linking compound having a larger number of cross-linking groups), preferably ranges from 60:40 to 99:1, more preferably from 70:30 to 95:5.

When a composition for producing the at least one organic layer contains at least three cross-linking compounds having different numbers of cross-linking groups, at least one of the cross-linking compounds is preferably a cross-linking compound having one cross-linking group. In this case, the content ratio of the cross-linking compounds in the composition for use in an organic device is (total of the cross-linking compound having one cross-linking group):(total of the cross-linking compounds having at least two cross-linking groups) preferably in the range of 60:40 to 99:1, more preferably in the range of 70:30 to 95:5, by molar ratio.

{A composition that contains a polymeric substance having constitutional repeating units as a cross-linking compound}

When a composition for producing the at least one organic layer contains at least two polymeric substances having constitutional repeating units as cross-linking compounds, the cross-linking compounds may be at least two compounds having different average numbers of cross-linking groups per constitutional repeating unit and/or different numbers of cross-linking groups in portions other than the constitutional repeating units.

A cross-linking group in a polymeric substance having constitutional repeating units (hereinafter also referred to simply as a "polymeric substance". A polymeric substance, as used herein, refers to a polymeric substance in a broad sense, including copolymers.) acting as a cross-linking compound contained in a composition for producing the at least one organic layer may be present in the constitutional repeating units or in a portion other than the constitutional repeating units (for example, an end of a molecule of polymeric substance).

Unlike compounds having a single molecular weight, a polymeric substance having constitutional repeating

units has a molecular weight distribution. Thus, the number of cross-linking groups per molecule of polymeric substance (a unit of polymeric substance having constitutional repeating units), the number of cross-linking groups per molecular weight of a polymeric substance, and the number of constitutional repeating units in one molecule of polymeric substance are generally expressed as mean values, like the average molecular weight of a polymeric substance. In the present invention, the number of cross-linking groups of a polymeric substance is evaluated by "the average number of cross-linking groups" and "the average number of cross-linking groups per constitutional repeating unit".

<Average Number of Cross-Linking Groups>

The average number of cross-linking groups is a mean value of the number of cross-linking groups present in one molecule of polymeric substance. This average number of cross-linking groups can be determined from the structural formula of a molecule of polymeric substance, which is determined from the ratio of monomers charged in the synthesis of the polymeric substance and the weight-average molecular weight of the synthesized polymeric substance.

For example, a target compound 29 (cross-linking compound (H9) used in Example 8) synthesized in Synthesis Example 9 described below has a weight-average molecular weight of 144000 and has the following structural formula on the basis of the ratio of monomers charged in the synthesis. The mean value of the number of constitutional repeating units that have two cross-linking groups (a constitutional repeating unit on the right side in the following structural formula) in one molecule of polymeric substance is 26.81. Thus, the average number of cross-linking groups is calculated to be 53.62.

[Formula 2]

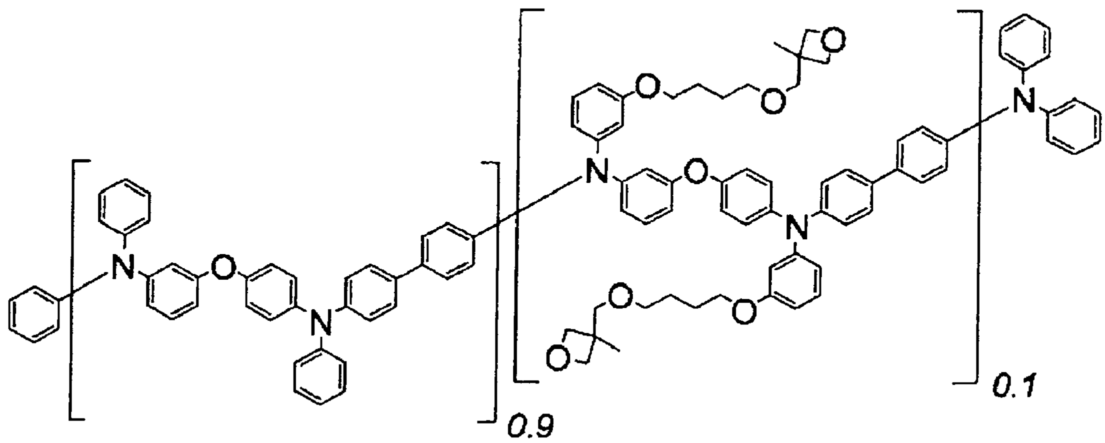

(H9)

In the same manner, a target compound 30 (cross-linking compound (H10) used in Example 8) synthesized in Synthesis Example 10 described below has a weight-average molecular weight of 92400 and has the following structural formula on the basis of the ratio of monomers charged in the synthesis. The mean value of the number of constitutional repeating units that have two cross-linking groups (a constitutional repeating unit on the right side in the following structural formula) in one molecule of polymeric substance is 68.46. Thus, the average number of cross-linking groups is calculated to be 136.92.

[Formula 3]

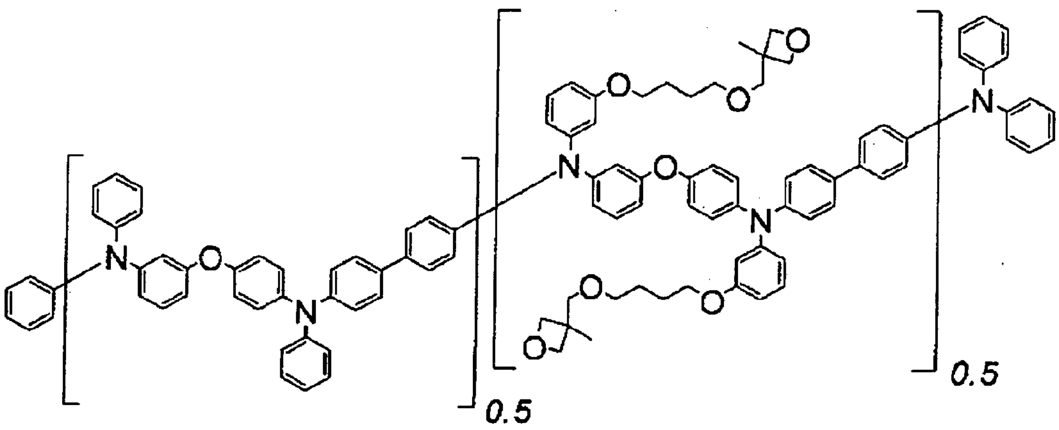

(H10)

When a molecule of polymeric substance has cross-linking groups at ends thereof rather than in constitutional repeating units, the number of cross-linking groups present at ends is equal to the average number of cross-linking groups.

Thus, when a composition for producing the at least one organic layer contains a polymeric substance having constitutional repeating units as a cross-linking compound, the number of cross-linking groups of the cross-linking compound, that is, the polymeric substance, refers to the average number of cross-linking groups per constitutional repeating unit.

<Average Number of Cross-Linking Groups per Constitutional Repeating Unit>

The average number of cross-linking groups determined as described above is divided by the average total number of constitutional repeating units per molecule of polymeric substance to determine the average number of cross-linking groups per constitutional repeating unit.

For example, the aforementioned compound (H9) has a mean value of the total number of constitutional repeating units of 268.13 on the basis of the structural formula determined by the weight-average molecular weight of the compound and the ratio of monomers charged in the synthesis. Thus, the average number of cross-linking groups per constitutional repeating unit is 0.2, which is calculated by dividing the average number of cross-linking groups of 53.62 described above by 268.13.

In the same manner, the aforementioned compound (H10) has a mean value of the total number of constitutional repeating units of 136.92 on the basis of the structural formula determined by the weight-average molecular weight of the compound and the ratio of monomers charged in the synthesis. Thus, the average number of cross-linking groups per constitutional repeating unit is 1.0, which is calculated by dividing the average number of cross-linking groups of 136.92 described above by 136.92.

The method for measuring the weight-average molecular weight of a polymeric substance is described later.

In the present invention, the average number of cross-linking groups of a polymeric substance acting as a cross-linking compound is preferably at least one, more preferably at least two, and preferably 200 or less, more preferably 100 or less. An average number of cross-linking groups of a polymeric substance below this lower limit may result in insufficient insolubilization. Thus, a layered film may not be formed by a wet deposition method. An average number of cross-linking groups of a polymeric substance above this upper limit may result in a rough film because of cracking.

When cross-linking groups are present in portions other than constitutional repeating units of a polymeric substance, the number of cross-linking groups in portions other than the constitutional repeating units of a polymeric substance is typically three or less, preferably two or less. Above this upper limit, the cross-linking density increases locally, and therefore the film quality may deteriorate.

The average number of cross-linking groups per constitutional repeating unit of a polymeric substance is preferably at least 0.005, more preferably at least 0.01, and preferably 3.0 or less, more preferably 2.0 or less, still more preferably 1.0 or less. An average number of cross-linking groups per constitutional repeating unit of a polymeric substance below this lower limit may result in insufficient insolubilization. Thus, a film may not be formed by a wet deposition

method. Above this upper limit, a flat film may not be formed because of cracking.

The weight-average molecular weight of the polymeric substance is typically 3,000,000 or less, preferably 1,000,000 or less, more preferably 500,000 or less, and typically 1,000 or more, preferably 2,500 or more, more preferably 5,000 or more.

The number-average molecular weight of the polymeric substance is typically 2,500,000 or less, preferably 750,000 or less, more preferably 400,000 or less, and typically 500 or more, preferably 1,500 or more, more preferably 3,000 or more.

When the molecular weight of the polymeric substance is above this upper limit, impurities may have a high molecular weight and may be difficult to remove. When the molecular weight of the polymeric substance is below this lower limit, the film-forming properties may deteriorate, and the glass transition temperature, melting point, and vaporization temperature may be decreased. The heat resistance may therefore deteriorate greatly.

The molecular weight distribution Mw/Mn (Mw: weight-average molecular weight, Mn: number-average molecular weight) of the polymeric substance is typically 3.0 or less, preferably 2.5 or less, more preferably 2.0 or less, and preferably 1.0 or more, more preferably 1.1 or more, particularly preferably 1.2 or more. The molecular weight distribution of the polymeric substance above this upper limit may cause failures, such as difficult purification, low solubility in solvent, and insufficient charge transport.

The weight-average molecular weight and the number-average molecular weight of the polymeric substance are generally measured by size exclusion chromatography (SEC). In the SEC measurement, a higher molecular weight component has a shorter elution time, and a lower molecular weight component has a longer elution time. The weight-average molecular weight and the number-average molecular weight are calculated by converting the elution time of a sample into the molecular weight using a calibration curve, which is obtained from elution times of polystyrenes having known molecular weights (standard samples).

Preferably, a composition for producing the at least one organic layer contains, as cross-linking compounds, at least two polymeric substances having different average numbers of cross-linking groups per constitutional repeating unit and/or different numbers of cross-linking groups in portions other than the constitutional repeating units. This is because the materials design or the composition can be easily adjusted to produce a film having better physical properties. More preferably, when a composition for producing the at least one organic layer contains polymeric substances having constitutional repeating units as two cross-linking compounds having different numbers of cross-linking groups, the average number LA of cross-linking groups per constitutional repeating unit of a cross-linking compound (A) and the average number LB of cross-linking groups per constitutional repeating unit of a cross-linking compound (B) satisfy the following formulae (I) and (II), wherein the cross-linking compound (A) and the cross-linking compound (B) represent the two different cross-linking compounds.

$$LA > LB \qquad \cdots(I)$$

$$(LA - LB)/LB \geq 0.05 \qquad \cdots(II)$$

The value of (LA - LB)/LB is typically at least 0.05, preferably at least 0.1. At (LA - LB)/LB below this lower limit, the number of unreacted cross-linking groups may increase. While there is no upper limit for (LA - LB)/LB as long as insolubility is achieved, the upper limit is typically 100 or less.

When a composition for producing the at least one organic layer contains at least three polymeric substances, at least two polymeric substances may satisfy the aforementioned formulae (I) and (II).

When cross-linking compounds contained in a composition for producing the at least one organic layer are polymeric substances, the ratio of cross-linking compounds having different numbers of cross-linking groups in the composition for use in an organic device can be appropriately determined, as in the case where compounds having a single molecular weight are contained as cross-linking compounds. Preferably, the weight of a cross-linking compound having a smaller average number of cross-linking groups per constitutional repeating unit is equal to or larger than the weight of a cross-linking compound having a larger average number of cross-linking groups per constitutional repeating unit, because unreacted cross-linking groups after polymerization can be decreased under this condition.

In particular, the cross-linking compound (A):cross-linking compound (B) that satisfy the aforementioned formulae (I) and (II) are contained in a composition for producing the at least one organic layer at a weight ratio preferably in the range of 1:1 to 1:20, more preferably in the range of 1:2 to 1:10.

Furthermore, the cross-linking compound (A):cross-linking compound (B) that satisfy the aforementioned formulae (I) and (II) are contained in a composition for use in an organic device at a molar ratio of constitutional repeating units preferably in the range of 1:1 to 1:20, more preferably in the range of 1:2 to 1:10.

The molar ratio of constitutional repeating units is defined as described below.

[Formula 4]

$$-\left(A_m\right)_{x_m}\left(B_n\right)_{y_n}-$$

(wherein m and n each independently denote an integer of zero or more, $A_m$ denotes a constitutional repeating unit having no cross-linking group, and $B_n$ denotes a constitutional repeating unit having a cross-linking group. $x_m$ and $y_n$ denote the ratio of the numbers of constitutional repeating units in $A_m$ and $B_n$, respectively). In this formula, the molar ratio of constitutional repeating units is expressed by the following equation.

Molar ratio of constitutional repeating units = Weight of polymeric substance having constitutional repeating units (g)/Average molecular weight M of constitutional repeating units

The average molecular weight of constitutional repeating units is expressed by the following equation, regardless of the number of types of constitutional repeating units in the copolymer.

[Numerical Formula 1]

$$M = \left(\sum_m MA_m \times x_m + \sum_n MB_n \times y_n\right) / \left(\sum_m x_m + \sum_n y_n\right)$$

(wherein $MA_m$ denotes the molecular weight of the constitutional repeating unit $A_m$, and $MB_n$ denotes the molecular weight of the constitutional repeating unit $B_n$)

The polymeric substance may be composed only of a constitutional repeating unit having a cross-linking group as a constitutional repeating unit constituting the polymeric substance. The polymeric substance may also be composed only of a constitutional repeating unit having no cross-linking group as a constitutional repeating unit constituting the polymeric substance, provided that a cross-linking group is present in a portion other than the constitutional repeating unit in the polymeric substance. In particular, the polymeric substance is preferably a copolymer composed of a constitutional repeating unit having a cross-linking group and a constitutional repeating unit having no cross-linking group. The constitutional repeating unit having a cross-linking group preferably has three or less, more preferably two or less, cross-linking groups in one constitutional repeating unit.

A copolymer serving as a cross-linking compound may be a random copolymer, an alternating copolymer, a block copolymer, or a graft copolymer, and is preferably a random copolymer in terms of solubility.

In a composition for producing the at least one organic layer when each of at least two cross-linking compounds having different numbers of cross-linking groups is a copolymer, constitutional repeating units constituting each of the at least two copolymers may be the same or different.

The clause "constitutional repeating units constituting each of the at least two copolymers are the same" means that each of the two copolymers is a copolymer composed of, for example, a constitutional repeating unit X and a constitutional repeating unit Y. In this case, a difference in the ratio of the constitutional repeating unit X to the constitutional repeating unit Y in the copolymers provides two copolymers having different average numbers of cross-linking groups per constitutional repeating unit.

In a composition for producing the at least one organic layer preferably, each of at least two cross-linking compounds having different numbers of cross-linking groups is a copolymer, and constitutional repeating units constituting each of the at least two copolymers are the same.

In particular, preferably, each of the at least two copolymers is a copolymer composed of a constitutional repeating unit X having x cross-linking groups and a constitutional repeating unit Y having y cross-linking groups as constitutional repeating units, and the proportions of the constitutional repeating unit X to the constitutional repeating unit Y in the copolymers are different.

Each of x and y denotes an integer, and x and y are different integers, including zero. Each of x and y is

preferably three or less, more preferably two or less.

As described above, a composition for producing the at least one organic layer referably contains, as a cross-linking compound, a copolymer composed of a constitutional repeating unit having a cross-linking group and a constitutional repeating unit having no cross-linking group.

In this case, the constitutional repeating unit having no cross-linking group:the constitutional repeating unit having a cross-linking group in the copolymer preferably ranges from 99.9:0.1 to 1:1.

Thus, when a composition for producing the at least one organic layer contains only polymeric substances as cross-linking compounds, as expressed by the following formulae (IA) and (IB), preferably, two copolymers composed of a constitutional repeating unit X having x cross-linking groups and a constitutional repeating unit Y having y cross-linking groups are contained as the polymeric substances, the proportions of the constitutional repeating unit X to the constitutional repeating unit Y in the two copolymers being different, x being zero, y being three or less, in particular, a positive number of two or less (that is, two or one). Preferably, p:q = 50:50 to 99:1, r:s = 50:50 to 99:1, and q:s = 1:1 to 50:1.

[Formula 5]

$$-\!\!-\![X]_p\!-\![Y]_q\!-\!\!-\qquad (IA)$$

$$-\!\!-\![X]_r\!-\![Y]_s\!-\!\!-\qquad (IB)$$

{A composition for producing the at least one organic layer containing, as cross-linking compounds, a compound having a single molecular weight and a polymeric substance having constitutional repeating units}

A composition for producing the at least one organic layer may be a composition that contains, as at least two cross-linking compounds having different numbers of cross-linking groups, one or at least two polymeric substances having constitutional repeating units and one or at least two compounds having a single molecular weight.

In this case, the compounds having a single molecular weight and the polymeric substances having constitutional repeating units may be those described in the sections {A composition for producing the at least one organic layer that contains a compound having a single molecular weight as a cross-linking compound} and {A composition for producing the at least one organic layer that contains a polymeric substance having constitutional repeating units as a cross-linking compound}.

In particular, preferably, a composition for producing the at least one organic layer contains, as the two cross-linking compounds having different numbers of cross-linking groups, one compound having a single molecular weight and one polymeric substance having constitutional repeating units, the number of cross-linking groups of the compound having a single molecular weight being different from the average number of cross-linking groups per constitutional repeating unit of the polymeric substance having constitutional repeating units.

The number of cross-linking groups of the compound having a single molecular weight may be smaller or larger than the average number of cross-linking groups per constitutional repeating unit of the polymeric substance having constitutional repeating units. Preferably, the average number of cross-linking groups per constitutional repeating unit of the polymeric substance having constitutional repeating units is smaller than the number of cross-linking groups of the compound having a single molecular weight.

Regarding the number of cross-linking groups of the compound having a single molecular weight and the average number of cross-linking groups of the polymeric substance having constitutional repeating units in a composition for use in an organic device, the weight of a cross-linking compound having a smaller number of cross-linking groups (in the case of the polymeric substance, the average number of cross-linking groups per constitutional repeating unit) is preferably equal to or larger than the weight of a cross-linking compound having a larger number of cross-linking groups (in the case of the polymeric substance, the average number of cross-linking groups per constitutional repeating unit). In particular, the weight ratio of the cross-linking compound having a larger number of cross-linking groups (in the case of the polymeric substance, the average number of cross-linking groups per constitutional repeating unit) to the cross-linking compound having a smaller number of cross-linking groups (in the case of the polymeric substance, the average number of cross-linking groups per constitutional repeating unit) preferably ranges from 1:1 to 1:10.

{Cross-Linking Group}

A cross-linking group, as used herein, refers to a group having a group that produces a new chemical bond

through a reaction with the same or different group of another molecule in the neighborhood under heat and/or active energy beam irradiation. Examples of the active energy beam include ultraviolet rays, an electron beam, infrared rays, and a microwave.

Specifically, as long as the composition for forming the at least one organic layer contains at least two cross-linking compounds that have different numbers of cross-linking groups selected from

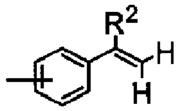

and

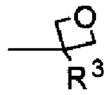

wherein $R^2$ and $R^3$ each independently denote a hydrogen atom or an alkyl group, and which are compounds having a partial structure of the following formula [109]:

[Formula 109]

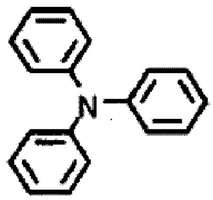

the cross-linking group is not limited to a particular group and is preferably a group that contains an unsaturated double bond, a cyclic ether, or benzocyclobutane. Among others, a group having a group selected from a group T of cross-linking groups described below is preferred.

<Group T of Cross-Linking Groups>

[Formula 6]

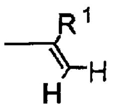
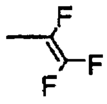
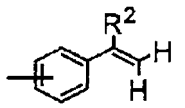
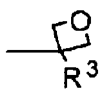
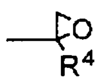
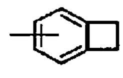

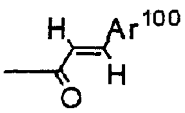
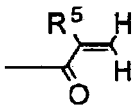
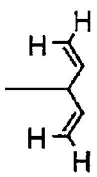
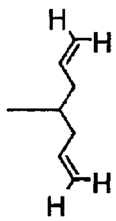
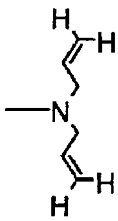

(wherein $R^1$ to $R^5$ each independently denote a hydrogen atom or an alkyl group. $Ar^{100}$ denotes an aromatic hydrocarbon group optionally having a substituent or a heteroaromatic ring group optionally having a substituent.)

The alkyl group of $R^1$ to $R^5$ may be an alkyl group having 1 to 20 carbon atoms and, in particular, is preferably an alkyl group having 1 to 4 carbon atoms.

Examples of the aromatic hydrocarbon group of $Ar^{100}$ include univalent groups derived from 6-membered monocyclic rings or bicyclic to pentacyclic fused rings, such as a benzene ring, a naphthalene ring, an anthracene ring, a phenanthrene ring, a perylene ring, a tetracene ring, a pyrene ring, a benzpyrene ring, a chrysene ring, a triphenylene ring, an acenaphthene ring, and a fluoranthene ring.

Examples of the heteroaromatic ring group of $Ar^{100}$ include univalent groups derived from 5- or 6-membered monocyclic rings or bicyclic to tetracyclic fused rings, such as a furan ring, a benzofuran ring, a thiophene ring, a benzothiophene ring, a pyrrole ring, a pyrazole ring, an imidazole ring, an oxadiazole ring, an indole ring, a carbazole

ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzoisoxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a cinnoline ring, a quinoxaline ring, a phenanthridine ring, a benzoimidazole ring, a perimidine ring, a quinazoline ring, a quinazolinone ring, and an azulene ring.

In terms of electrochemical stability and/or reactivity (cross-linking reactivity), $Ar^{100}$ is preferably a univalent group derived from a ring selected from the group consisting of a benzene ring, a naphthalene ring, an anthracene ring, a phenanthrene ring, a thiophene ring, a furan ring, and a pyridine ring and is more preferably an unsubstituted phenyl group or a monosubstituted or disubstituted phenyl group.

Examples of the optional substituent in the aromatic hydrocarbon group or the heteroaromatic ring group of $Ar^{100}$ include one or at least two selected from the following group Z of substituent groups.

<Group Z of Substituent Group>

Alkyl groups preferably having 1 to 24 carbon atoms, more preferably having 1 to 12 carbon atoms, such as a methyl group and an ethyl group;
alkenyl groups preferably having 2 to 24 carbon atoms, more preferably having 2 to 12 carbon atoms, such as a vinyl group;
alkynyl groups preferably having 2 to 24 carbon atoms, more preferably having 2 to 12 carbon atoms, such as an ethynyl group;
alkoxy groups preferably having 1 to 24 carbon atoms, more preferably having 1 to 12 carbon atoms, such as a methoxy group and an ethoxy group;
aryloxy groups preferably having 4 to 36 carbon atoms, more preferably having 5 to 24 carbon atoms, such as a phenoxy group, a naphthoxy group, and a pyridyloxy group;
alkoxycarbonyl groups preferably having 2 to 24 carbon atoms, more preferably having 2 to 12 carbon atoms, such as a methoxycarbonyl group and an ethoxycarbonyl group;
dialkylamino groups preferably having 2 to 24 carbon atoms, more preferably having 2 to 12 carbon atoms, such as a dimethylamino group and a diethylamino group;
diarylamino groups preferably having 10 to 36 carbon atoms, more preferably having 12 to 24 carbon atoms, such as a diphenylamino group, a ditolylamino group, and an N-carbazolyl group;
arylalkylamino groups preferably having 6 to 36 carbon atoms, more preferably having 7 to 24 carbon atoms, such as a phenylmethylamino group;
acyl groups preferably having 2 to 24 carbon atoms, more preferably having 2 to 12 carbon atoms, such as an acetyl group and a benzoyl group;
halogen atoms, such as a fluorine atom and a chlorine atom;
haloalkyl groups preferably having 1 to 12 carbon atoms, more preferably having 1 to 6 carbon atoms, such as a trifluoromethyl group;
alkylthio groups preferably having 1 to 24 carbon atoms, more preferably having 1 to 12 carbon atoms, such as a methylthio group and an ethylthio group;
arylthio groups preferably having 4 to 36 carbon atoms, more preferably having 5 to 24 carbon atoms, such as a phenylthio group, a naphthylthio group, and a pyridylthio group;
silyl groups preferably having 2 to 36 carbon atoms, more preferably having 3 to 24 carbon atoms, such as a trimethylsilyl group and a triphenylsilyl group;
siloxy groups preferably having 2 to 36 carbon atoms, more preferably having 3 to 24 carbon atoms, such as a trimethylsiloxy group and a triphenylsiloxy group;
a cyano group;
aromatic hydrocarbon ring groups preferably having 6 to 36 carbon atoms, more preferably having 6 to 24 carbon atoms, such as a phenyl group and a naphthyl group; and
heteroaromatic ring groups preferably having 3 to 36 carbon atoms, more preferably having 4 to 24 carbon atoms, such as a thienyl group and a pyridyl group.
Each of these substituents may further have a substituent, which may be a group listed in the group Z of substituent groups.

In terms of solubility, preferably, the substituent that $Ar^{100}$ may have is each independently an alkyl group having 1 to 12 carbon atoms and an alkoxy group having 1 to 12 carbon atoms.

Provided that the composition for forming the at least one organic layer contains at least two cross-linking compounds that have different numbers of cross-linking groups selected from

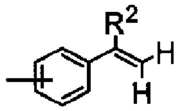 and 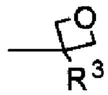

wherein $R^2$ and $R^3$ each independently denote a hydrogen atom or an alkyl group, and which are compounds having a partial structure of the following formula [109]:

[Formula 109]

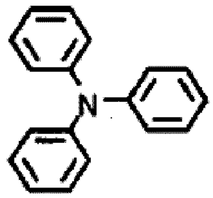

a cross-linking compound preferably has an intramolecular aromatic hydrocarbon group and/or heteroaromatic ring group. In this case, a cross-linking group may be intramolecularly and directly bound to the intramolecular aromatic hydrocarbon group or heteroaromatic ring group. Preferably, a cross-linking group is bound to the aromatic hydrocarbon group or heteroaromatic ring group through a bivalent group in which 1 to 30 groups selected from an -O- group, a -C(=O)- group, or a $-CH_2-$ group (optionally having a substituent) are bound to each other in any order.

Specific examples of a cross-linking group including the bivalent group, that is, a group having a cross-linking group include, but not limited to, the following T-1 to T-84.

The molecular weight of the group having a cross-linking group is typically at least 25, and typically 400 or less, preferably 200 or less.

[Formula 7]

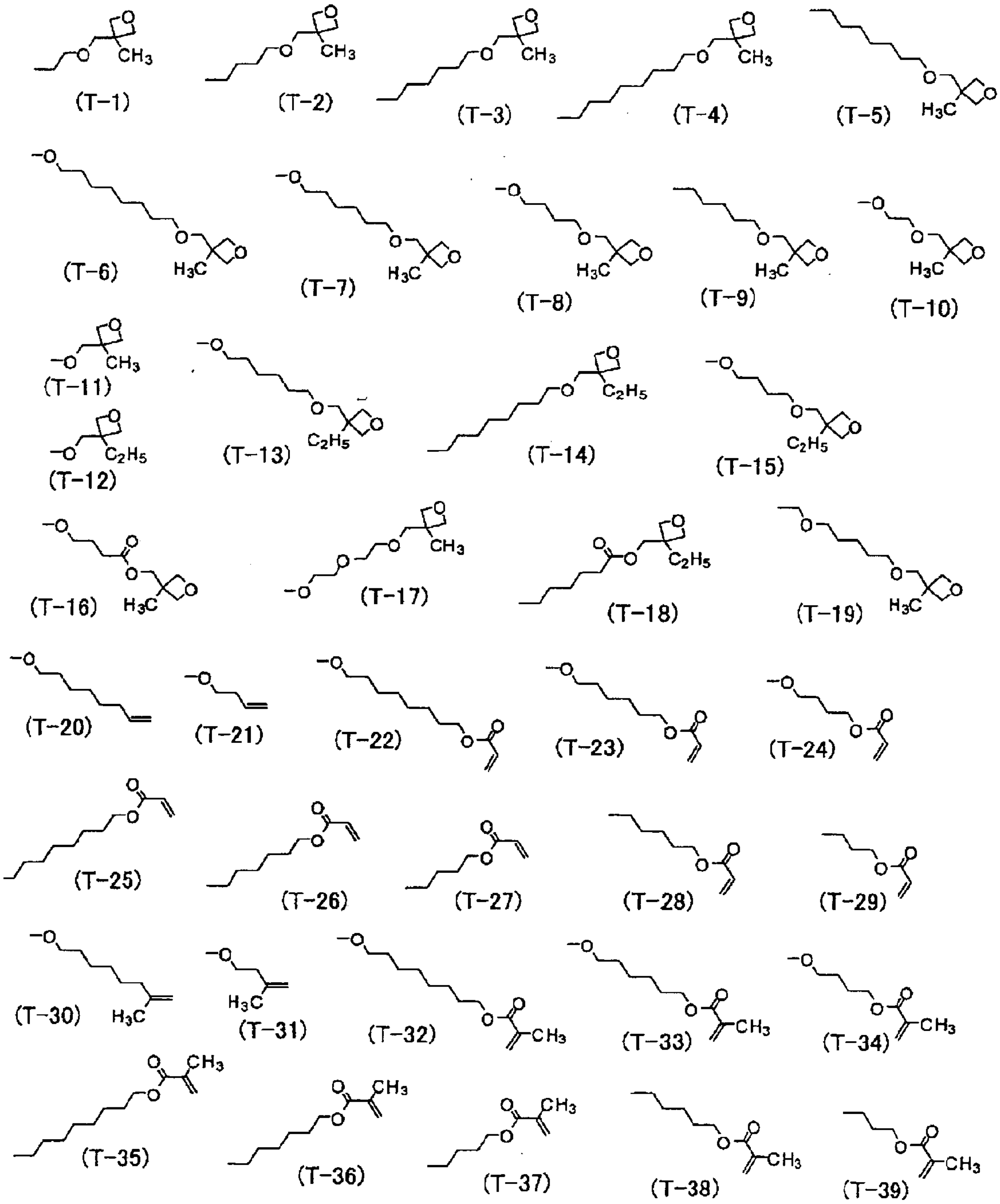

(T-1) (T-2) (T-3) (T-4) (T-5)

(T-6) (T-7) (T-8) (T-9) (T-10)

(T-11) (T-12) (T-13) (T-14) (T-15)

(T-16) (T-17) (T-18) (T-19)

(T-20) (T-21) (T-22) (T-23) (T-24)

(T-25) (T-26) (T-27) (T-28) (T-29)

(T-30) (T-31) (T-32) (T-33) (T-34)

(T-35) (T-36) (T-37) (T-38) (T-39)

[Formula 8]

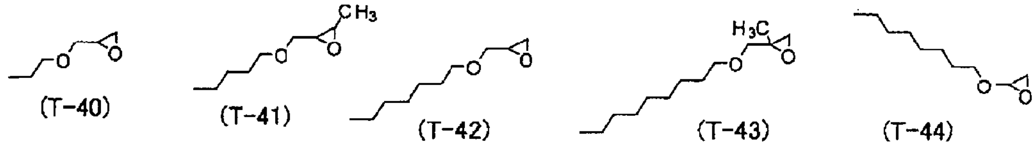

(T-40) (T-41) (T-42) (T-43) (T-44)

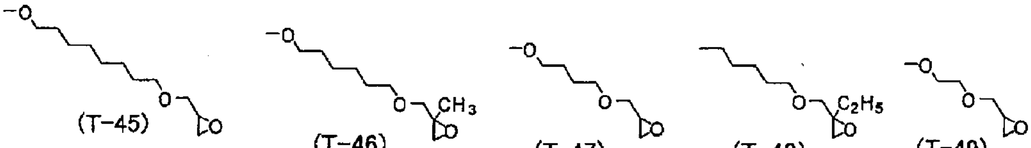

(T-45) (T-46) (T-47) (T-48) (T-49)

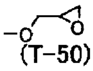

(T-50)

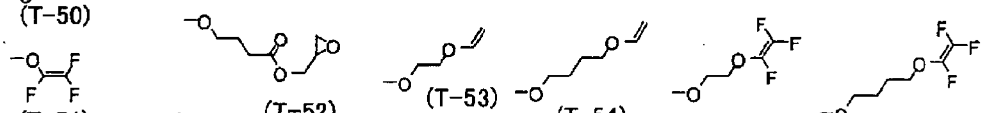

(T-51) (T-52) (T-53) (T-54) (T-55) (T-56)

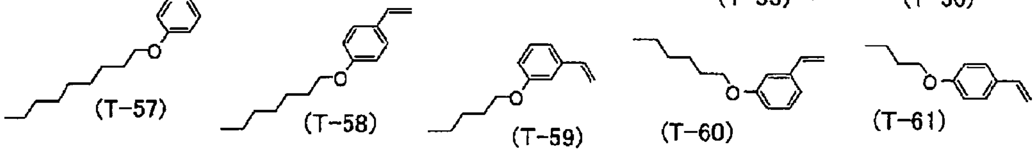

(T-57) (T-58) (T-59) (T-60) (T-61)

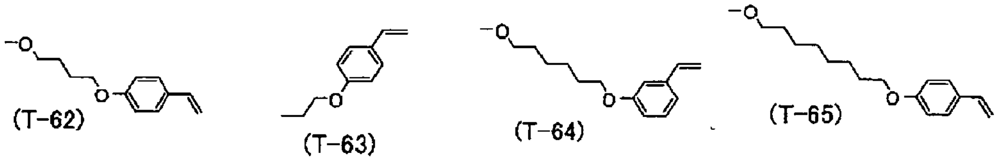

(T-62) (T-63) (T-64) (T-65)

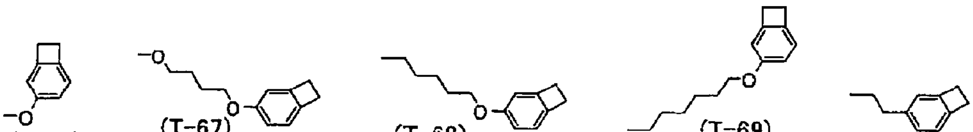

(T-66) (T-67) (T-68) (T-69) (T-70)

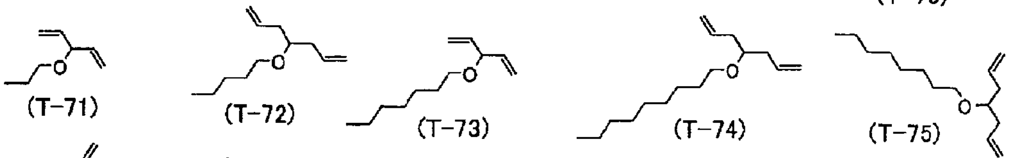

(T-71) (T-72) (T-73) (T-74) (T-75)

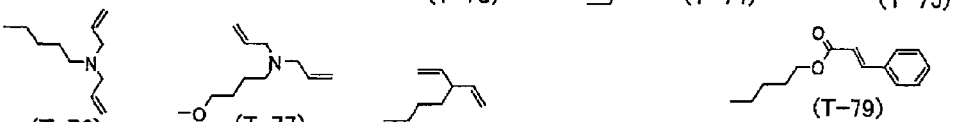

(T-76) (T-77) (T-78) (T-79)

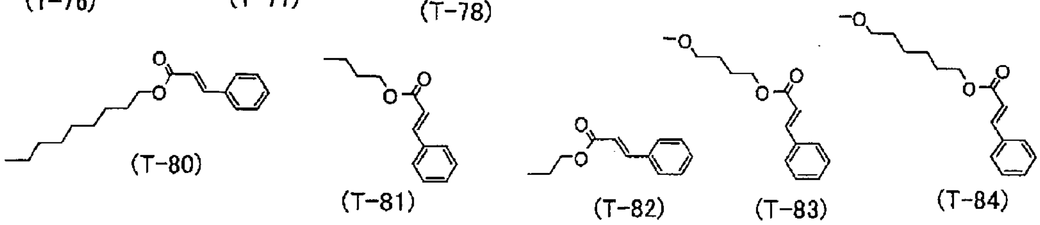

(T-80) (T-81) (T-82) (T-83) (T-84)

{Examples of Cross-Linking Compound}

Specific examples of the cross-linking compound include triarylamine derivatives, carbazole derivatives, fluorene derivatives, 2,4,6-triphenylpyridine derivatives, C60 derivative, oligothiophene derivatives, phthalocyanine derivatives, polycyclic aromatic derivatives, and metal complex derivatives. Preferably, the cross-linking compound is a triarylamine derivative.

Preferably, the cross-linking compound intramolecularly has a charge-transporting site, a luminous site, or a hole-transporting site. When a hole-transporting layer is to be formed, the cross-linking compound intramolecularly preferably has a hole-transporting site.

Specific examples of the cross-linking compound include, but not limited to, the following compounds. In the following compounds, T denotes a cross-linking group. When a plurality of Ts are present in a molecule, the plurality of Ts may be the same or different.

[Formula 10]

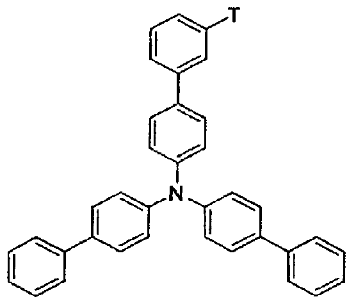
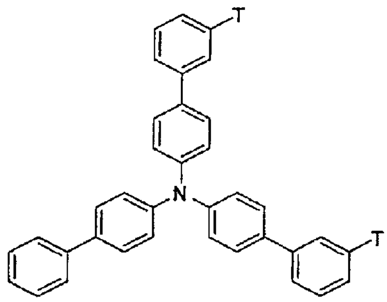
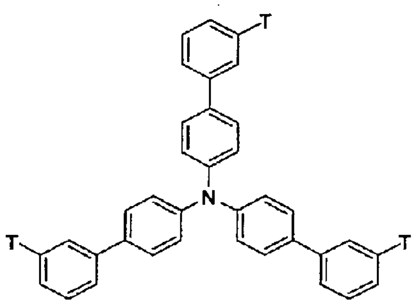
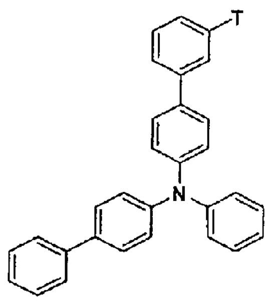
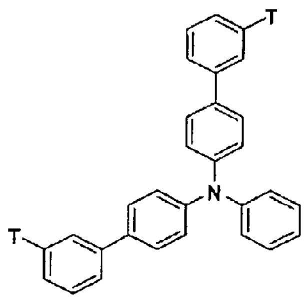
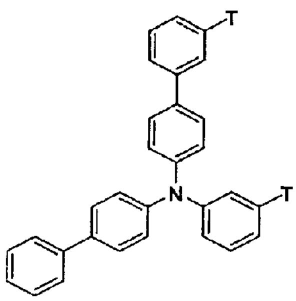
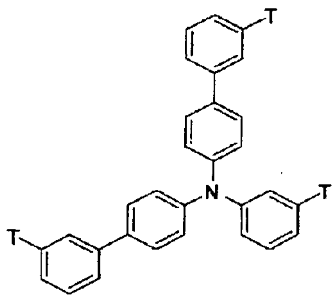
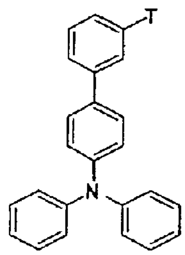
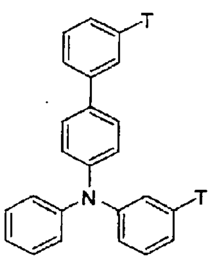
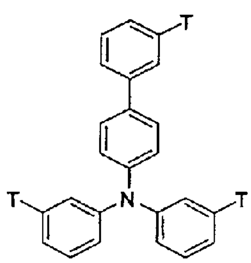

[Formula 11]

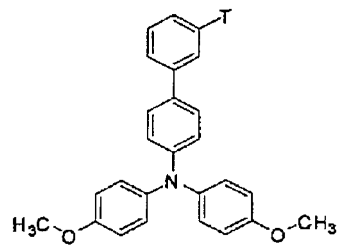

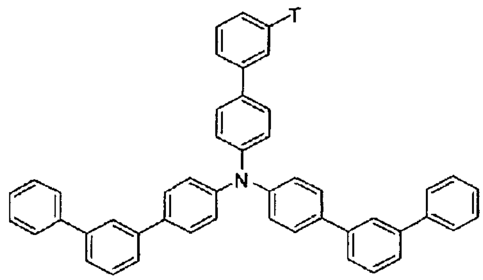

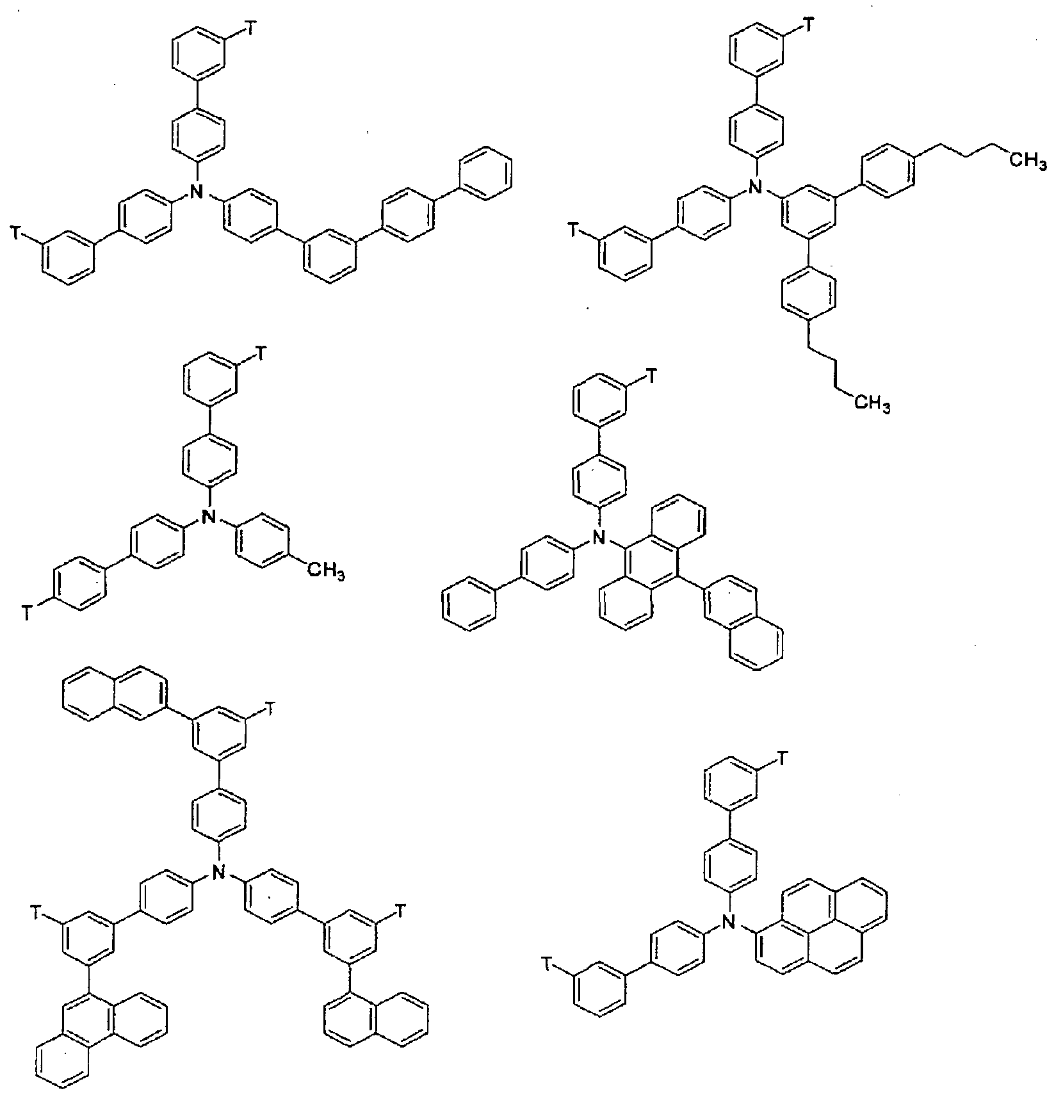

[Formula 12]

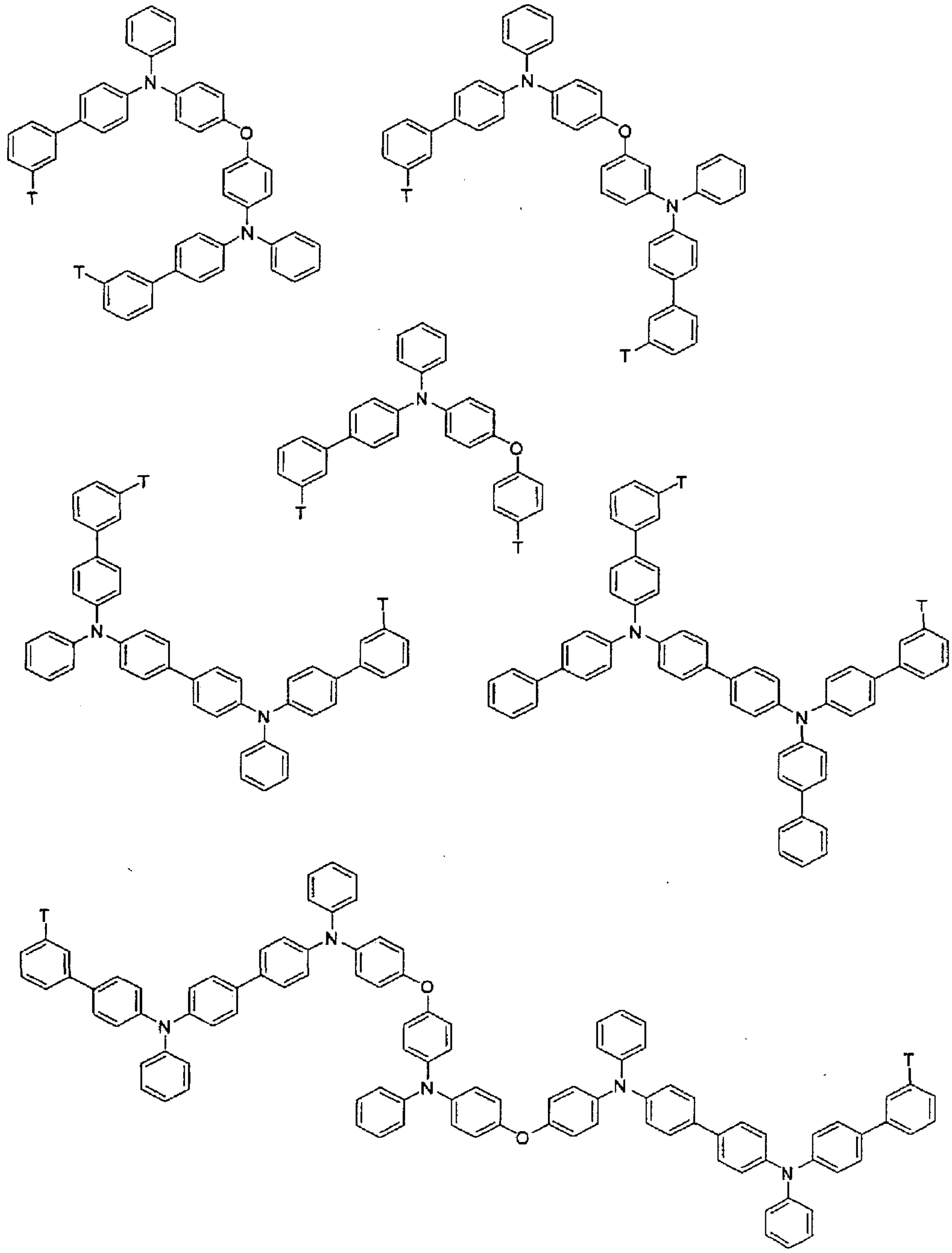

[Formula 13]

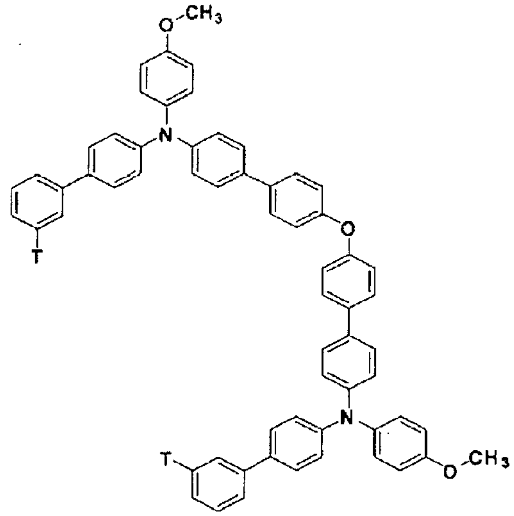

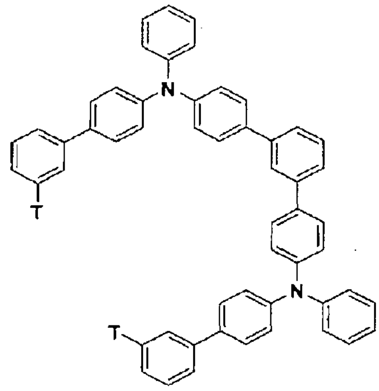

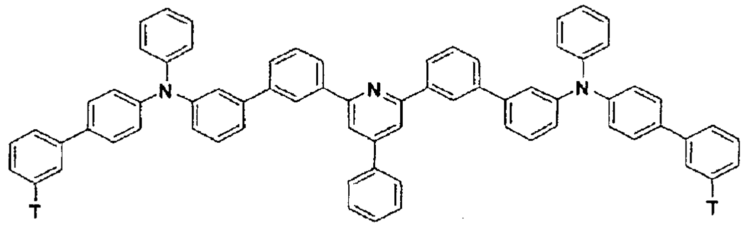

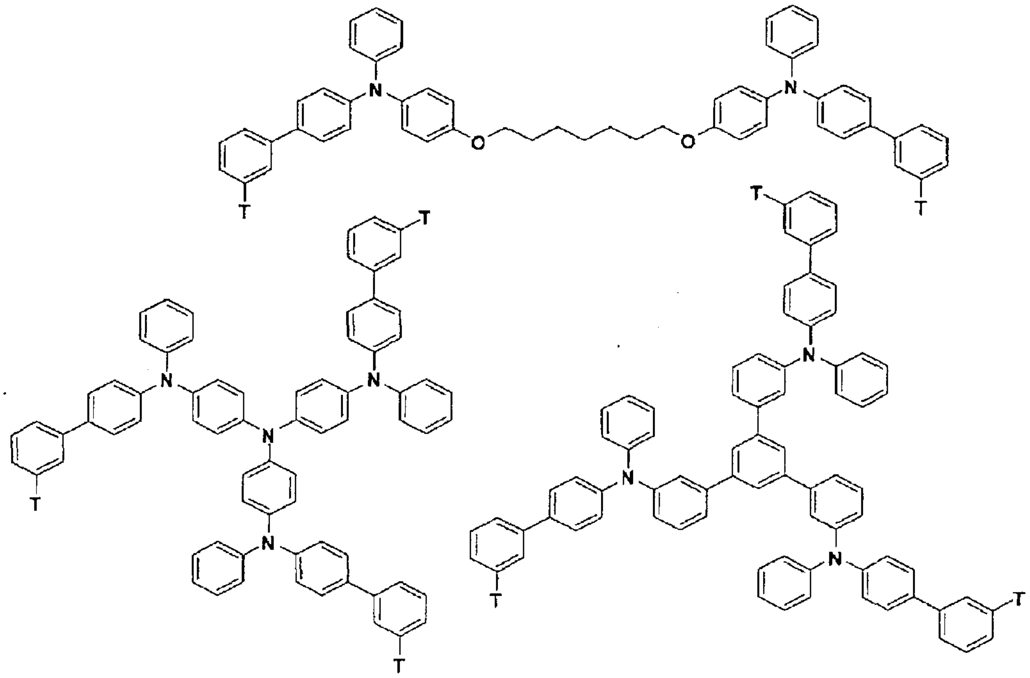

[Formula 14]

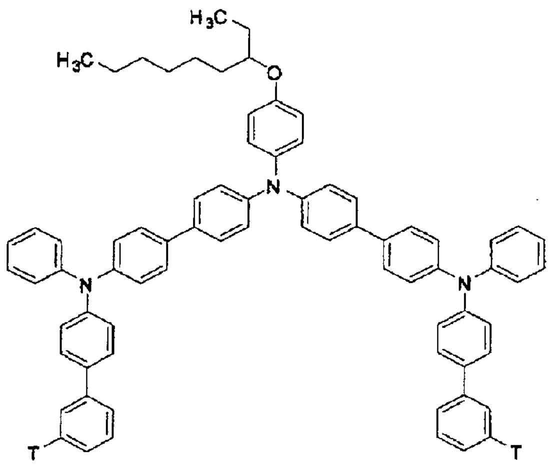

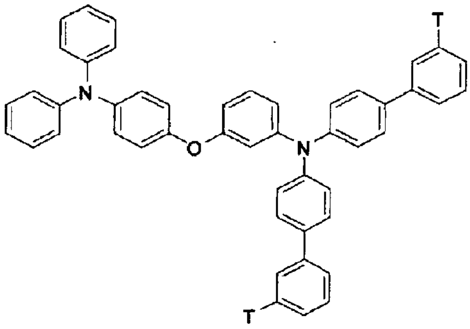

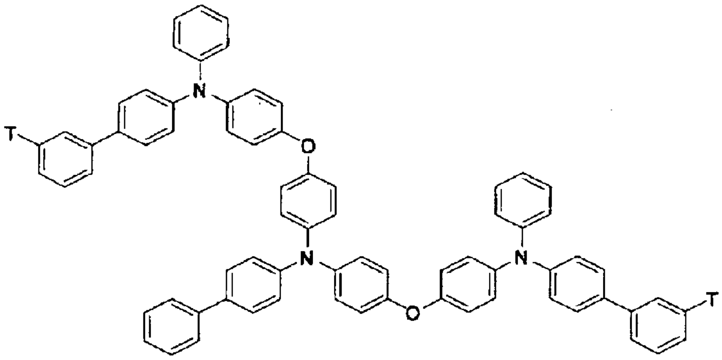

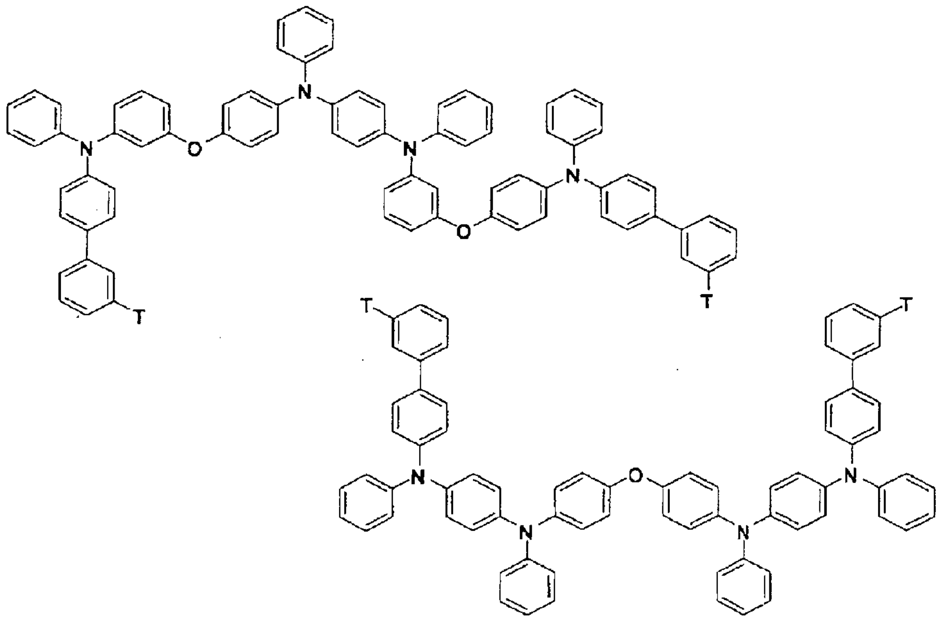

[Formula 15]

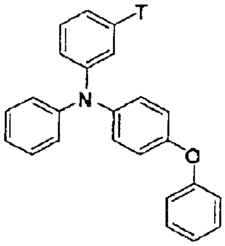
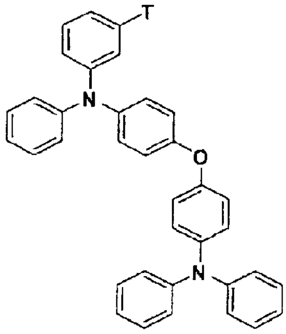
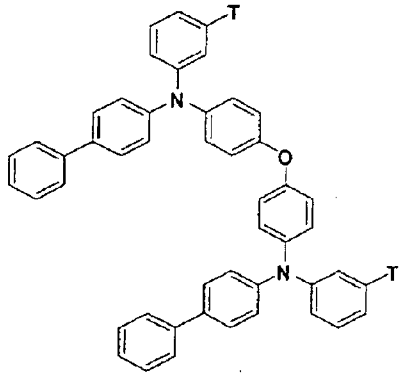
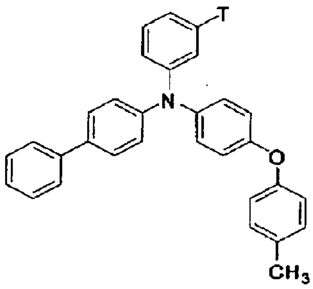
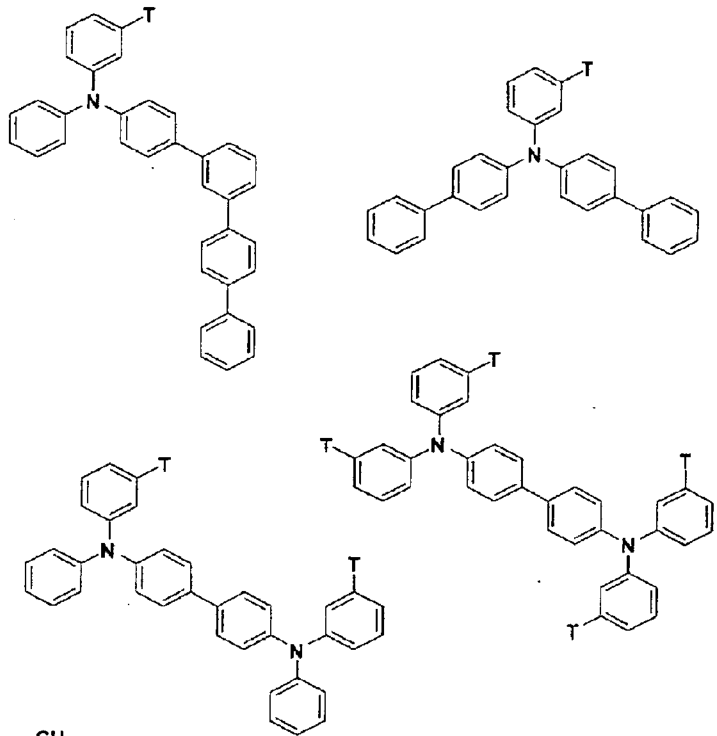
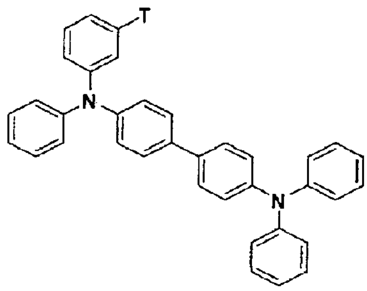
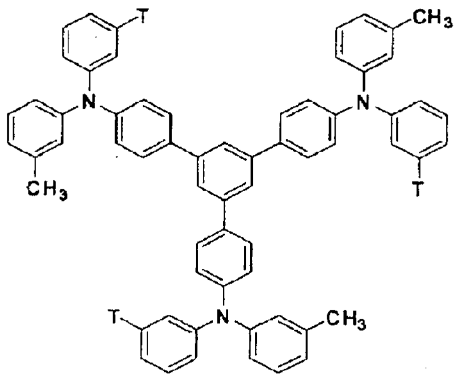
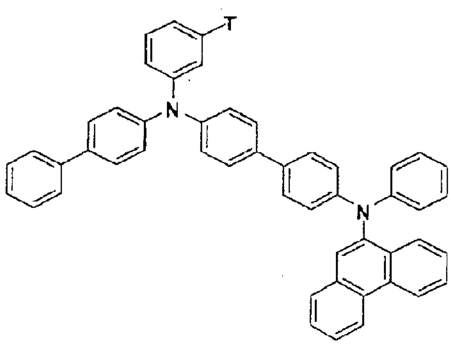

[Formula 16]

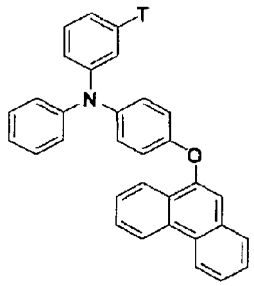

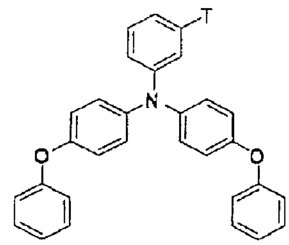

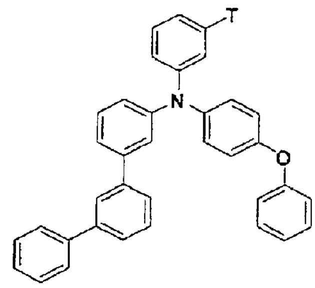

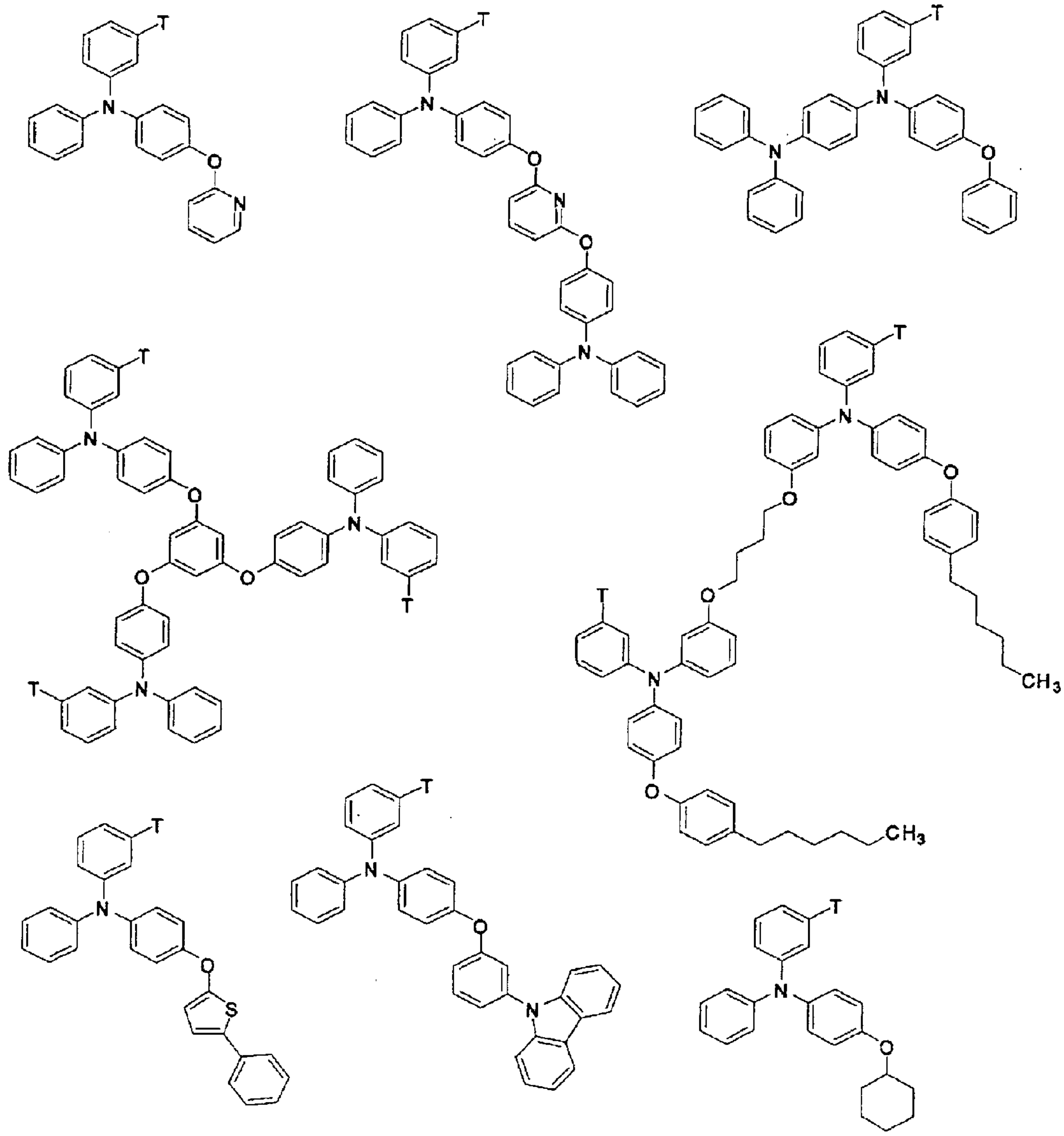

[Formula 17]

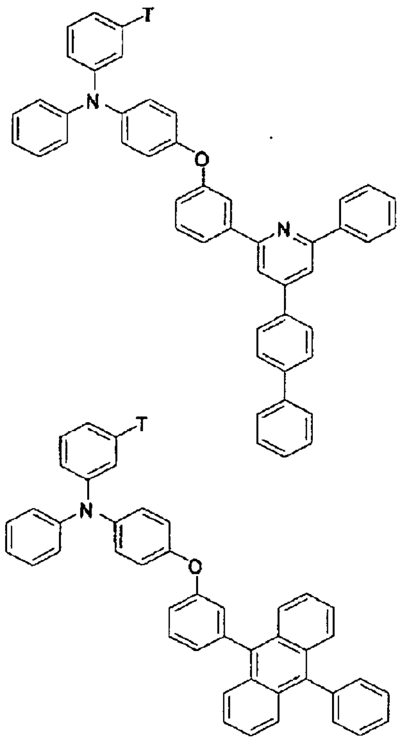

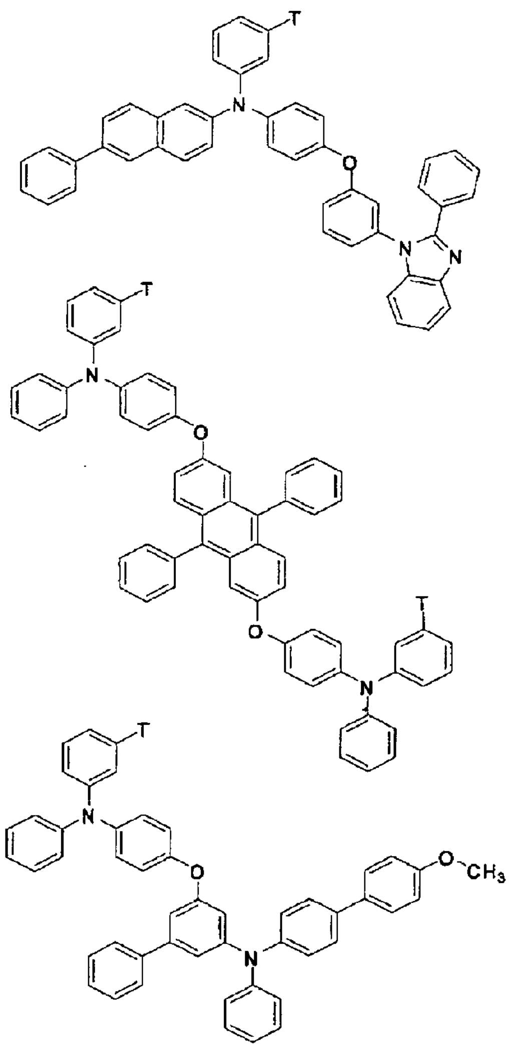

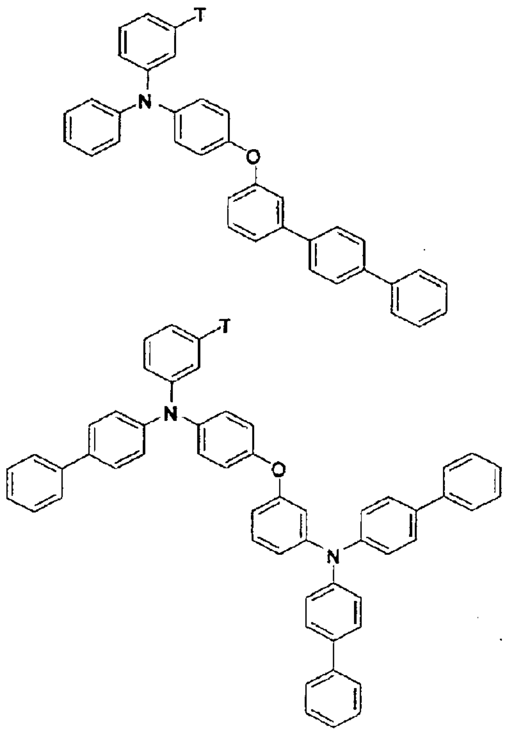

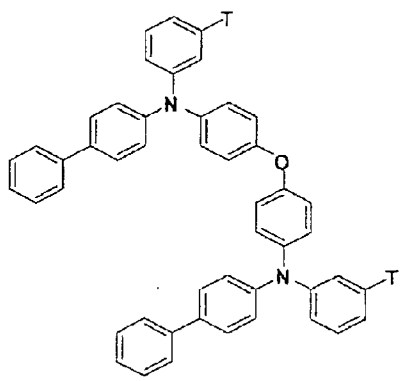

[Formula 18]

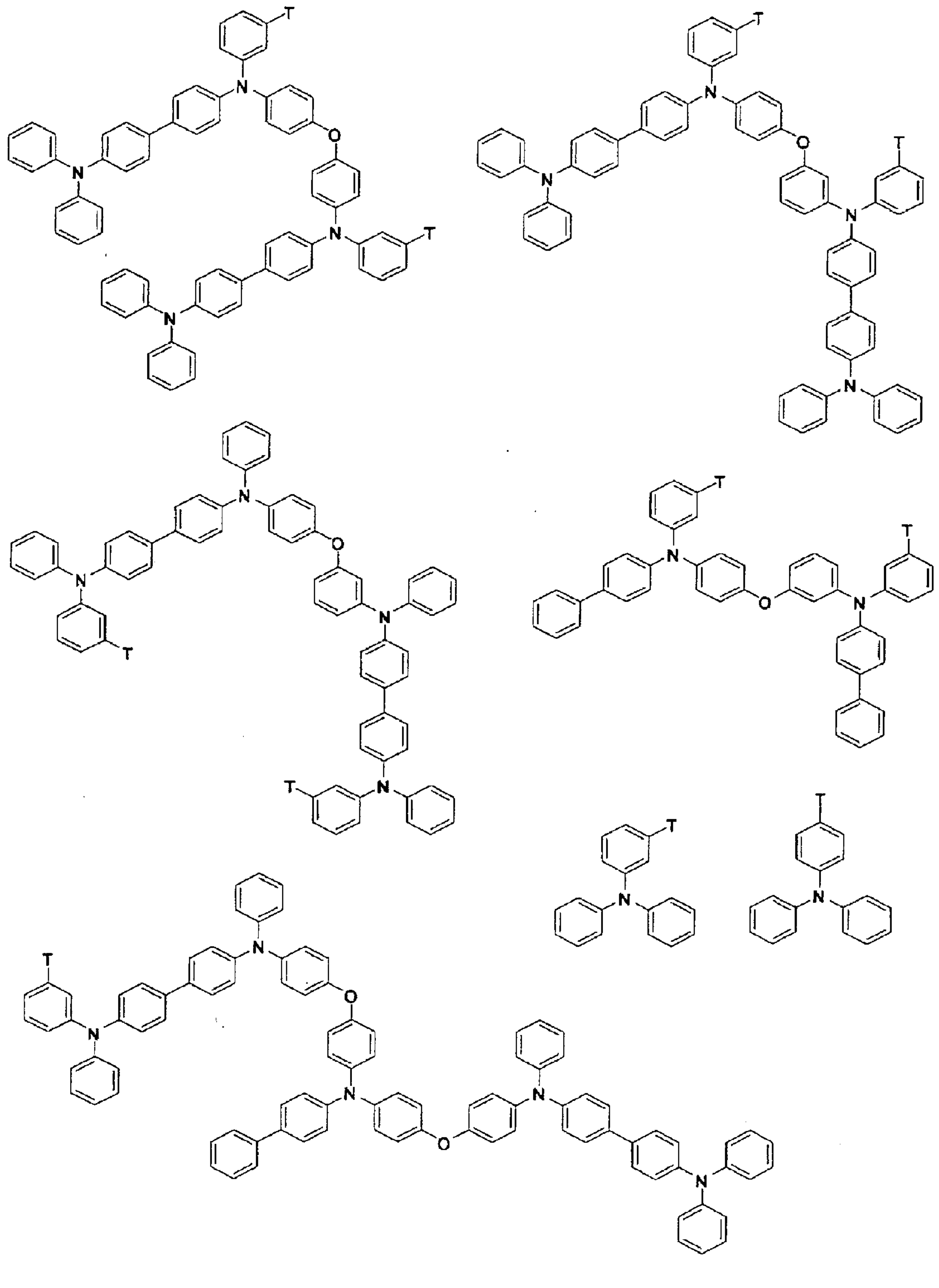

[Formula 19]

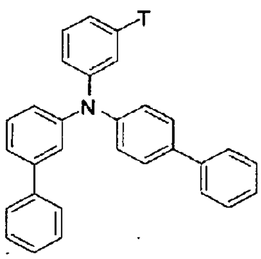

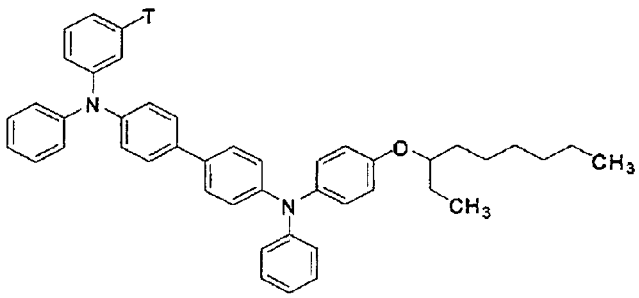

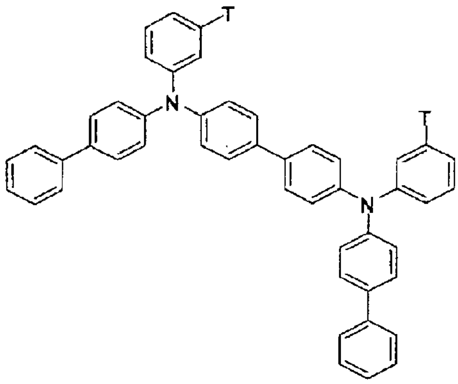

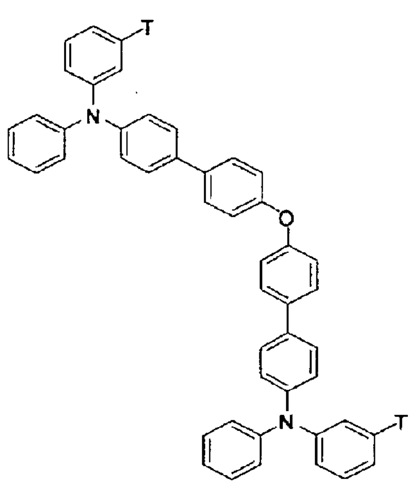

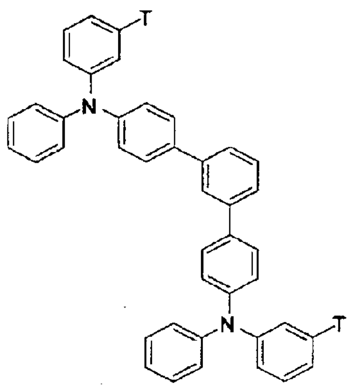

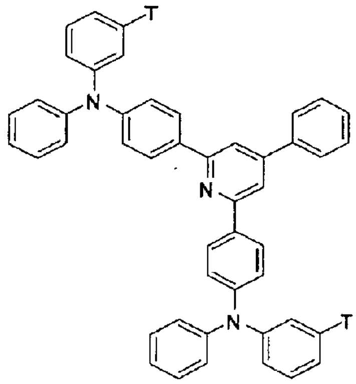

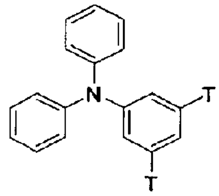

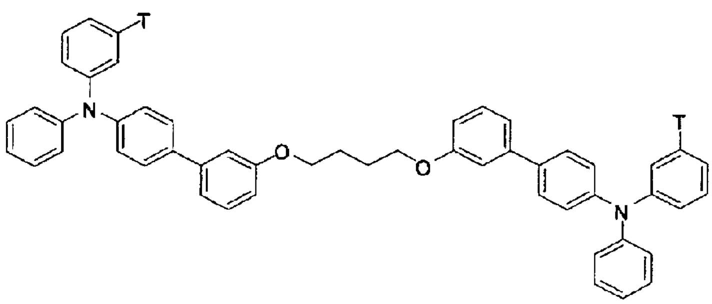

[Formula 20]

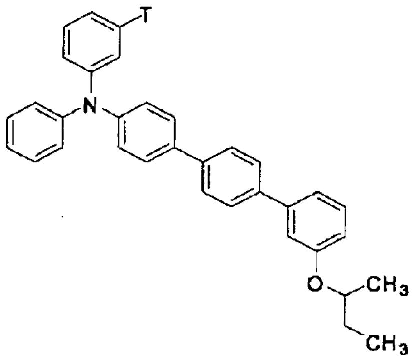

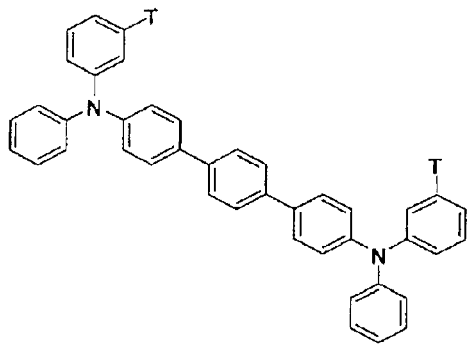

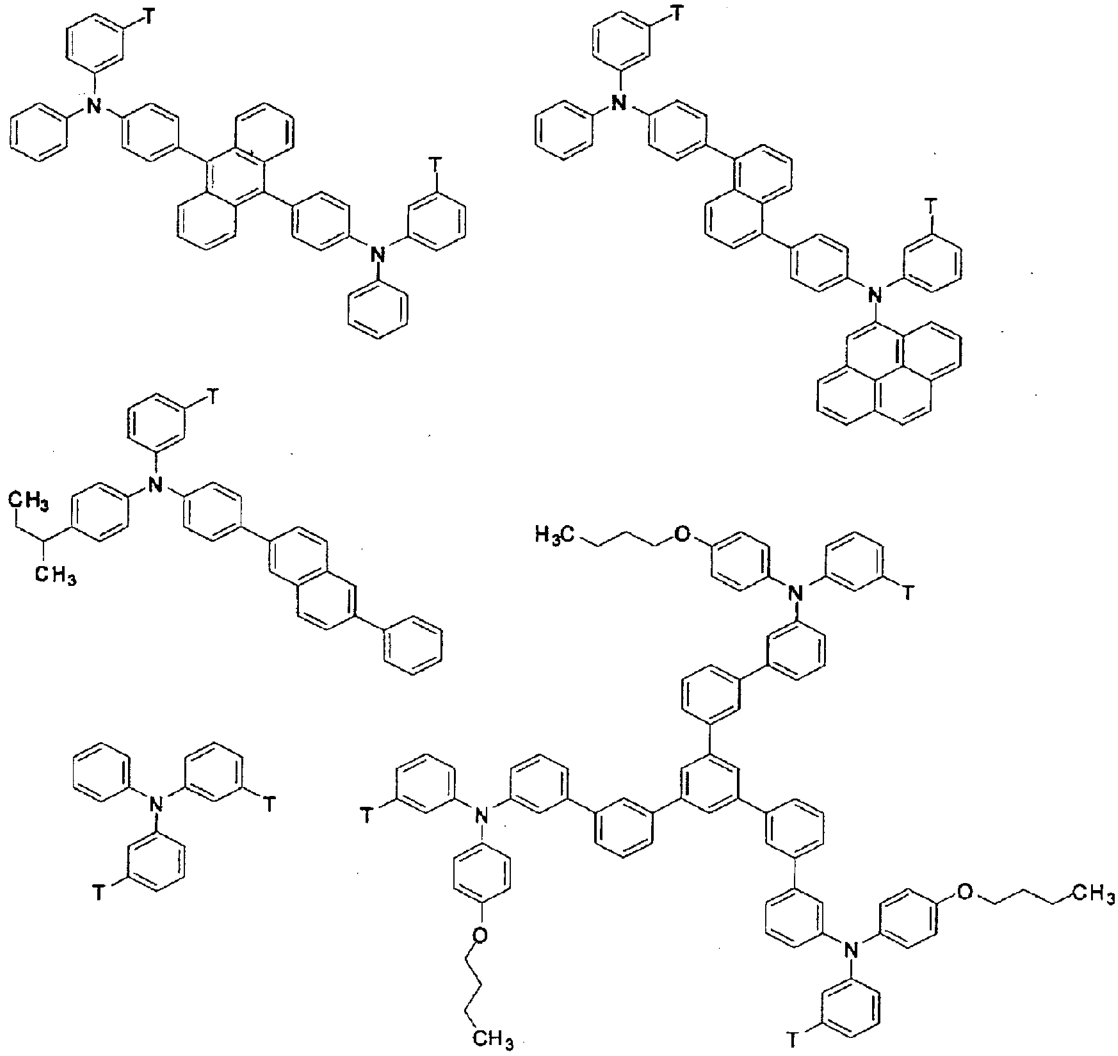

[Formula 21]

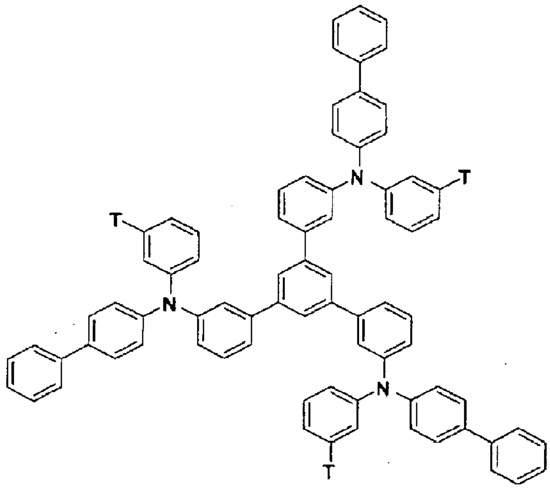

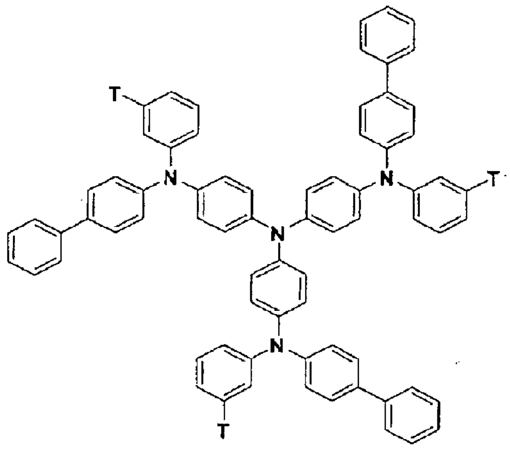

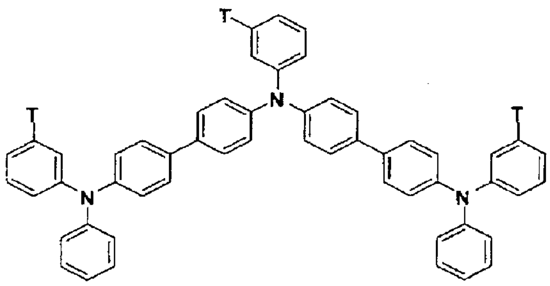

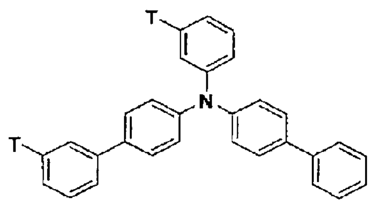

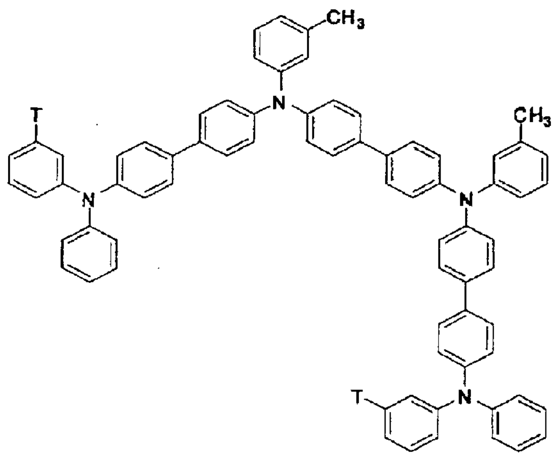

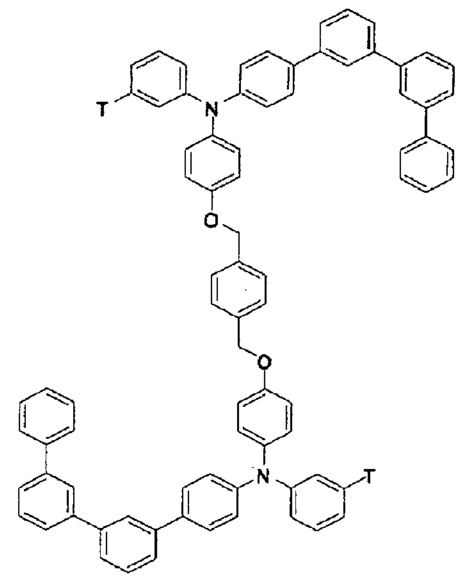

[Formula 22]

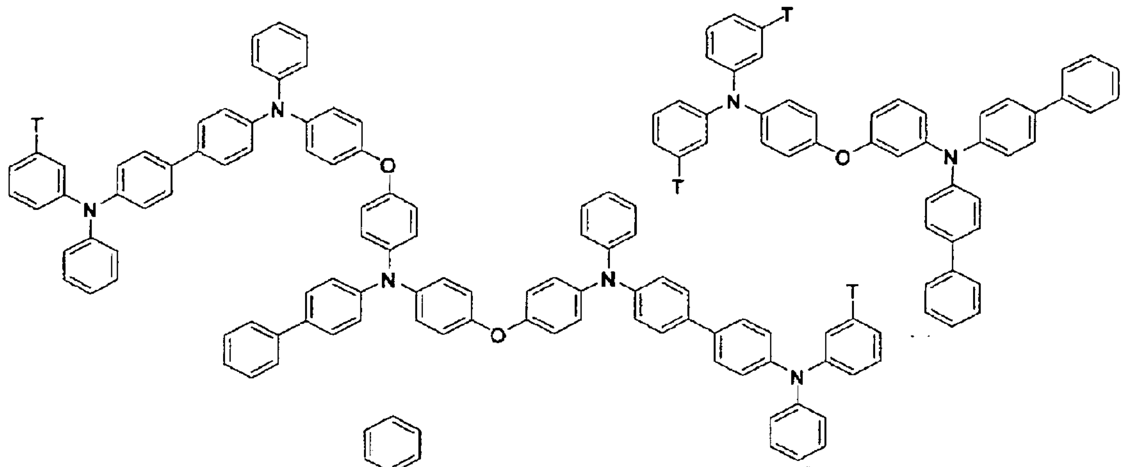

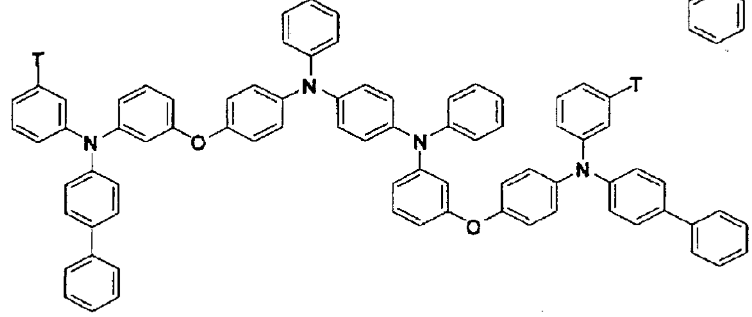

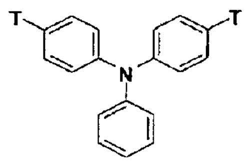

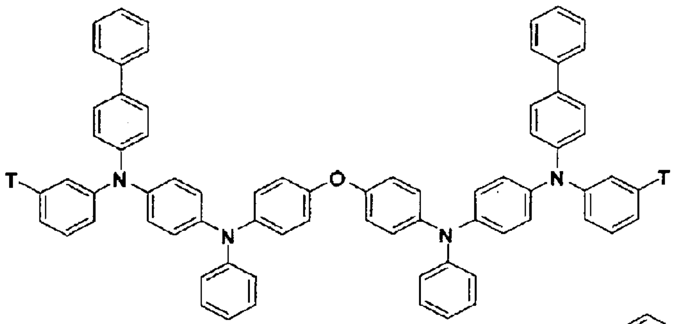

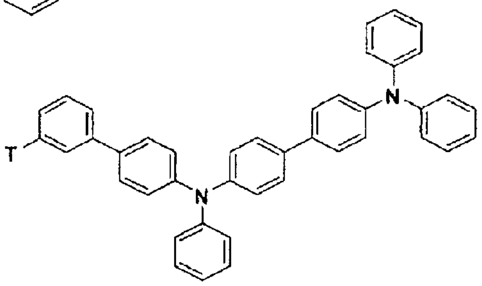

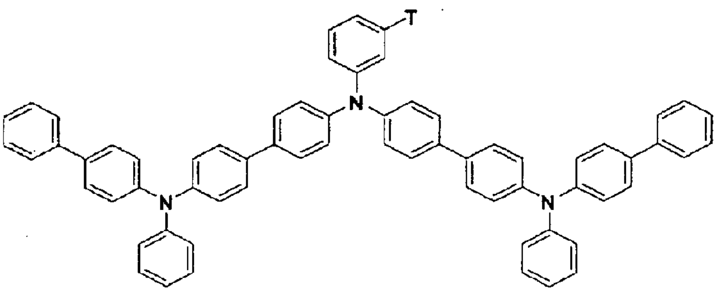

[Formula 23]

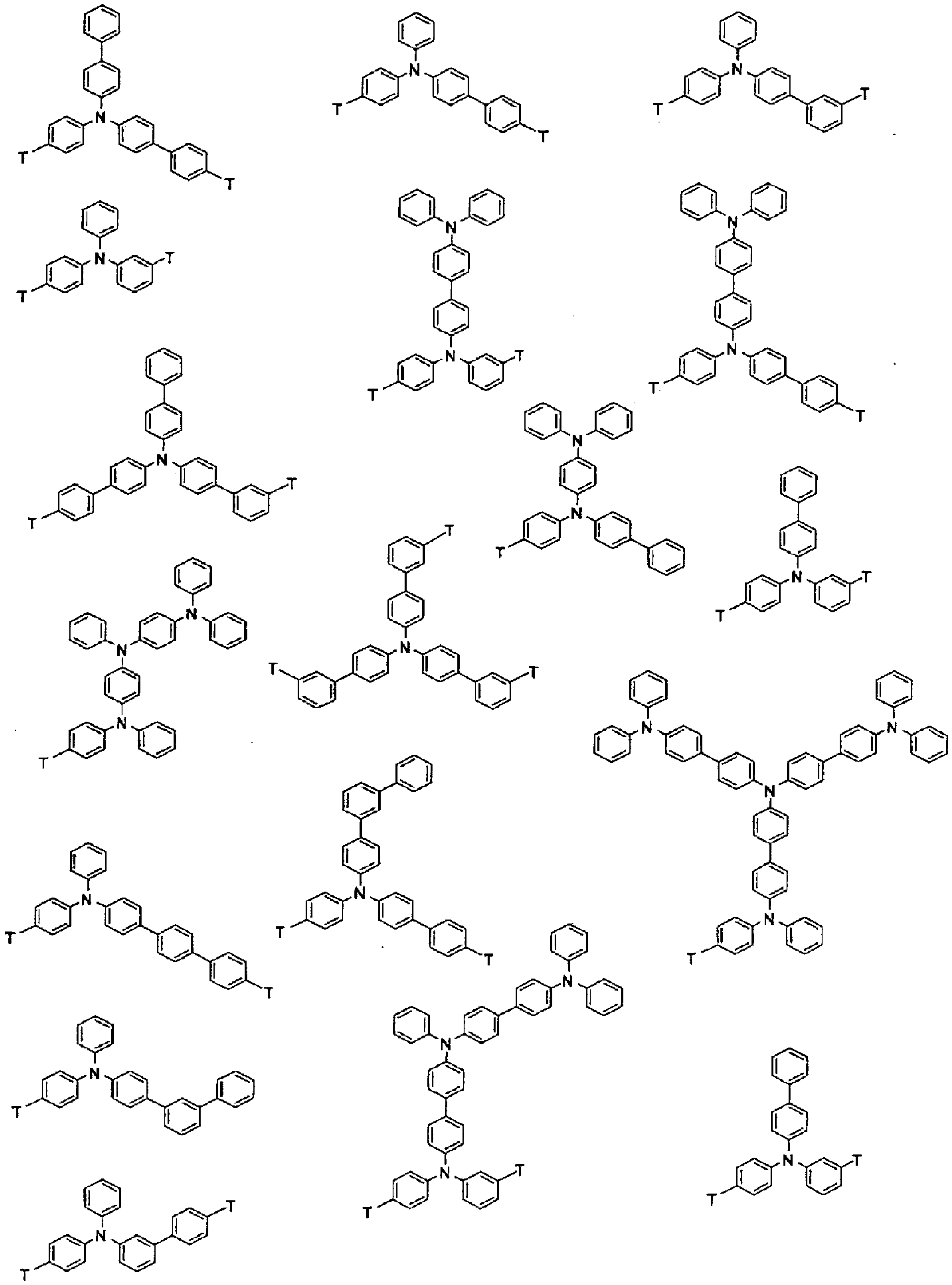

[Formula 24]

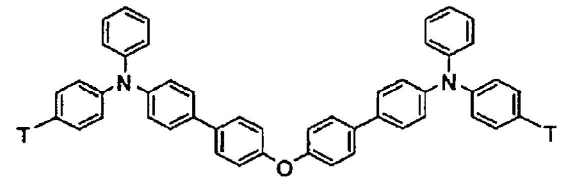

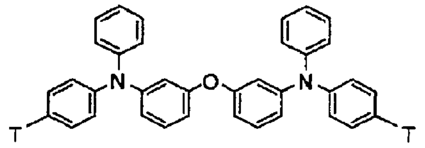

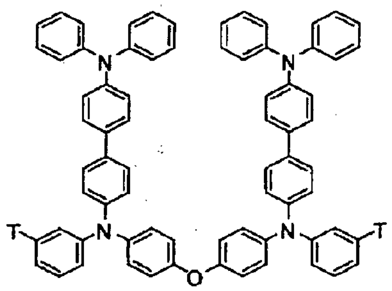

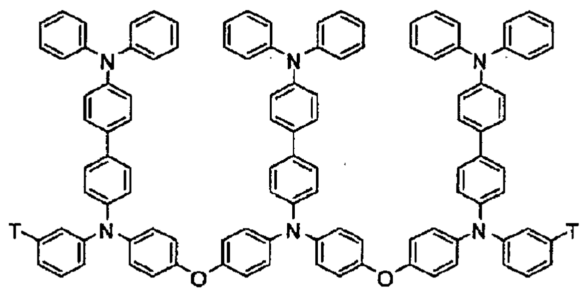

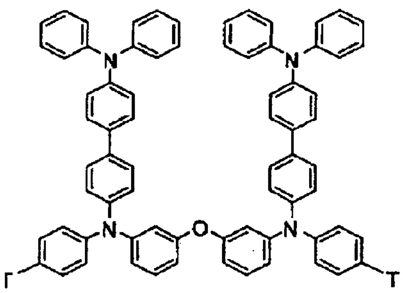

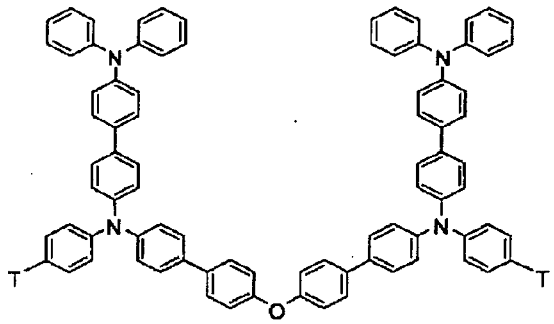

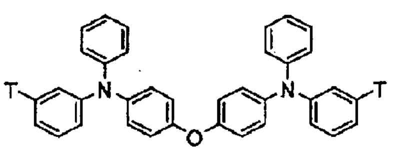

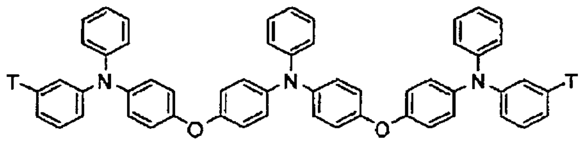

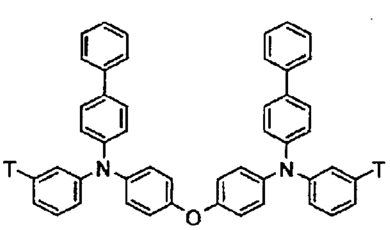

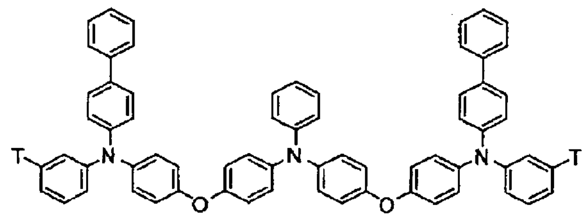

[Formula 25]

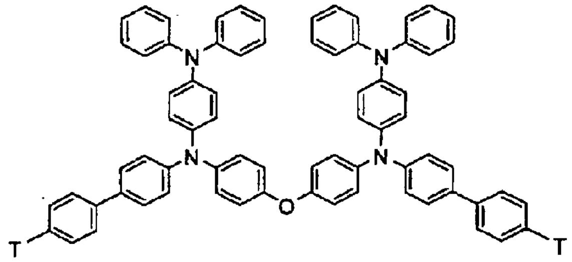

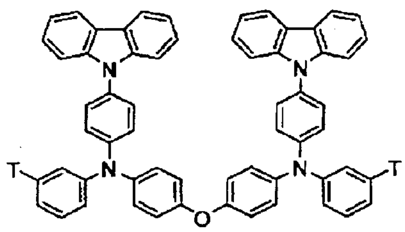

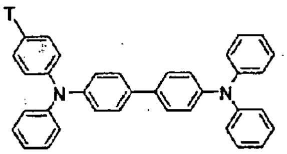

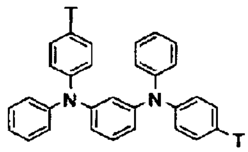

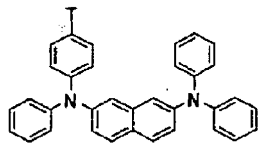

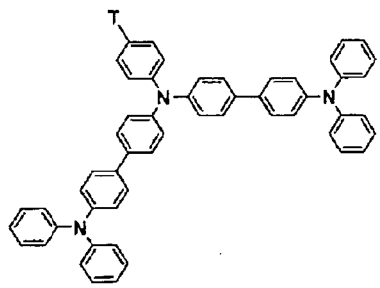

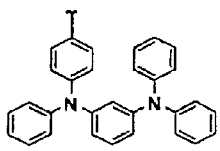

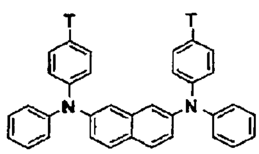

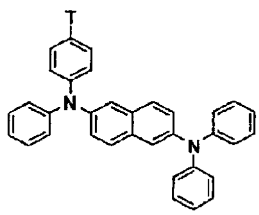

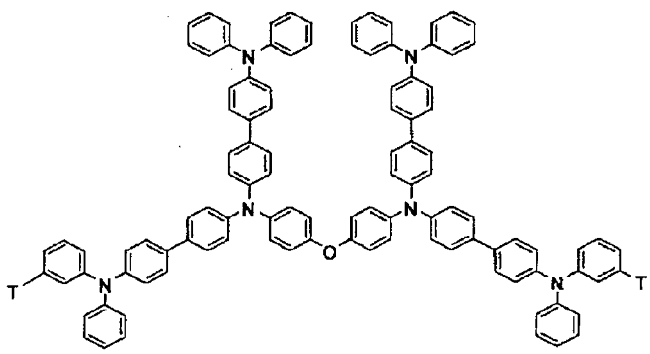

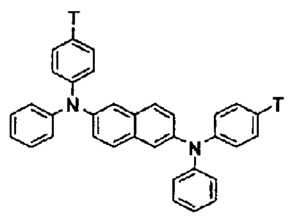

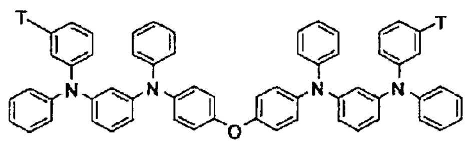

[Formula 26]

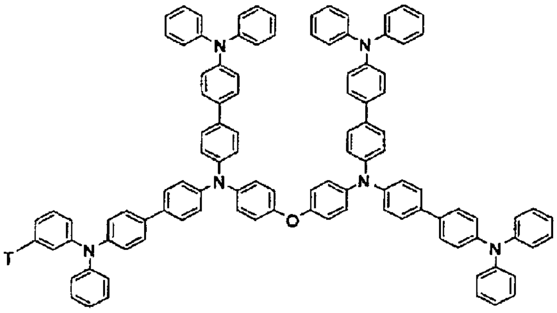

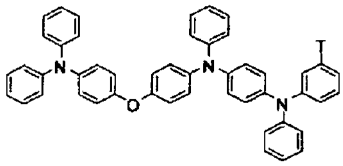

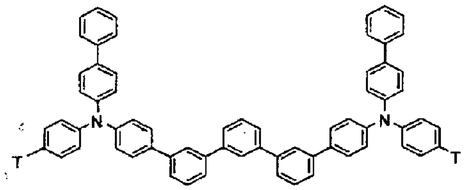

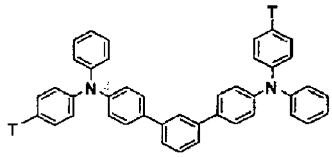

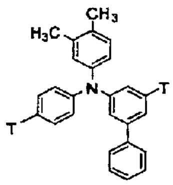

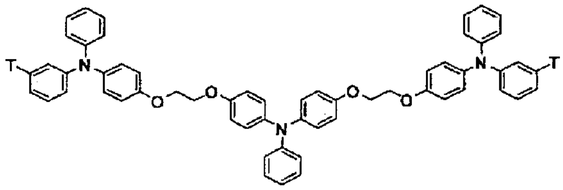

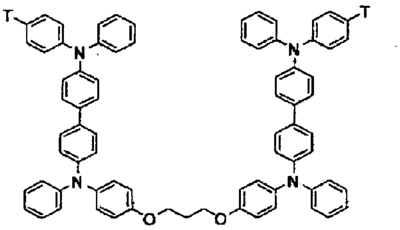

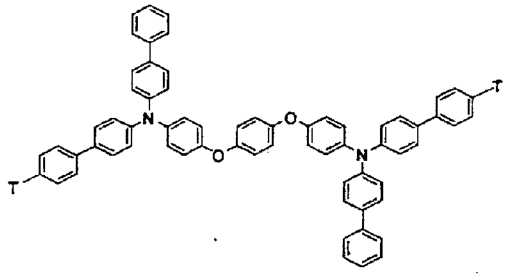

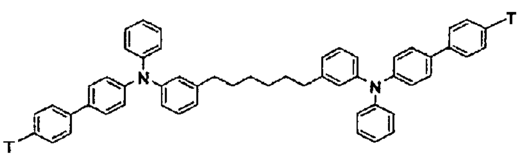

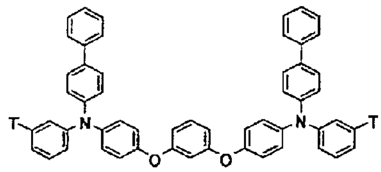

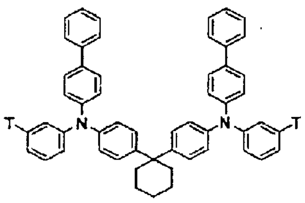

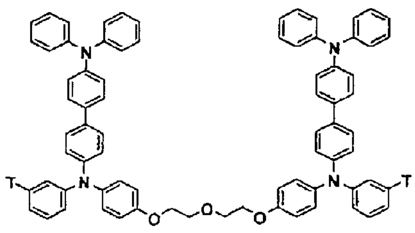

[Formula 27]

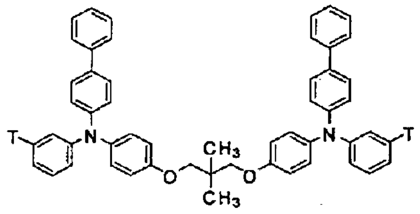

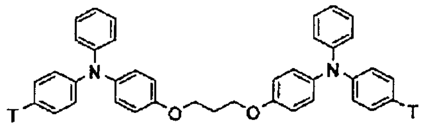

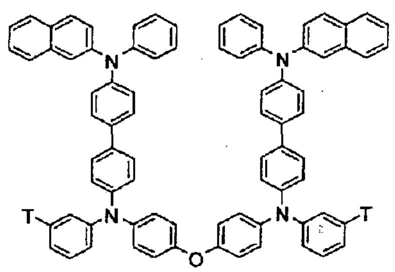

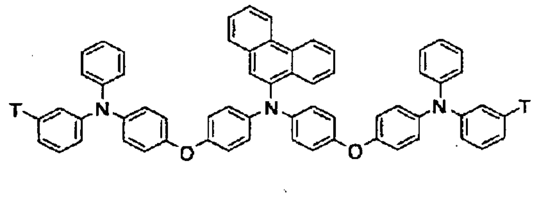

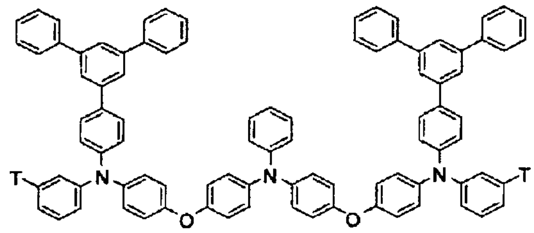

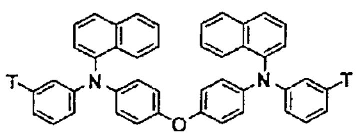

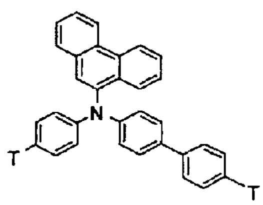

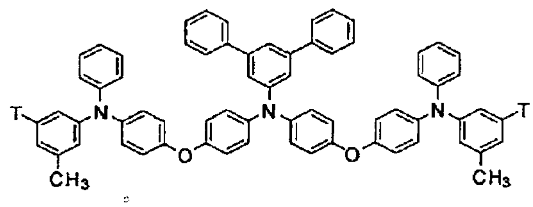

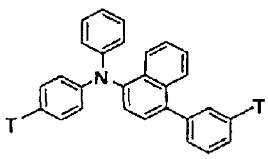

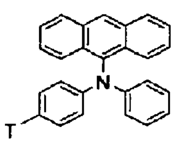

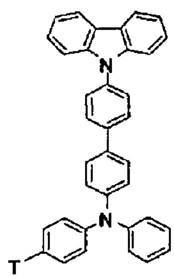

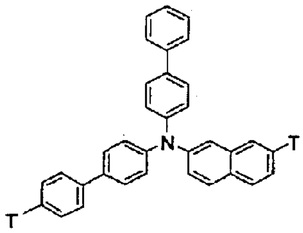

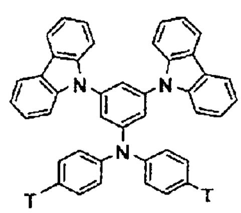

[Formula 28]

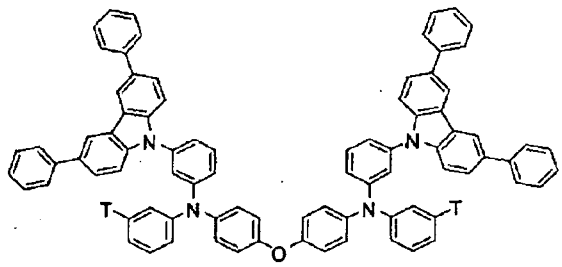

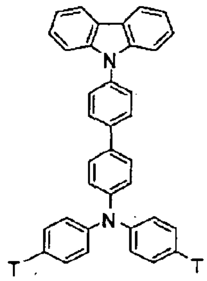

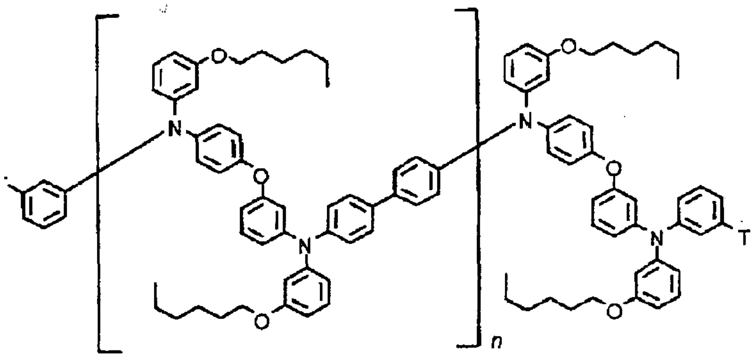

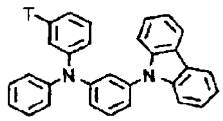

[Formula 29]

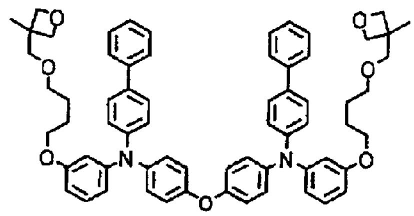

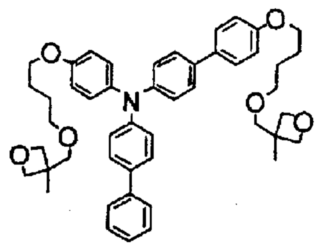

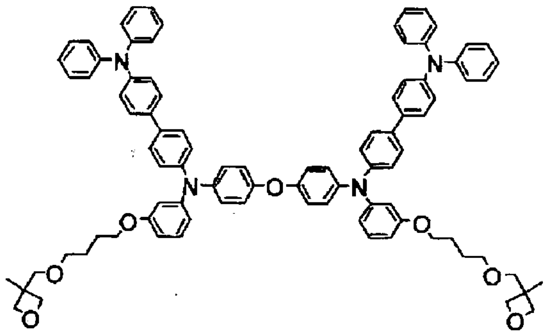

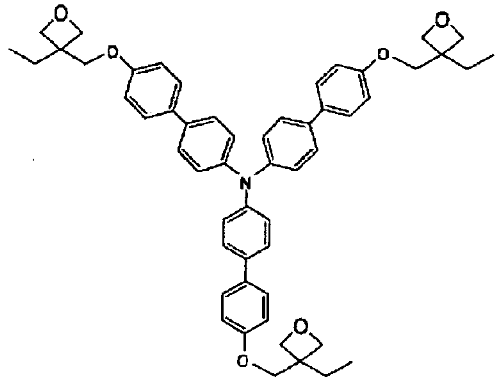

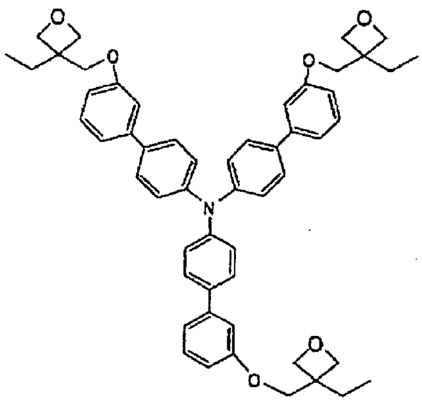

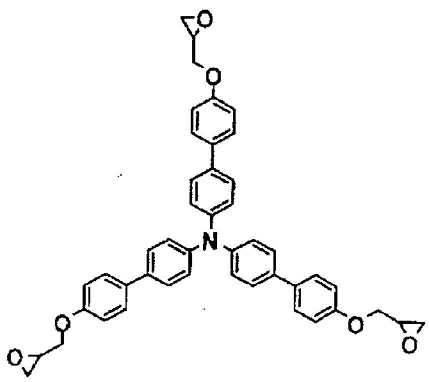

[Formula 30]

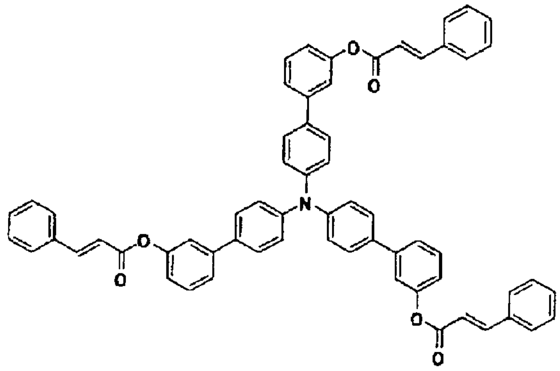

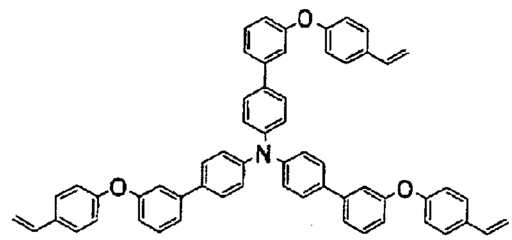

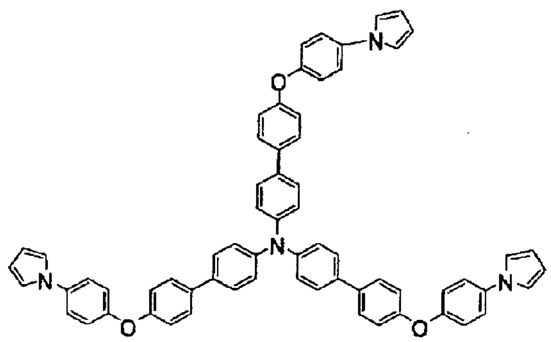

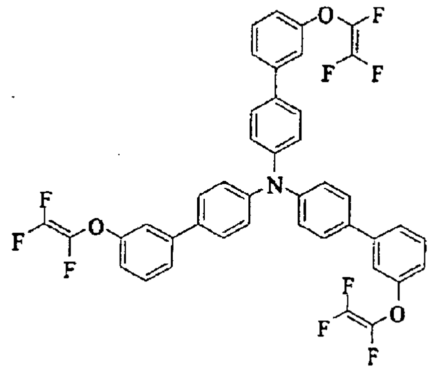

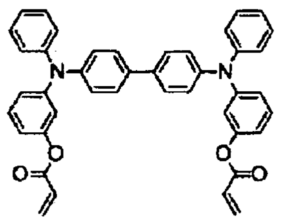

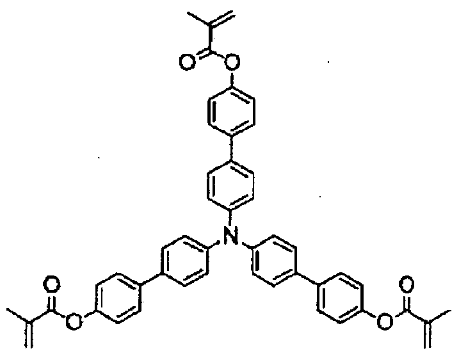

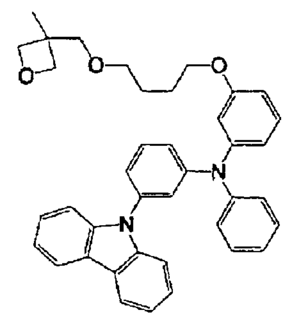

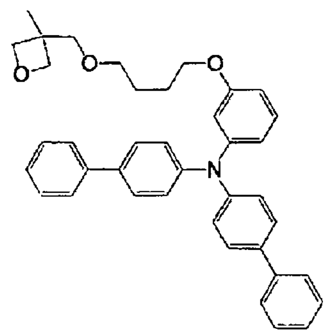

[Formula 31]

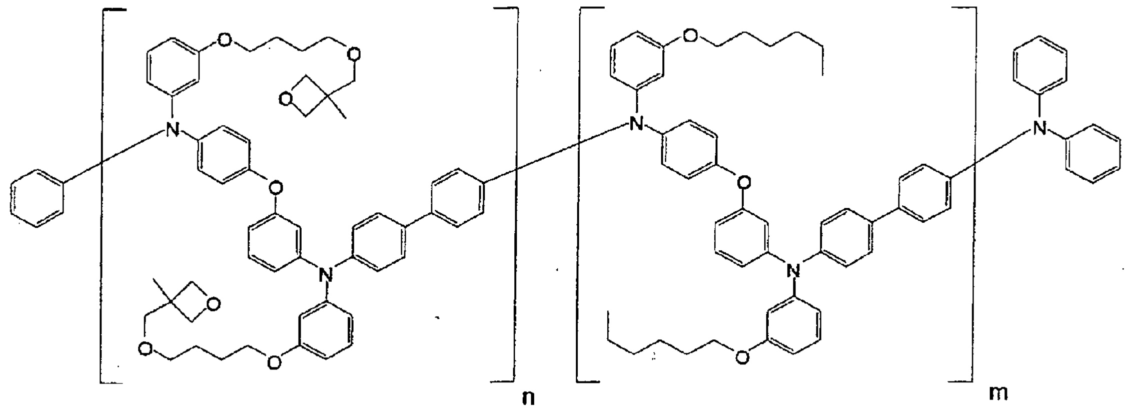

(wherein, for example, n = 0.9 and m = 0.1)

[Formula 32]

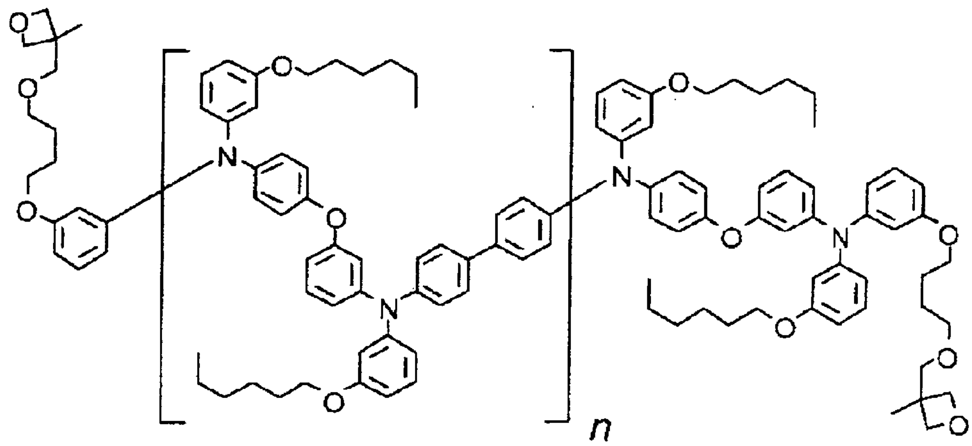

(wherein, for example, n is about 3.)

[Formula 33]

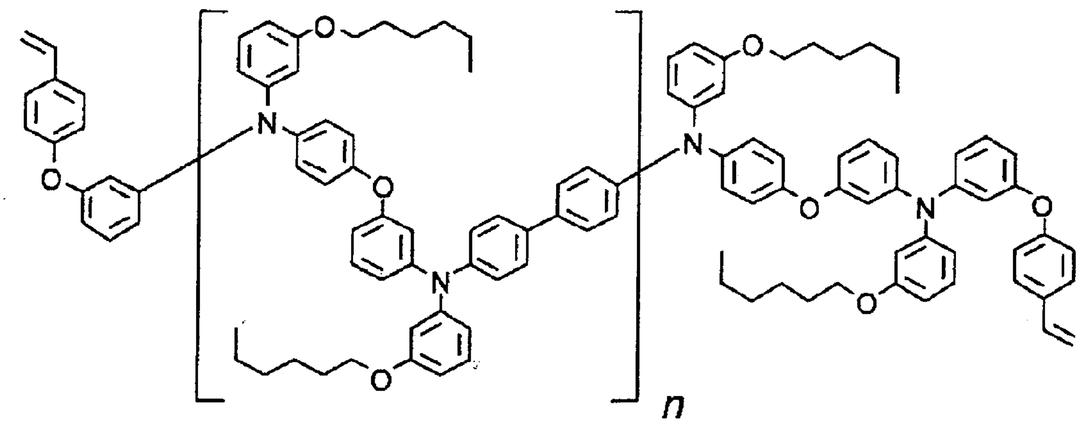

(wherein, for example, n = 4.)

[Formula 34]

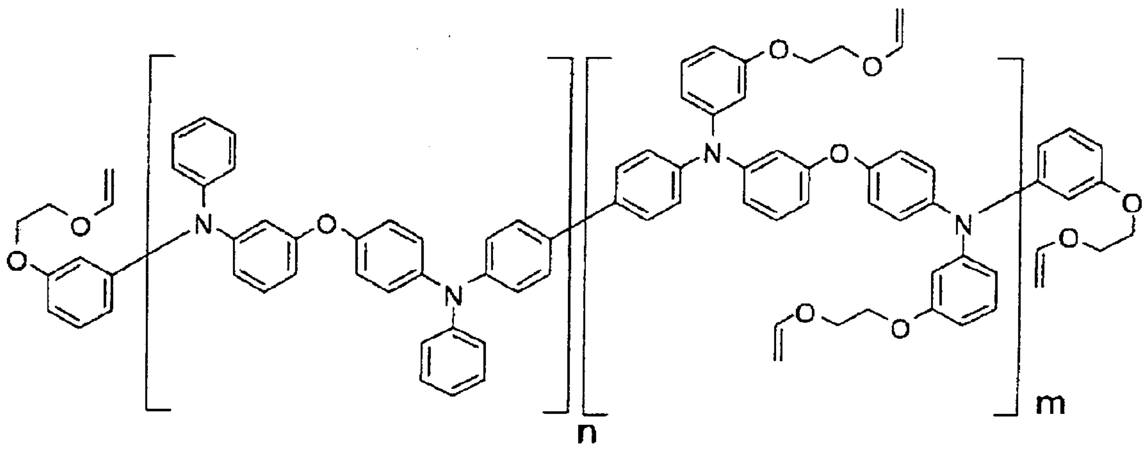

(wherein, for example, n = 0.94 and m = 0.06.)

[Formula 35]

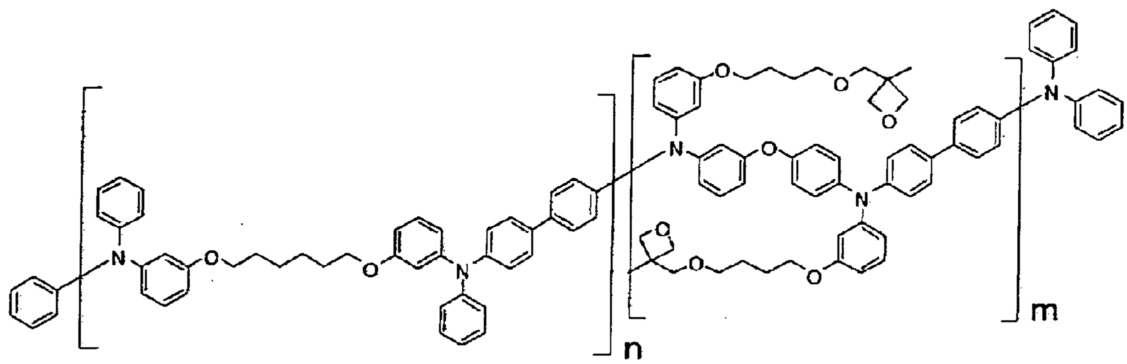

(wherein, for example, n = 0.9 and m = 0.1.)

[Formula 36]

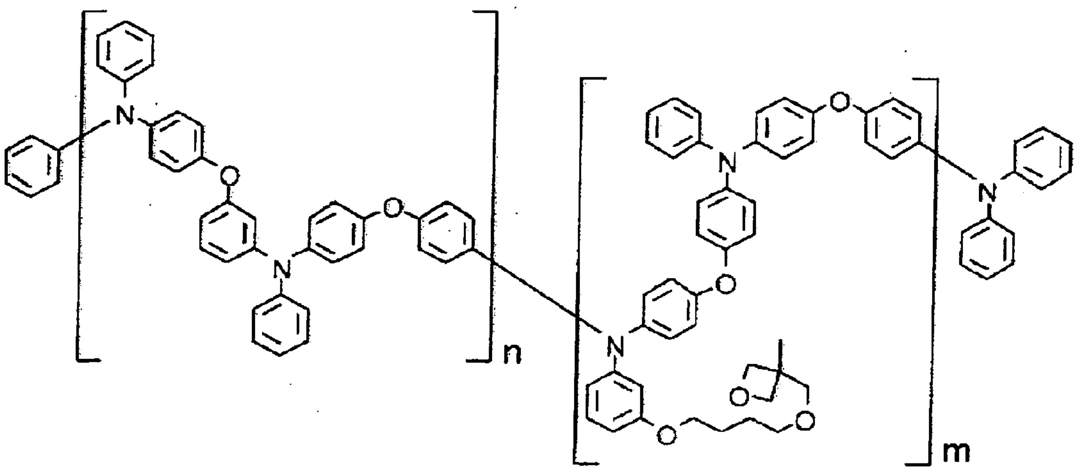

(wherein, for example, n = 0.9 and m = 0.1.)

[Formula 37]

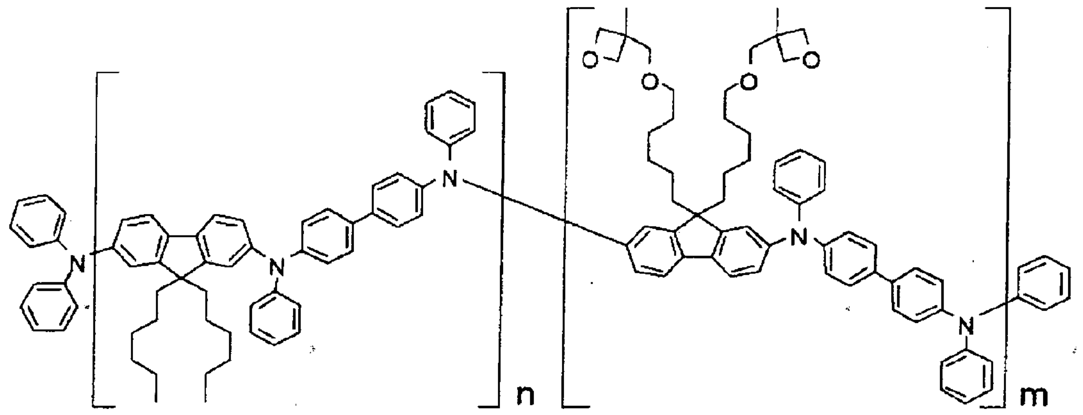

(wherein, for example, n = 0.9 and n = 0.1)

[Formula 38]

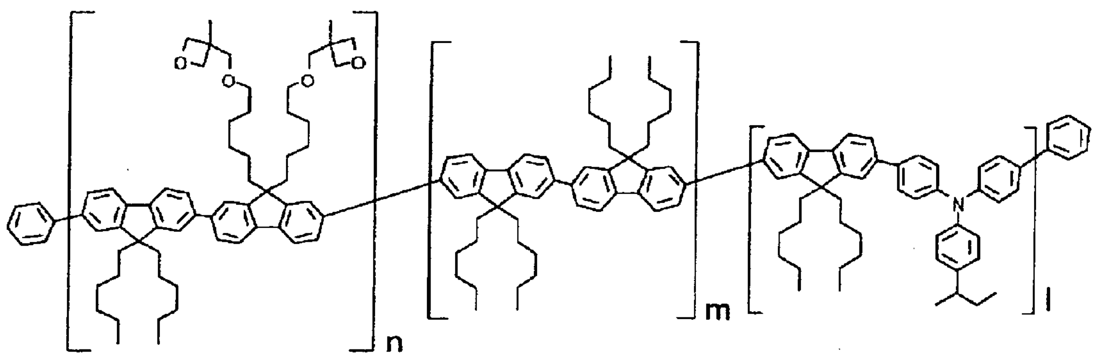

(wherein, for example, n = 0.1, m = 0.6, and 1 = 0.3.)

[Formula 39]

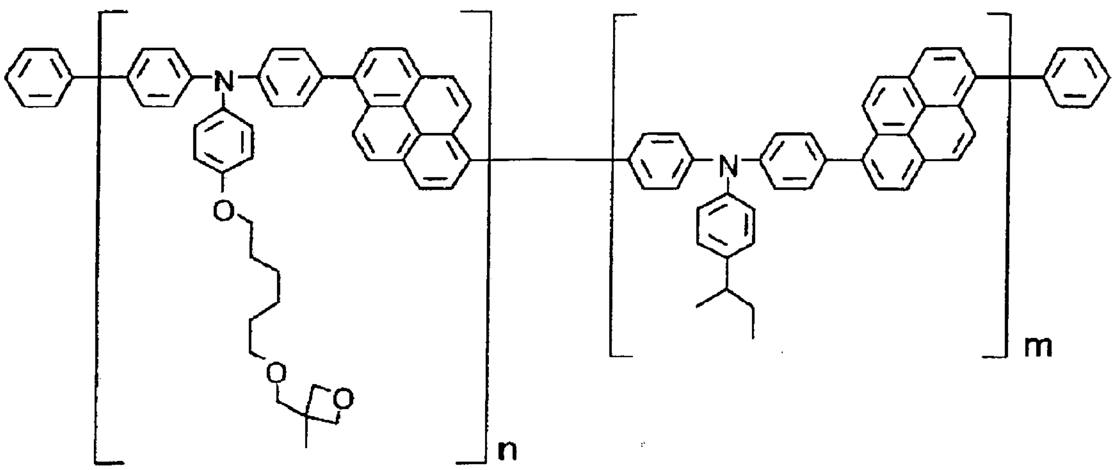

(wherein, for example, n = 0.1 and m = 0.9.)

[Formula 40]

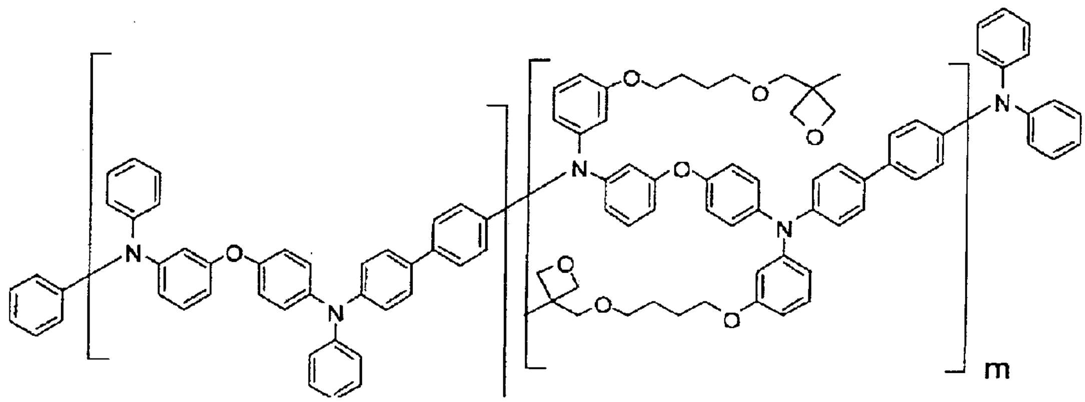

(wherein, for example, n = 0.9 and m = 0.1.)

{Content of Cross-Linking Compound}

A composition for producing the at least one organic layer typically contains 0.01% by weight or more, preferably 0.05% by weight or more, more preferably 0.1% by weight or more, and typically 50% by weight or less, preferably 20% by weight or less, more preferably 10% by weight or less, cross-linking compounds in total.

[Solvent]

A composition for producing the at least one organic layer generally further contains a solvent. The solvent preferably dissolves a cross-linking compound, and typically dissolves 0.01% by weight or more, preferably 0.05% by weight or more, more preferably 0.1% by weight or more cross-linking compound.

The solvent is not limited to a particular solvent. To dissolve a cross-linking compound, preferred examples of the solvent include organic solvents, for example, aromatic compounds, such as toluene, xylene, mesitylene, cyclohexylbenzene, pentafluoromethoxybenzene, and ethyl(pentafluorobenzoate); halogen-containing solvents, such as 1,2-dichloroethane, chlorobenzene, and o-dichlorobenzene; ether solvents, for example, aliphatic ethers, such as ethylene glycol dimethyl ether, ethylene glycol diethyl ether, and propylene glycol-1-monomethyl ether acetate (PGMEA), and aromatic ethers, such as 1,2-dimethoxybenzene, 1,3-dimethoxybenzene, anisole, phenetole, 2-methoxytoluene, 3-methoxytoluene, 4-methoxytoluene, trifluoromethoxyanisole, 3-(trifluoromethyl)anisole, 2,3-dimethylanisole, and 2,4-dimethylanisole; aliphatic esters, such as ethyl acetate, n-butyl acetate, ethyl lactate, and n-butyl lactate; ester solvents, such as phenyl acetate, phenyl propionate, methyl benzoate, ethyl benzoate, isopropyl benzoate, propyl benzoate, and n-butyl benzoate. These solvents may be used alone or in combination.

As a solvent contained in a composition for producing the at least one organic layer, if necessary, various solvents other than the aforementioned solvents may be contained. Examples of other solvents include amides, such as N,N-dimethylformamide and N,N-dimethylacetamide, and dimethyl sulfoxide.

The concentration of solvent contained in a composition for producing the at least one organic layer is typically 10% by weight or more, preferably 50% by weight or more, more preferably 80% by weight or more, of the composition.

It is widely known that water can accelerate the performance degradation, in particular luminance degradation during continuous operation, of organic electroluminescent elements. Thus, to minimize water remaining in a film, among these solvents, solvents having water solubility of 1% by weight or less at 25°C are preferred, and solvents having water solubility of 0.1% by weight or less at 25°C are more preferred. Examples of the solvents also include solvents having a surface tension below 40 dyn/cm, preferably 36 dyn/cm or less, more preferably 33 dyn/cm or less, at 20°C. Examples of solvents also include solvents having a vapor pressure of 10 mmHg or less, preferably 5 mmHg or less, and typically 0.1 mmHg or more, at 25°C. Use of such a solvent allows the preparation of a composition that is suitable for a process for producing an organic electroluminescent element by a wet deposition method and that is suited to the characteristics of a cross-linking compound.

Examples of a solvent contained in a composition for producing the at least one organic layer include mixed

solvents of solvents having a vapor pressure of 2 mmHg or more, preferably 3 mmHg or more, more preferably 4 mmHg or more (the upper limit is preferably 10 mmHg or less), at 25°C and solvents having a vapor pressure below 2 mmHg, preferably 1 mmHg or less, more preferably 0.5 mmHg or less, at 25°C.

[Additive Agent]

If necessary, a composition for producing the at least one organic layer may contain an electron-accepting compound, various additive agents, such as a coating improver, for example, a leveling agent or an anti-foaming agent, and additive agents, such as an additive for promoting a cross-linking reaction that decreases the solubility of a hole-transporting layer of the after-mentioned organic electroluminescent element and thereby allows another layer to be formed on the hole-transporting layer. In this case, a solvent that dissolves at least 0.05% by weight, preferably at least 0.5% by weight, more preferably at least 1% by weight, of each of a cross-linking compound and an additive agent, is preferably used as a solvent.

Examples of an additive for promoting a cross-linking reaction that is used in a composition for producing the at least one organic layer include polymerization initiators and polymerization accelerators, such as alkylphenone compounds, acylphosphine oxide compounds, metallocene compounds, oxime ester compounds, azo compounds, and onium salts, and photosensitizers, such as polycyclic hydrocarbons, porphyrin compounds, and diarylketone compounds. These additives may be used alone or in combination.

As the electron-accepting compound, one or at least two compounds described below as an electron-accepting compound contained in a hole-injection layer of an organic electroluminescent element described in detail below may be used.

[Amount of Unreacted Cross-Linking Group]

As described above and further defined in claim 1, a composition for producing the at least one organic layer contains at least two cross-linking compounds having different numbers of cross-linking groups selected from

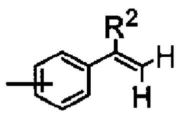

and

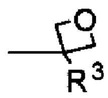

wherein $R^2$ and $R^3$ each independently denote a hydrogen atom or an alkyl group, and are compounds having a partial structure of the following formula [109]:

[Formula 109]

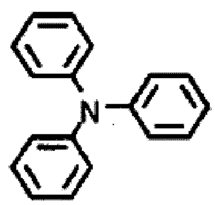

to control the number of cross-linking groups, decreasing the number of unreacted cross-linking groups after polymerization and thereby improving operation stability.

Through the control of the number of cross-linking groups, a composition for producing the at least one organic layer can decrease the number of unreacted cross-linking groups to the extent that a peak value due to unreacted cross-linking groups in a reflection absorption spectrum of a film formed of the composition measured by IR method under conditions described below decreases to 0.01 or less. The film is formed by applying the composition for producing the at least one organic layer to a glass substrate such that the film thickness after drying is 20 nm and heat-treating the composition at 200°C for 60 minutes to polymerize cross-linking compounds.

<IR Measurement Method>

IR measurement is performed with NEXUS670FTIR manufactured by Thermo Electron Co., Ltd. equipped with FT85 manufactured by Spectratech Inc. as an accessory. A reflection absorption spectrum is measured with a mercury-cadmium-tellurium detector (MCT detector; liquid nitrogen cooling) using infrared rays incident at an angle of 85 degrees

with respect to a normal line to the surface of a sample. The resolution is 4 $cm^{-1}$, and the number of scans is 1024. A reflection absorption spectrum of a sample is obtained by measuring the spectrum of an ITO substrate, which is used as a substrate for a sample, as the background spectrum and dividing measured data of the sample by the spectrum of an ITO substrate.

[II] Polymer Film

After the formation of a film of a composition for producing the at least one organic layer , cross-linking compounds are polymerized to form a polymer film.

In general, as a coating solution containing a solvent, a composition for producing the at least one organic layer is formed into a film on a substrate or another layer by a wet deposition method. As a film forming method, a coating method, such as a spin coating method or a spray method, a printing method, such as an ink-jet method or a screen method, or a known wet deposition method can be used in a manner that depends on the characteristics of an underlying substrate or another layer.

When a wet deposition method is used, a cross-linking compound and another optional component (such as an electron-accepting compound, an additive for promoting a cross-linking reaction, or a coating improver) are dissolved in an appropriate solvent to prepare the composition for producing the at least one organic layer described above. The composition is formed into a film by the aforementioned film forming method on a layer that corresponds to a layer underlying a layer to be formed, and is dried to form a layer. After the film formation, heating and/or active energy beam irradiation is applied to cause the polymerization reaction (cross-linking reaction) of the cross-linking compound to form a polymer film.

Any heating technique, including heat drying or vacuum drying, may be used. Conditions for heat drying involve heating of a formed layer typically at least 120°C and preferably 400°C or less. The heating time is typically at least one minute and preferably 24 hours or less. Any heating means may be used. For example, a substrate on which a layer is formed or a layered product is placed on a hot plate or heated in an oven. For example, conditions, such as heating on a hot plate at 120°C or more for at least one minute, may be used.

In the case of active energy beam irradiation, an irradiation method directly using an ultraviolet, visible, or infrared light source, such as an ultrahigh-pressure mercury lamp, a high-pressure mercury lamp, a halogen lamp, or an infrared lamp, or an irradiation method using a mask aligner including the aforementioned light source or a conveyor-type photoirradiation apparatus may be mentioned. An irradiation method using an apparatus that emits a microwave generated by, for example, a magnetron, that is, a so-called microwave oven may also be mentioned. As an irradiation time, conditions required to reduce the solubility of a film is preferably determined. Irradiation is performed typically at least 0.1 seconds and preferably 10 hours or less.

Heating and/or active energy beam irradiation may be performed alone or in combination. When heating and/or active energy beam irradiation is used in combination, they may be performed in any order.

Heating and/or active energy beam irradiation is preferably performed in an atmosphere free of water, such as a nitrogen gas atmosphere, to decrease the water content of a layer and/or water adsorbed on the surface of a layer after irradiation. When heating and/or active energy beam irradiation is used in combination for the same purpose, at least a process immediately before the formation of an upper layer is particularly preferably performed in an atmosphere free of water, such as a nitrogen gas atmosphere.

The thickness of a polymer film thus formed is not limited to a particular value and is appropriately determined on the basis of its application.

[III] Organic Electroluminescent Element

An organic electroluminescent element according to the present invention includes an anode and a cathode on a substrate and one or at least two organic layers disposed between the anode and the cathode, wherein at least one of the organic layers is a layer formed of a polymer film produced by forming a film of a composition as defined in claim 1 and explained above, and then polymerizing cross-linking compounds in the composition.

The layer formed of a polymer film is preferably a hole-transporting layer described in detail below. The hole-transporting layer is preferably formed by wet deposition of a composition for producing the at least one organic layer.

A light-emitting layer is preferably formed on the hole-transporting layer adjacent to a cathode by a wet deposition method. A hole-injection layer is preferably formed on the hole-transporting layer adjacent to an anode by a wet deposition method.

Thus, in an organic electroluminescent element according to the present invention, all the hole-injection layer, hole-transporting layer, and light-emitting layer are preferably formed by a wet deposition method. In particular, the light-emitting layer formed by the wet deposition method is preferably a layer that contains a low-molecular-weight luminescent material having a molecular weight of 10000 or less.

Fig. 1 is a schematic cross-sectional view of the structure of an organic electroluminescent element according to an embodiment of the present invention. The organic electroluminescent element illustrated in Fig. 1 includes an anode 2, a hole-injection layer 3, a hole-transporting layer 4, an organic light-emitting layer 5, a hole-blocking layer 6, an electron-transporting layer 7, an electron-injection layer 8, and a cathode 9 layered on a substrate 1 in this order. In this structure, the hole-transporting layer 4 generally corresponds to a layer formed by forming a film of a composition for producing the at least one organic layer and then by polymerization, as described above.

[1] Substrate

The substrate 1 serves as a support for an organic electroluminescent element and may be a quartz or glass plate, a metal plate, a metallic foil, or a plastic film or sheet. In particular, a glass plate and plates formed of transparent synthetic resins, such as polyester, polymethacrylate, polycarbonate, and polysulfone are preferred. When a synthetic resin substrate is used, gas barrier characteristics must be considered. Too low gas barrier of a substrate is unfavorable because an organic electroluminescent element may deteriorate owing to the outside air passing through the substrate. Thus, as one of preferred methods, a dense silicon oxide film may be provided on at least one side of a synthetic resin substrate to secure gas barrier.

[2] Anode

The anode 2 plays a role of injecting positive holes into a layer (such as the hole-injection layer 3 or the organic light-emitting layer 5) adjacent to an organic light-emitting layer described below. The anode 2 is generally formed of a metal, such as aluminum, gold, silver, nickel, palladium, or platinum, a metal oxide, such as indium and/or tin oxide, a halogenated metal, such as copper iodide, carbon black, or an electroconductive polymer, such as poly(3-methylthiophene), polypyrrole, or polyaniline. In general, the anode 2 is often formed by a sputtering method or a vacuum evaporation method. In the case of fine particles of metal, such as silver, fine particles of copper iodide, carbon black, electroconductive metal oxide fine particles, or finely divided electroconductive polymer, the anode 2 may also be formed by dispersing them in an appropriate binder resin solution and applying the dispersion to the substrate 1. In the case of an electroconductive polymer, the anode 2 may be formed by forming a thin film directly on the substrate 1 by electrolytic polymerization, or by applying an electroconductive polymer to the substrate 1 (see Applied Physics Letters, 1992, Vol. 60, pp. 2711). The anode 2 may be formed of layered different substances.

The thickness of the anode 2 depends on required transparency. When transparency is required, it is desired that the transmittance of visible light is typically at least 60%, preferably at least 80%. In this case, the thickness is typically at least 5 nm, preferably at least 10 nm, and typically 1000 nm or less, preferably 500 nm or less. When the anode 2 may be opaque, the anode 2 may be the same as the substrate 1. Furthermore, another different electroconductive material may be disposed on the anode 2.

To remove impurities adhering to the anode and control the ionization potential to improve the hole-injection characteristic, the surface of the anode is preferably treated with ultraviolet rays (UV)/ozone, oxygen plasma, or argon plasma. To further improve the efficiency of hole injection and improve the adhesion strength of the entire organic layer to the anode, a known anode buffer layer may be disposed between the hole-injection layer 3 and the anode 2.

[3] Hole-Injection layer

The hole-injection layer 3 is a layer that transports positive holes from the anode 2 to the organic light-emitting layer 5. In general, the hole-injection layer 3 is formed on the anode 2. Thus, preferably, the hole-injection layer 3 contains a hole-injecting compound and an electron-accepting compound. The hole-injection layer 3 may contain another component.

The hole-injection layer 3 may be formed on the anode 2 by a wet deposition method or a vacuum evaporation method. As described above, the wet deposition method is preferred because the wet deposition method can easily provide a uniform, defect-free thin film and requires only a short time to form the film. Indium tin oxide (ITO), which is widely used as an anode 2, not only has a surface roughness (Ra) of about 10 nm, but also often has a local projection, thus having a tendency to cause a short circuit defect. The formation of the hole-injection layer 3 on the anode 2 by the wet deposition method, as compared with the formation by a vacuum evaporation method, also has an advantage of decreasing the frequency of defects of the element resulting from recessed and raised portions on the surface of the anode 2.

An aromatic amine compounds acting as a hole-injecting compound is preferably a compound having a triarylamine structure and may be appropriately selected from compounds that have been used as materials for forming hole-injection layers in conventional organic electroluminescent elements. Examples of the aromatic amine compounds include binaphthyl compounds having the following general formula (1).

[Formula 41]

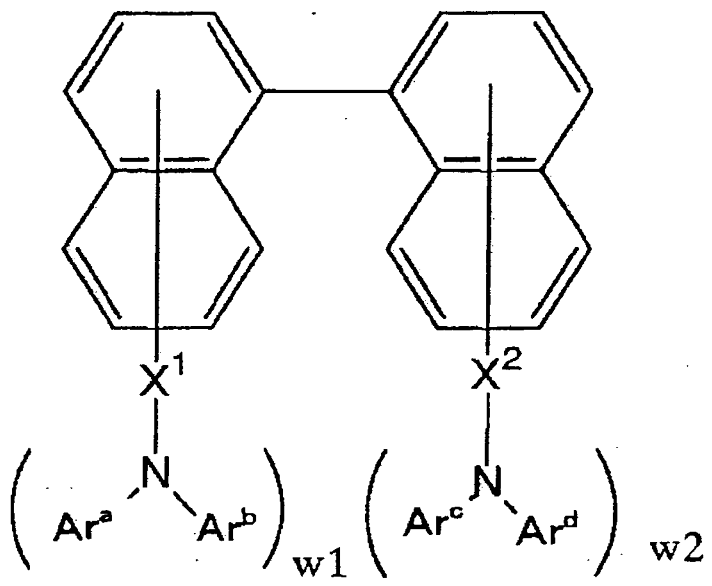

(1)

In the general formula (1), $Ar^a$ to $Ar^d$ each independently denote a monocyclic group or fused ring group of a 5- or 6-membered aromatic hydrocarbon ring or heteroaromatic ring each optionally having a substituent. Each of $Ar^a$ and $Ar^b$, and Arc and $Ar^d$ may be bound to form a ring. W1 and W2 individually denote an integer in the range of 0 to 4 and satisfy W1 + W2 ≥ 1. $X^1$ and $X^2$ each independently denote a direct bond or a bivalent linking group. In addition to $-(X^1NAr^aAr^b)$ and $-(X^2NAr^cAr^d)$, the naphthalene rings in the general formula (1) may have any other substituent.

In the general formula (1), examples of the monocyclic group or fused ring group of a 5- or 6-membered aromatic hydrocarbon ring or heteroaromatic ring each optionally having a substituent in $Ar^a$ to $Ar^d$ include 5- or 6-membered monocyclic rings or bicyclic to tricyclic fused rings and, more specifically, groups derived from aromatic hydrocarbon rings, such as a phenyl group, a naphthyl group, and an anthryl group, and groups derived from heteroaromatic rings, such as a pyridyl group and a thienyl group. These groups may have a substituent.

Examples of the substituent that $Ar^a$ to $Ar^d$ may have include the after-mentioned substituents that Are to $Ar^1$ may have and arylamino groups (corresponding to $-(NAr^eAr^f)$ and-$(NAr^gAr^h)$ described below).

$Ar^a$ and $Ar^b$ and/or Arc and $Ar^d$ may individually be bound to form a ring. In this case, specific examples of the ring thus formed include a carbazole ring, a phenoxazine ring, an iminostilbene ring, a phenothiazine ring, an acridone ring, an acridine ring, and an iminodibenzyl ring, each of which may have a substituent. Among others, a carbazole ring is preferred.

In the general formula (1), W1 and W2 individually denote an integer in the range of 0 to 4 and satisfy W1 + W2 ≥ 1. W1 = 1 and W2 = 1 are particularly preferred. When W1 and/or W2 is at least 2, the arylamino groups may individually be the same or different.

$X^1$ and $X^2$ each independently denote a direct bond or a bivalent linking group. While the bivalent linking group is not limited to a particular group, examples of the bivalent linking group include the following groups. Direct bonds are particularly preferred as $X^1$ and $X^2$.

[Formula 42]

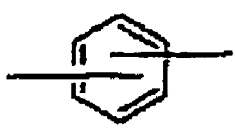

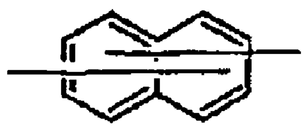

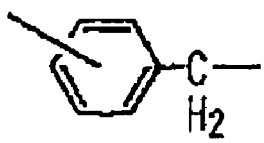

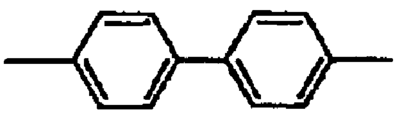

In addition to - ($X^1NAr^aAr^b$) and - ($X^2NAr^cAr^d$), the naphthalene rings in the general formula (1) may have one or at least two substituents at any position. Preferably, the one or at least two substituents are one or at least two substituents selected from the group consisting of a halogen atom, a hydroxyl group, alkyl groups optionally having a substituent, alkoxy groups optionally having a substituent, alkenyl groups optionally having a substituent, and alkoxycarbonyl groups optionally having a substituent. Among others, alkyl groups are particularly preferred.

As shown by the following general formula (1-1), a binaphthyl compound in which $Ar^a$ and Arc are individually further substituted with an arylamino group is preferred as the binaphthyl compound having the general formula (1).

[Formula 43]

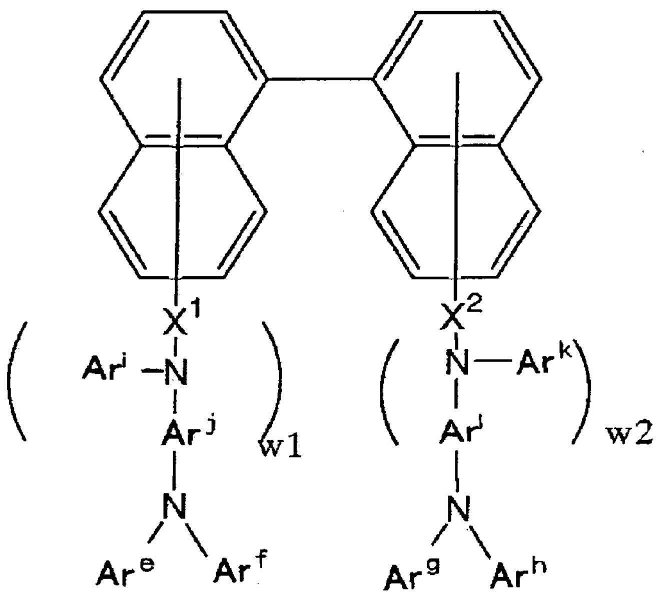

(1-1)

(In the general formula (1-1), Are to $Ar^1$ each independently denote a monocyclic group or fused ring group of a 5- or 6-membered aromatic hydrocarbon ring or heteroaromatic ring each optionally having a substituent. Are and $Ar^f$, and $Ar^g$ and $Ar^h$ may individually be bound to form a ring. W1 and W2 are the same as in the general formula (1). $X^1$ and $X^2$ are the same as in the general formula (1).)

In addition to the substituents -($X^1NAr^iAr^jNAr^fAr^e$) and - ($X^2NAr^kAr^lNAr^gAr^h$) that are bound to the respective naphthalene rings and include arylamino groups, the naphthalene rings in the general formula (1-1) may have any substituent. These substituents -($X^1NAr^iAr^jNAr^fAr^e$) and - ($X^2NAr^kAr^lNAr^gAr^h$) may have a substituent at any substitution position in the naphthalene rings. Among others, a binaphthyl compound in which positions 4 and 4' of the naphthalene rings in the general formula (1-1) are substituted is more preferred.

Examples of a polymer compound having a hole-transporting site therein, which is used as a hole-injecting compound, include polymer compounds that contain aromatic tertiary amino groups as constitutional units in the main skeleton. Specific examples are hole-injecting compounds that have a structure of the following general formula (2) as a constitutional repeating unit.

[Formula 44]

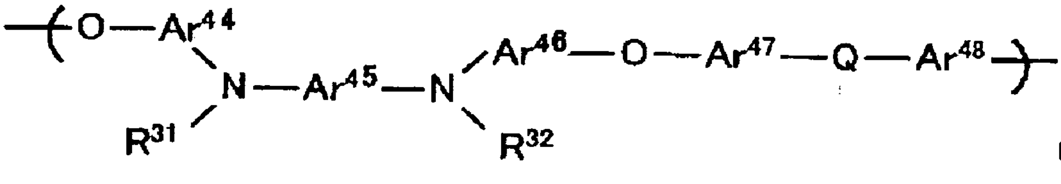

(2)

(In the formula (2), $Ar^{44}$ to $Ar^{48}$ each independently denote a bivalent aromatic ring group optionally having a substituent. $R^{31}$ and $R^{32}$ each independently denote a univalent aromatic ring group optionally having a substituent. Q

denotes a direct bond or is selected from the following linking groups. An "aromatic ring group" encompasses both "a group derived from an aromatic hydrocarbon ring" and "a group derived from a heteroaromatic ring".)

[Formula 45]

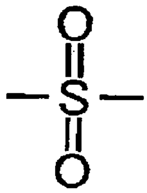

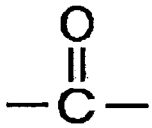

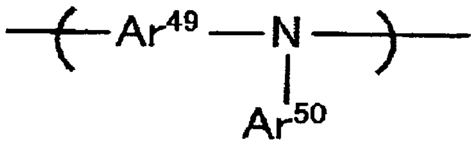

(3)

(In the formula (3), $Ar^{49}$ denotes a bivalent aromatic ring group optionally having a substituent, and $Ar^{50}$ denotes a univalent aromatic ring group optionally having a substituent.)

In the general formula (2), preferably, $Ar^{44}$ to $Ar^{48}$ are each independently a group derived from a bivalent benzene, naphthalene, or anthracene ring each optionally having a substituent, or a biphenyl group, and are preferably groups derived from a benzene ring. Examples of the substituent include a halogen atom; linear or branched alkyl groups having 1 to 6 carbon atoms, such as a methyl group and an ethyl group; alkenyl groups, such as a vinyl group; linear or branched alkoxycarbonyl groups having 2 to 7 carbon atoms, such as a methoxycarbonyl group and an ethoxycarbonyl group; linear or branched alkoxy groups having 1 to 6 carbon atoms, such as a methoxy group and an ethoxy group; aryloxy groups having 6 to 12 carbon atoms, such as a phenoxy group and a benzyloxy group; and dialkylamino groups including an alkyl chain having 1 to 6 carbon atoms, such as a diethylamino group and a diisopropylamino group. Among others, alkyl groups having 1 to 3 carbon atoms are preferred, and a methyl group is particularly preferred. Most preferably, all of $Ar^{44}$ to $Ar^{48}$ are unsubstituted aromatic ring groups.

$R^{31}$ and $R^{32}$ are each independently preferably a phenyl group, a naphthyl group, an anthryl group, a pyridyl group, a triazyl group, a pyrazyl group, a quinoxalyl group, a thienyl group, or a biphenyl group, each of which may have a substituent, preferably a phenyl group, a naphthyl group, or a biphenyl group, and more preferably a phenyl group. The substituent may be the same group as described above as a group that the aromatic ring in $Ar^{44}$ to $A^{48}$ may have.

In the general formula (3), $Ar^{49}$ is a bivalent aromatic ring group optionally having a substituent, preferably an aromatic hydrocarbon ring group in terms of hole-transporting characteristics and more specifically includes a group derived from a bivalent benzene ring, naphthalene ring, and anthracene ring each optionally having a substituent, a biphenylene group, and a terphenylene group. The substituent may be the same group as described above as a group that the aromatic ring in $Ar^{44}$ to $A^{48}$ may have. Among others, alkyl groups having 1 to 3 carbon atoms are preferred, and a methyl group is particularly preferred.

$Ar^{50}$ is an aromatic ring group optionally having a substituent, preferably an aromatic hydrocarbon ring group in terms of hole-transporting characteristics and more specifically includes a phenyl group, a naphthyl group, an anthryl group, a pyridyl group, a triazyl group, a pyrazyl group, a quinoxalyl group, a thienyl group, and a biphenyl group, each of which may have a substituent. The substituent may be the same group as described above as a group that the aromatic ring in $Ar^{44}$ to $A^{48}$ in the general formula (2) may have.

In the general formula (3), most preferably, both $Ar^{49}$ and $Ar^{50}$ are unsubstituted aromatic ring groups.

Examples of a hole-injecting compound having an aromatic tertiary amino group as a side chain include compounds having constitutional repeating unit having structures of the following general formulae (4) and (5).

[Formula 46]

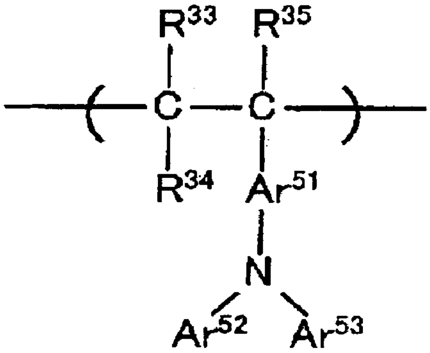

(4)

(In the formula (4), $Ar^{51}$ denotes a bivalent aromatic ring group optionally having a substituent. $Ar^{52}$ and $Ar^{53}$ each independently denote a univalent aromatic ring group optionally having a substituent. $R^{33}$ to $R^{35}$ each independently denote a hydrogen atom, a halogen atom, an alkyl group, an alkoxy group, or a univalent aromatic ring group optionally having a substituent.)

[Formula 47]

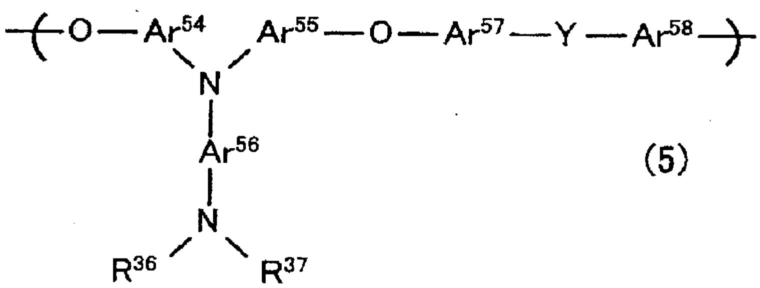

(5)

(In the formula (5), $Ar^{54}$ to $Ar^{58}$ each independently denote a bivalent aromatic ring group optionally having a substituent. $R^{36}$ and $R^{37}$ each independently denote an aromatic ring group optionally having a substituent. Y denotes a direct bond or is selected from the following linking groups.)

[Formula 48]

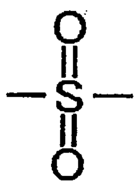

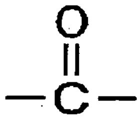

In the general formula (4), $Ar^{51}$ is preferably a group derived from a bivalent benzene, naphthalene, or anthracene ring each optionally having a substituent, or a biphenylene group. Examples of the substituent include the same groups as described above as groups that the aromatic ring in $Ar^{44}$ to $Ar^{48}$ in the aforementioned general formula (2) may have. Preferred groups are also the same as described above.

$Ar^{52}$ and $Ar^{53}$ each independently preferably include a phenyl group, a naphthyl group, an anthryl group, a pyridyl group, a triazyl group, a pyrazyl group, a quinoxalyl group, a thienyl group, and a biphenyl group, each of which may have a substituent. Examples of the substituent include the same groups as described above as groups that the aromatic ring in $Ar^{44}$ to $Ar^{48}$ in the general formula (2) may have. Preferred groups are also the same as described above.

$R^{33}$ to $R^{35}$ is each independently preferably a hydrogen atom; a halogen atom; linear or branched alkyl groups having 1 to 6 carbon atoms, such as a methyl group and an ethyl group; linear or branched alkoxy groups having 1 to 6 carbon atoms, such as a methoxy group and an ethoxy group; a phenyl group; or a tolyl group.

In the general formula (5), preferably, $Ar^{54}$ to $Ar^{58}$ are each independently a group derived from a bivalent benzene, naphthalene, or anthracene ring, each of which may have a substituent, or a biphenyl group, and are preferably groups derived from a benzene ring. Examples of the substituent include the same groups as described above as groups that the aromatic ring in $Ar^{44}$ to $Ar^{48}$ in the general formula (2) may have. Preferred groups are also the same as described above.

$R^{36}$ and $R^{37}$ are each independently preferably a phenyl group, a naphthyl group, an anthryl group, a pyridyl group, a triazyl group, a pyrazyl group, a quinoxalyl group, a thienyl group, or a biphenyl group, each of which may have a substituent. Examples of the substituent include the same groups as described above as groups that the aromatic ring in $Ar^{44}$ to $Ar^{48}$ in the general formula (2) may have. Preferred groups are also the same as described above.

Preferred examples of the structures of the general formulae (2) to (5) include, but not limited to, the following structures.

[Formula 49]

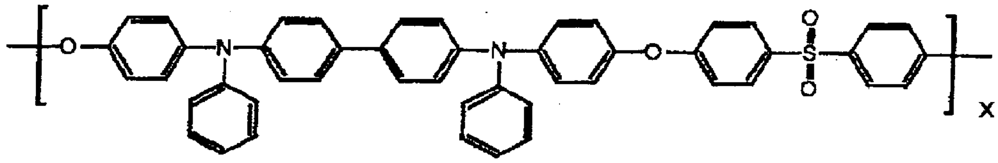

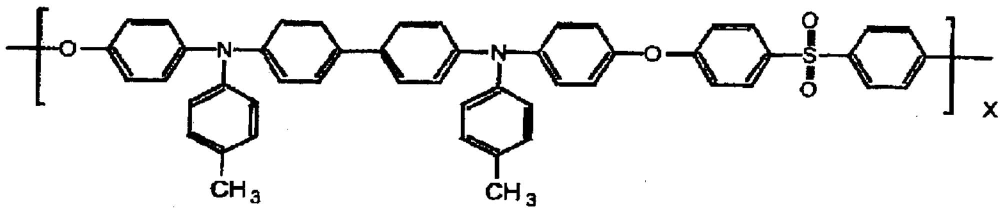

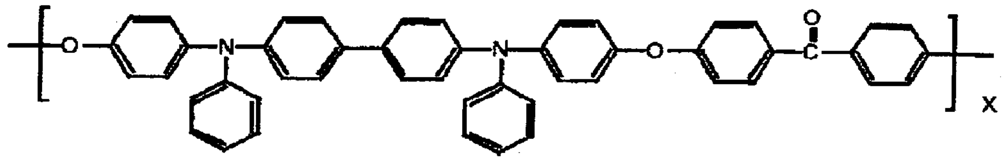

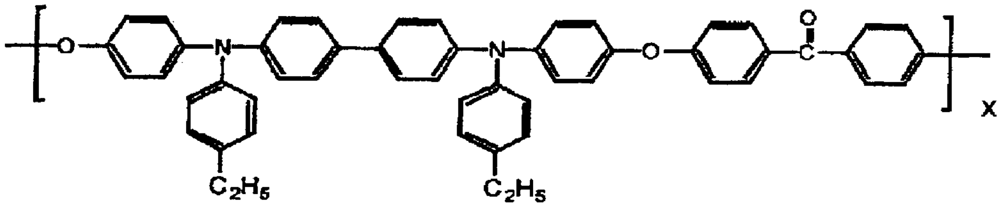

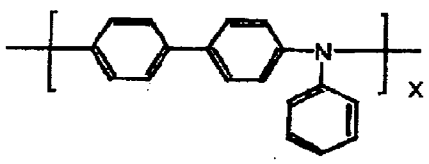

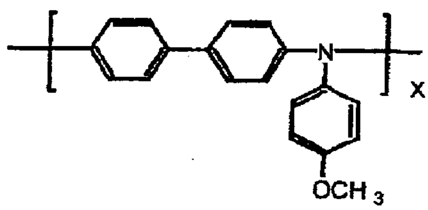

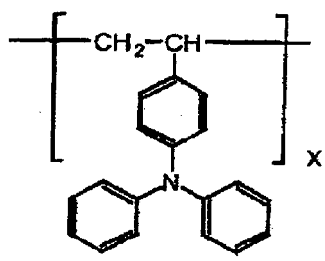

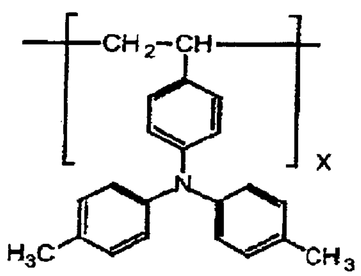

A hole-injecting compound that is a polymer compound having a hole-transporting site therein is most preferably

a homopolymer having a structure of any of the general formulae (2) to (5) and may be a copolymer (copolymeric substance) with another monomer. The copolymer preferably includes at least 50% by mole, in particular at least 70% by mole, constitutional units having the general formulae (2) to (5). A hole-injecting material that is a polymer compound may include a plurality of structures having the general formulae (2) to (5) in the compound. Furthermore, a plurality of compounds having the structures of the general formulae (2) to (5) may be used in combination. Among the general formulae (2) to (5), a homopolymer composed of a constitutional repeating unit having the general formula (2) is particularly preferred.

The hole-injecting material formed of a polymer compound may also be a conjugated polymer. To this end, polyfluorene, polypyrrole, polyaniline, polythiophene, and poly(para-phenylene vinylene) are suitable.

An electron-accepting compound will be described below.

Examples of the electron-accepting compound contained in the hole-injection layer include one or at least two compounds selected from the group consisting of triarylboron compounds, halogenated metals, Lewis acids, organic acids, onium salts, salts of arylamines and halogenated metals, and salts of arylamines and Lewis acids. These electron-accepting compounds can be mixed with a hole-injecting material and oxidize the hole-injecting material, thereby improving the electric conductivity of the hole-injection layer.

As an electron-accepting compound, triarylboron compounds include boron compounds having the following general formula (6). Preferably, the boron compounds having the general formula (6) are Lewis acids. The electron affinity of the boron compounds is typically at least 4 eV, preferably at least 5 eV.

[Formula 50]

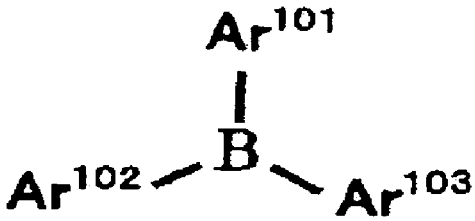

(6)

In the general formula (6), preferably, $Ar^{101}$ to $Ar^{103}$ each independently denote a 5- or 6-membered monocyclic ring, such as a phenyl, naphthyl, anthryl, or biphenyl group, each of which may have a substituent, or an aromatic hydrocarbon ring group that is formed by condensation and/or direct bonding of two or three of these monocyclic rings; 5- or 6-membered monocyclic ring, such as a thienyl, pyridyl, triazyl, pyrazyl, or quinoxalyl group, each of which may have a substituent, or a heteroaromatic ring group that is formed by condensation and/or direct bonding of two or three of these monocyclic rings.

Examples of the substituent that $Ar^{101}$ to $Ar^{103}$ may have include a halogen atom, alkyl groups, alkenyl groups, alkoxycarbonyl groups, alkoxy groups, aryloxy groups, acyl groups, haloalkyl groups, and cyano groups.

In particular, preferably, at least one of $Ar^{101}$ to $Ar^{103}$ is a substituent having positive Hammett constants ($\sigma_m$ and/or $\sigma_p$). Particularly preferably, all of $Ar^{101}$ to $Ar^{103}$ are substituents having positive Hammett constants ($\sigma_m$ and/or $\sigma_p$). Such electron-withdrawing substituents can improve the electron-accepting characteristics of these compounds. More preferably, all of $Ar^{101}$ to $Ar^{103}$ are aromatic hydrocarbon groups or heteroaromatic ring groups each substituted with a halogen atom.

Specific preferred examples of boron compounds having the general formula (6) include, but not limited to, the following 6-1 to 6-17.

[Formula 51]

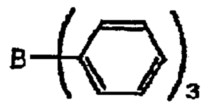

6-1

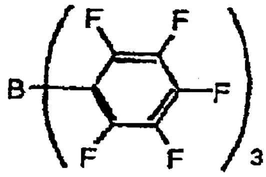

6-2

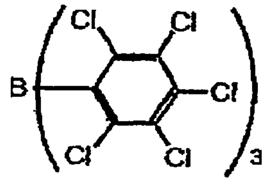

6-3

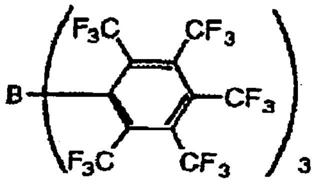

6-4

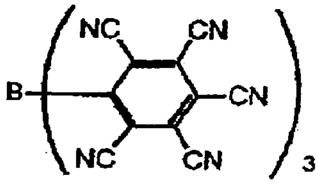

6-5

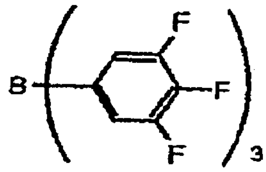

6-6

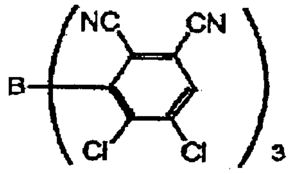

6-7

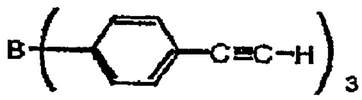

6-8

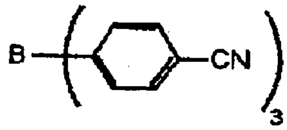

6-9

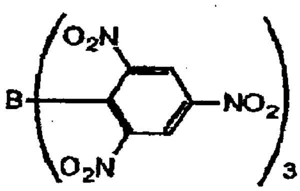

6-10

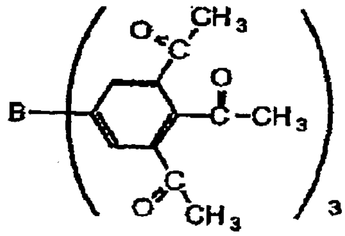

6-11

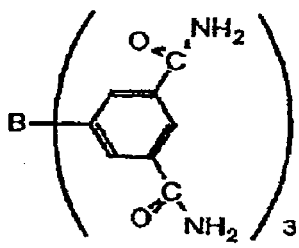

6-12

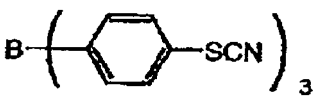

6-13

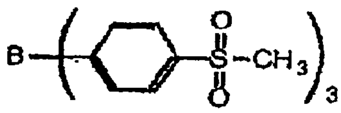

6-14

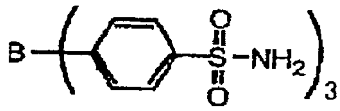

6-15

[Formula 52]

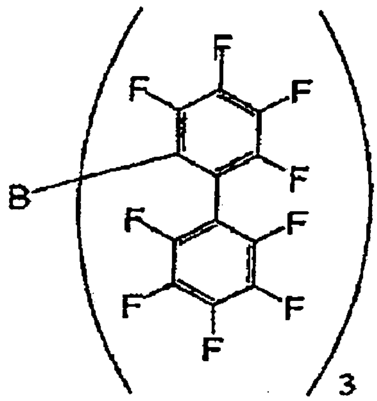

6-16

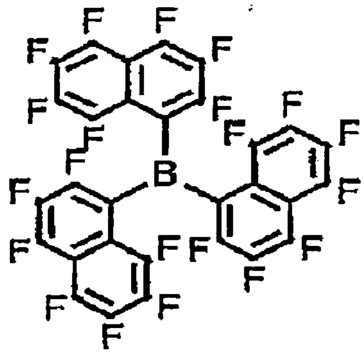

6-17

Among others, the following compounds are particularly preferred.

[Formula 53]

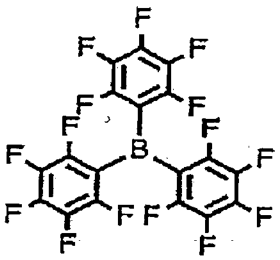

PPB

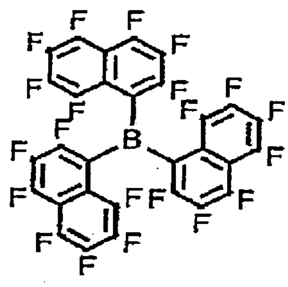

PNB

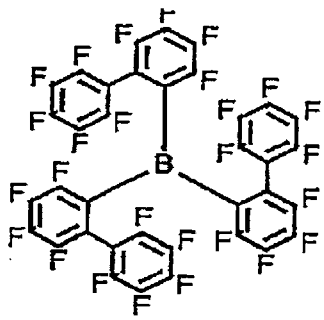

PBB

As an electron-accepting compound, examples of onium salts include those described in WO 2005/089024. Suitable examples of onium salts are also described in WO 2005/089024. The following compounds are particularly preferred.

[Formula 54]

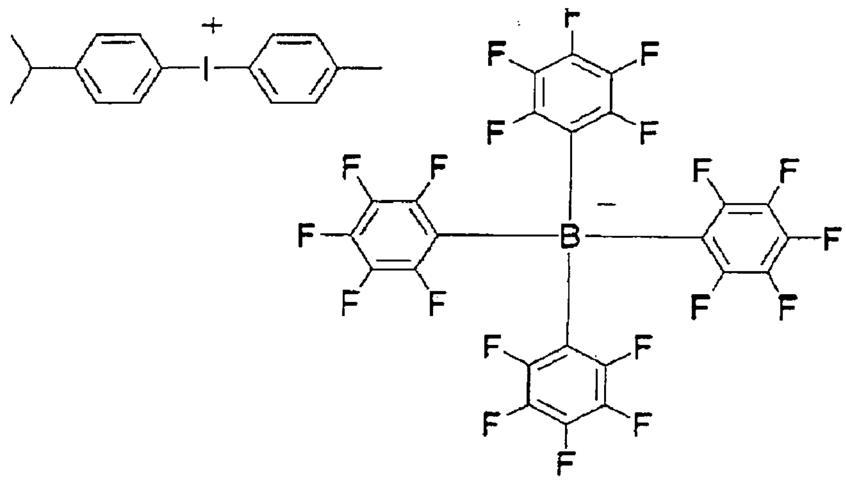

The thickness of the hole-injection layer 3 is typically at least 5 nm, preferably at least 10 nm, and typically 1000 nm or less, preferably 500 nm or less.

The content of the electron-accepting compound in the hole-injection layer 3 is typically at least 0.1% by mole, preferably at least 1% by mole, of the hole-injecting compound. However, the content is typically 100% by mole or less, preferably 40% by mole or less.

[4] Hole-Transporting Layer

The hole-transporting layer 4 has a function of injecting positive holes that were injected into the anode 2 and the hole-injection layer 3 in this order into the organic light-emitting layer 5, as well as a function of preventing a decrease in luminous efficacy resulting from the injection of electrons from the light-emitting layer 5 toward the anode 2.

To perform these functions, preferably, the hole-transporting layer 4 is a layer formed of a composition for producing the at least one organic layer, as described above. Thus, preferably, a polymer film produced from a composition comprising at least two cross-linking compounds and polymerizing the cross-linking compounds, wherein at least two of the cross-linking compounds have different numbers of cross-linking groups selected from

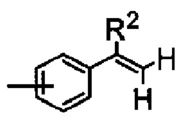

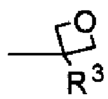

and

wherein $R^2$ and $R^3$ each independently denote a hydrogen atom or an alkyl group, and wherein the crosslinking compounds are compounds having a partial structure of the following formula [109]:

[Formula 109]

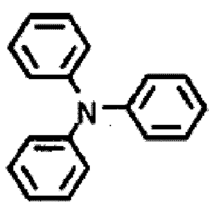

, is used as a hole-transporting layer.

The hole-transporting layer is formed by a method as described above.

The thickness of the hole-transporting layer is typically at least 5 nm, preferably at least 10 nm, and typically 1000 nm or less, preferably 500 nm or less.

[5] Organic Light-Emitting Layer

The organic light-emitting layer 5 is generally formed on the hole-transporting layer 4. The organic light-emitting layer 5 is a layer that is excited by recombination of positive holes injected from the anode 2 through the hole-injection layer 3 and the hole-transporting layer 4 with electrons injected from the cathode 9 through the electron-injection layer 7 and the hole-blocking layer 6 between the electrodes to which an electric field is applied and that acts as the main light source.

The organic light-emitting layer 5 contains at least a material that has a luminous property (luminescent material) and preferably a material that has a hole-transporting property (hole-transporting compound) or a material that has an electron-transporting property (electron-transporting compound). The organic light-emitting layer 5 may contain another component without departing from the gist of the present invention. A low molecular material is preferably used for any of these materials in view of the formation of the organic light-emitting layer 5 by a wet deposition method as described below.

Any known material is applicable as the luminescent material. For example, the luminescent material may be a fluorescent material or a phosphorescent material and is preferably a phosphorescent material in terms of internal quantum efficiency.

To improve the solubility in a solvent, it is important to decrease the molecular symmetry or rigidity of a luminescent material or introduce a lipophilic substituent, such as an alkyl group.

Fluorescent dyes that provide blue light emission include perylene, pyrene, anthracene, coumarin, p-bis(2-phenylethynyl)benzene, and derivatives thereof. Green fluorescent dyes include quinacridone derivatives and coumarin derivatives. Yellow fluorescent dyes include rubrene and perimidone derivatives. Red fluorescent dyes include 4-(dicyanomethylene)-2-methyl-6-(p-dimethylaminostyryl)-4H-pyran (DCM) compounds, benzopyran derivatives, rhodamine derivatives, benzothioxanthen derivatives, and azabenzothioxanthen.

Examples of the phosphorescent material include organic metal complexes that contain a metal selected from Groups 7 to 11 of a long-form periodic table (Unless otherwise specified, a "periodic table" hereinafter refers to a long-form periodic table.).

Groups 7 to 11 metals in the periodic table contained in the phosphorescent organic metal complex preferably include ruthenium, rhodium, palladium, silver, rhenium, osmium, iridium, platinum, and gold. These organic metal complexes are preferably compounds having the following formula (III) or (IV).

$$ML_{(q-j)}L'_j \qquad (III)$$

(In the formula (III), M denotes a metal, and q denotes the valency of the metal. L and L' denote bidentate ligands. j is 0, 1, or 2.)

[Formula 55]

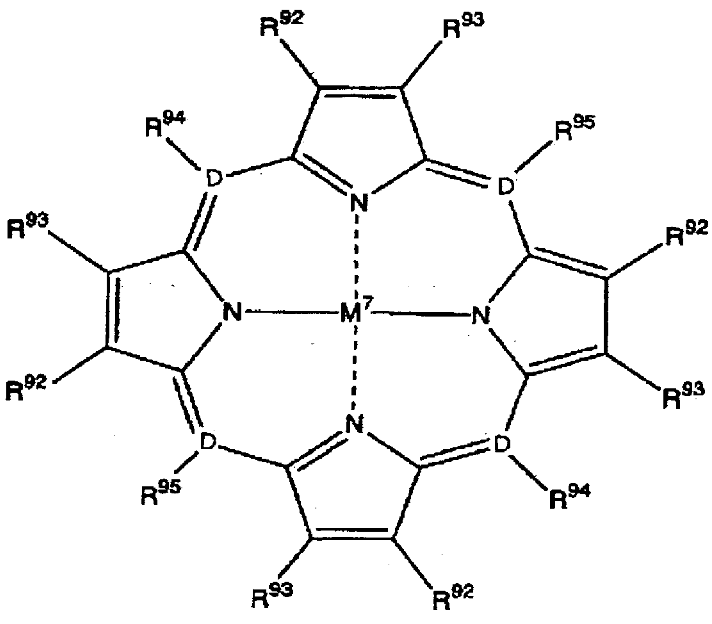

(IV)

(In the formula (IV), $M^7$ denotes a metal, and D denotes a carbon atom or a nitrogen atom. $R^{92}$ to $R^{95}$ each independently denote a substituent. When D is a nitrogen atom, there is no $R^{94}$ or $R^{95}$.)

Compounds having the formula (III) will be described below.

In the formula (III), M denotes a metal. Specific preferred examples of the metal include the aforementioned metals selected from Groups 7 to 11 of the periodic table.

In the formula (III), the bidentate ligand L denotes a ligand having the following partial structure.

[Formula 56]

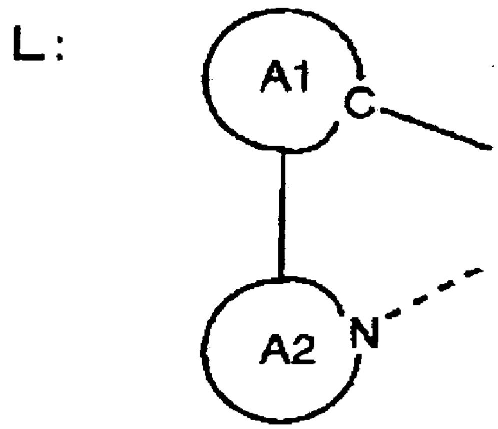

(In the partial structure of L, the ring A1 denotes an aromatic hydrocarbon group or a heteroaromatic ring group each optionally having a substituent.)

Examples of the aromatic hydrocarbon group include 5- or 6-membered monocyclic rings or bicyclic to pentacyclic fused rings. Specific examples include univalent groups derived from a benzene ring, a naphthalene ring, an anthracene ring, a phenanthrene ring, a perylene ring, a tetracene ring, a pyrene ring, a benzpyrene ring, a chrysene ring, a triphenylene ring, an acenaphthene ring, a fluoranthene ring, and a fluorene ring.

Examples of the heteroaromatic ring group include 5- or 6-membered monocyclic rings or bicyclic to tetracyclic fused rings. Specific examples include univalent groups derived from a furan ring, a benzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzoisoxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a cinnoline ring, a quinoxaline ring, a phenanthridine ring, a benzoimidazole ring, a perimidine ring, a quinazoline ring, a quinazolinone ring, and an azulene ring.

In the partial structure of L, the ring A2 denotes a nitrogen-containing heteroaromatic ring group optionally having a substituent.

Examples of the nitrogen-containing heteroaromatic ring group include groups derived from 5- or 6-membered monocyclic rings or bicyclic to tetracyclic fused rings. Specific examples include univalent groups derived from a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a furopyrrole ring, a thienofuran ring, a benzoisoxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a quinoxaline ring, a phenanthridine ring, a benzoimidazole ring, a perimidine ring, a quinazoline ring, and a quinazolinone ring.

Examples of a substituent that the ring A1 or the ring A2 may have include a halogen atom, alkyl groups, alkenyl groups, alkoxycarbonyl groups, alkoxy groups, aryloxy groups, dialkylamino groups, diarylamino groups, a carbazolyl group, an acyl group, haloalkyl groups, a cyano group, and aromatic hydrocarbon groups.

In the formula (III), the bidentate ligand L' denotes a ligand having the following partial structure. In the following formula, "Ph" denotes a phenyl group.

[Formula 57]

L' :

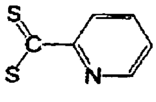 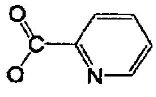 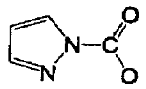 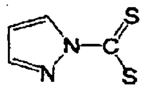 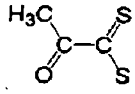 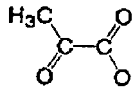

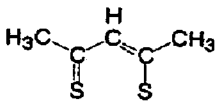 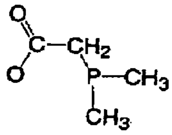 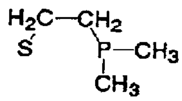 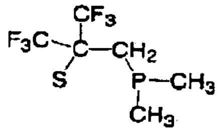 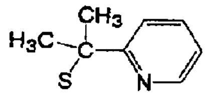

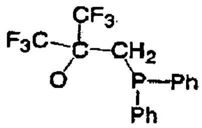 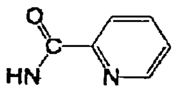 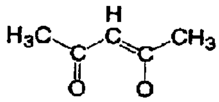 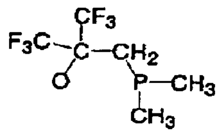 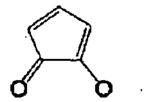

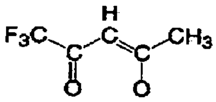 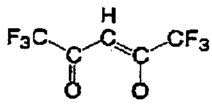 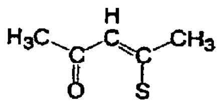 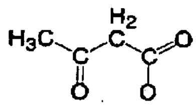

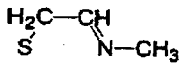 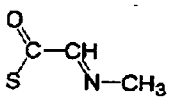 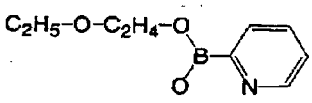 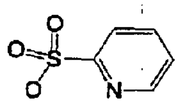 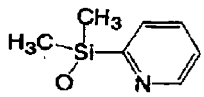

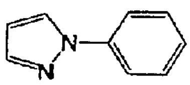 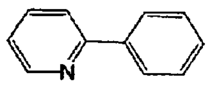 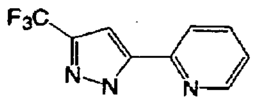 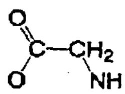

Among others, L' is preferably the following ligands in terms of the stability of the complex.

[Formula 58]

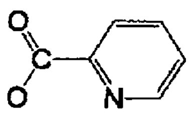 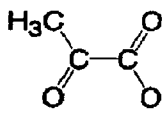 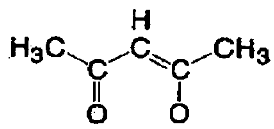

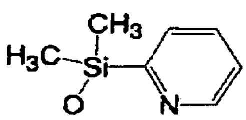 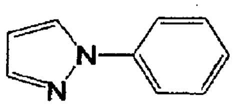 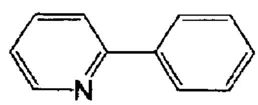

More preferably, the compounds having the formula (III) are compounds having the following formulae (IIIa), (IIIb), and (IIIc).

[Formula 59]

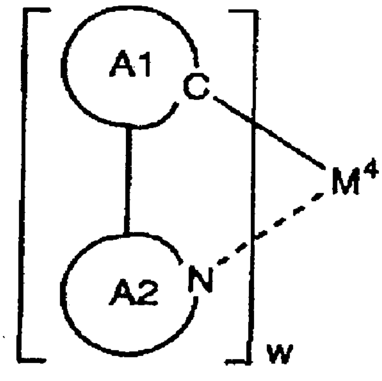

(IIIa)

(In the formula (IIIa), $M^4$ denotes the same metal as M, w denotes the valency of the metal, the ring A1 denotes an aromatic hydrocarbon group optionally having a substituent, and the ring A2 denotes a nitrogen-containing heteroaromatic ring group optionally having a substituent.)

[Formula 60]

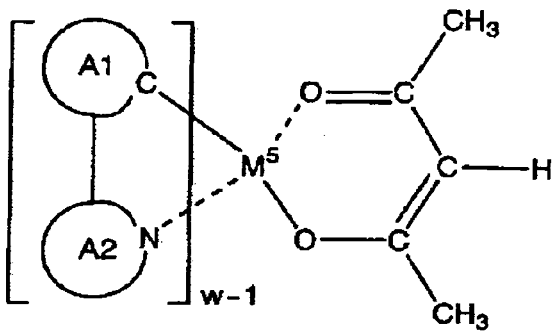

(IIIb)

(In the formula (IIIb), $M^5$ denotes the same metal as M, w denotes the valency of the metal, the ring A1 denotes an aromatic hydrocarbon group or a heteroaromatic ring group each optionally having a substituent, and the ring A2 denotes a nitrogen-containing heteroaromatic ring group optionally having a substituent.)

[Formula 61]

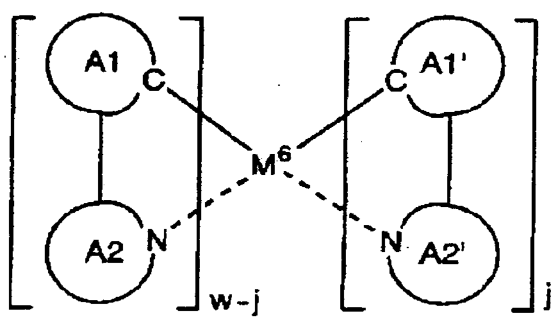

(IIIc)

(In the formula (IIIc), $M^6$ denotes the same metal as M, w denotes the valency of the metal, j is 0, 1, or 2, the rings A1 and A1' each independently denote an aromatic hydrocarbon group or a heteroaromatic ring group each optionally having a substituent, and the rings A2 and A2' each independently denote a nitrogen-containing heteroaromatic ring group each optionally having a substituent.)

In the formulae (IIIa), (IIIb), and (IIIc), preferred examples of the rings A1 and A1' include a phenyl group, a

biphenyl group, a naphthyl group, an anthryl group, a thienyl group, a furyl group, a benzothienyl group, a benzofuryl group, a pyridyl group, a quinolyl group, an isoquinolyl group, and a carbazolyl group.

In the formulae (IIIa) to (IIIc), preferred examples of the rings A2 and A2' include a pyridyl group, a pyrimidyl group, a pyrazyl group, a triazyl group, a benzothiazole group, a benzoxazole group, a benzoimidazole group, a quinolyl group, an isoquinolyl group, a quinoxalyl group, and a phenanthridyl group.

Examples of a substituent that the compounds having the formulae (IIIa) to (IIIc) may have include a halogen atom, alkyl groups, alkenyl groups, alkoxycarbonyl groups, alkoxy groups, aryloxy groups, dialkylamino groups, diarylamino groups, a carbazolyl group, an acyl group, haloalkyl groups, and a cyano group.

These substituents may be bound to each other to form a ring. As a specific example, a substituent of the ring A1 is bound to a substituent of the ring A2, or a substituent of the ring A1' is bound to a substituent of the ring A2', thus forming a fused ring. Such a fused ring may be a 7,8-benzoquinoline group.

Among others, examples of a substituent of the rings A1, A1', A2, and A2' more preferably include alkyl groups, alkoxy groups, aromatic hydrocarbon groups, a cyano group, a halogen atom, haloalkyl groups, diarylamino groups, and a carbazolyl group.

Preferred examples of $M^4$ to $M^6$ in the formulae (IIIa) to (IIIc) include ruthenium, rhodium, palladium, silver, rhenium, osmium, iridium, platinum, and gold.

Specific examples of the organic metal complexes having the formulae (III) and (IIIa) to (IIIc) include, but not limited to, the following compounds.

[Formula 62]

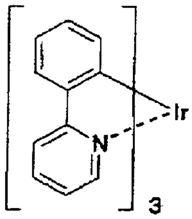
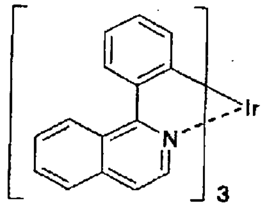
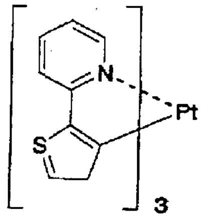
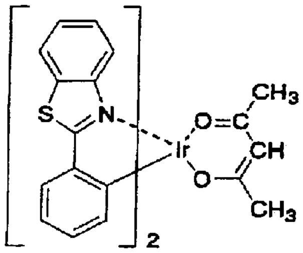
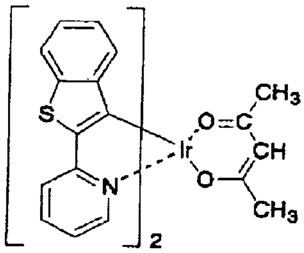
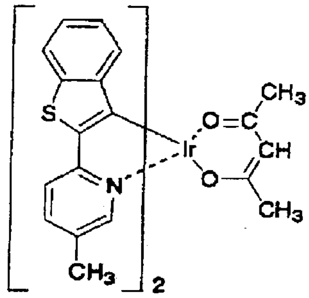
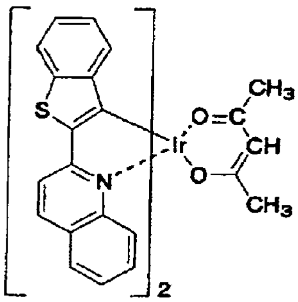
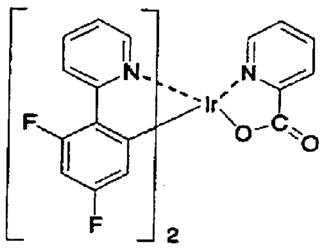
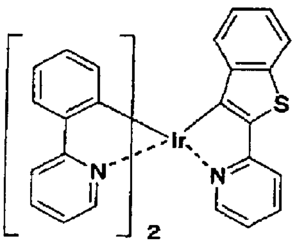
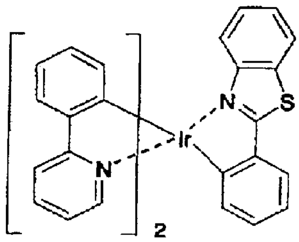
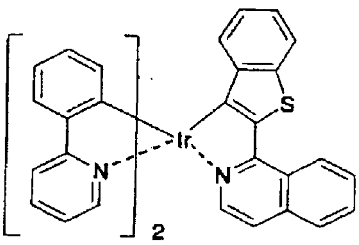
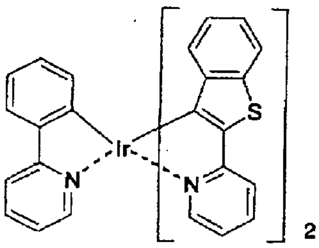
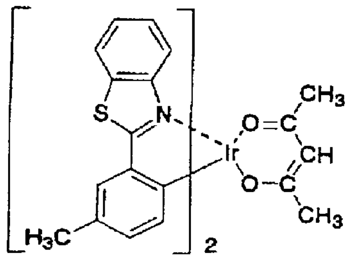
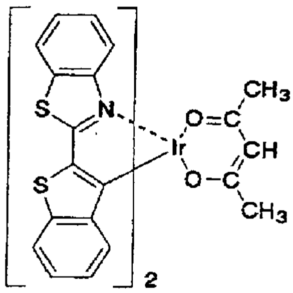

[Formula 63]

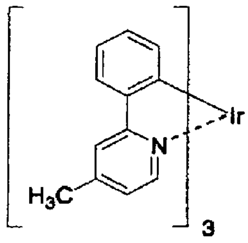
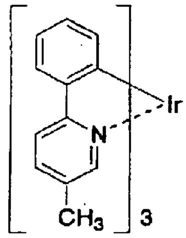
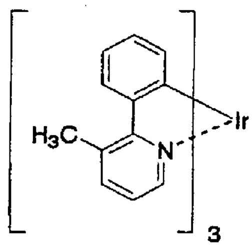
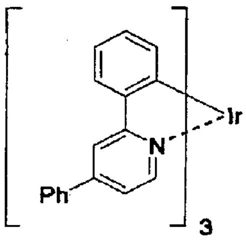
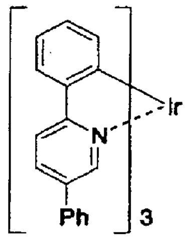
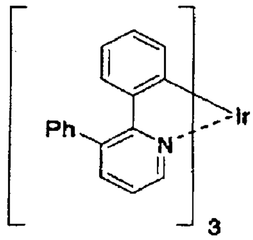
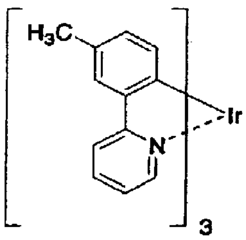
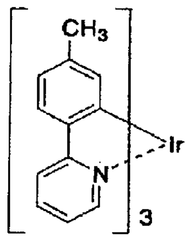
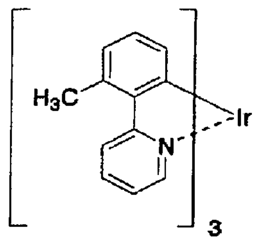
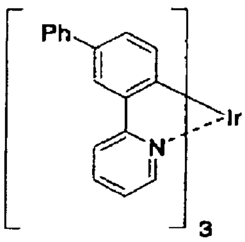
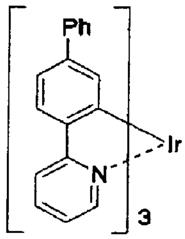
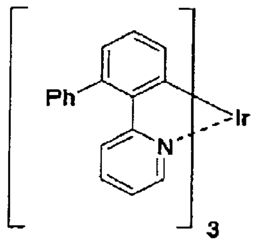
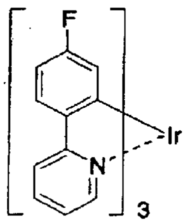
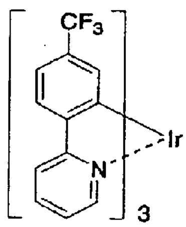
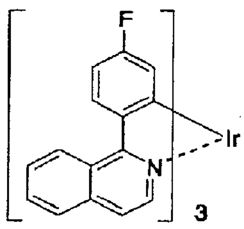

[Formula 64]

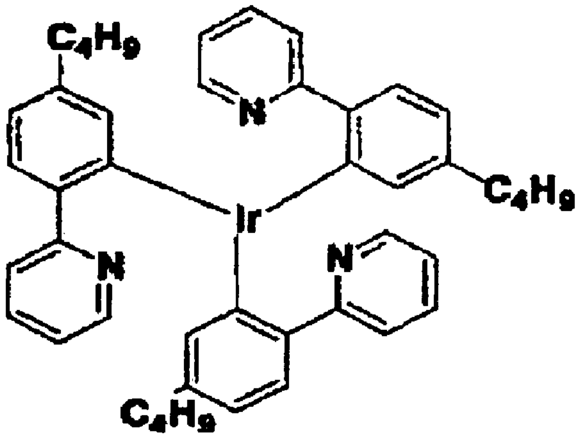

(C3)

Among the organic metal complexes having the formula (III), in particular, compounds that have, as ligands L and/or L', 2-aryl pyridine ligands, that is, 2-aryl pyridine, 2-aryl pyridine substituted with a substituent, and 2-aryl pyridine condensed with a group are preferred.

Compounds described in International Publication WO 2005/019373 can also be used as the luminescent material.

Compounds having the formula (IV) will be described below.

In the formula (IV), $M^7$ denotes a metal. Specific examples include the aforementioned metals selected from Groups 7 to 11 of the periodic table. Among others, ruthenium, rhodium, palladium, silver, rhenium, osmium, iridium, platinum, or gold is preferred. Bivalent metals, such as platinum and palladium, are particularly preferred.

In the formula (IV), $R^{92}$ and $R^{93}$ each independently denote a hydrogen atom, a halogen atom, an alkyl group, an aralkyl group, an alkenyl group, a cyano group, an amino group, an acyl group, an alkoxycarbonyl group, a carboxyl group, an alkoxy group, an alkylamino group, an aralkylamino group, a haloalkyl group, a hydroxyl group, an aryloxy group, an aromatic hydrocarbon group, or a heteroaromatic ring group.

When D is a carbon atom, $R^{94}$ and $R^{95}$ each independently denote the same substituent as exemplified for $R^{92}$ and $R^{93}$. When D is a nitrogen atom, there is no $R^{94}$ or $R^{95}$.

$R^{92}$ to $R^{95}$ may further have a substituent. The substituent may be of any type and may be any group.

At least two groups of $R^{92}$ to $R^{95}$ may be bound to each other to form a ring.

Specific examples (D-1 to D-7) of the organic metal complex having the formula (IV) include, but not limited to, the following complexes. In the following chemical formulae, Me denotes a methyl group, and Et denotes an ethyl group.

[Formula 65]

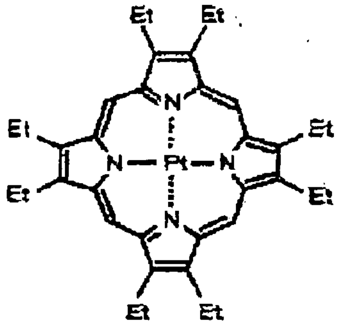

(D−1)

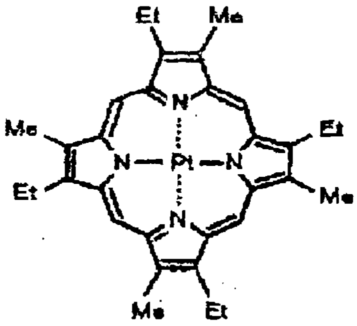

(D−2)

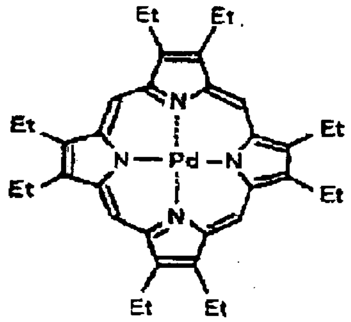

(D−3)

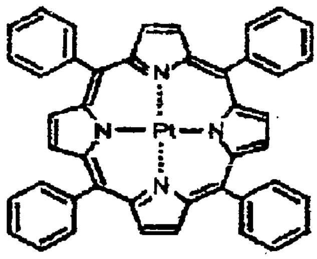

(D−4)

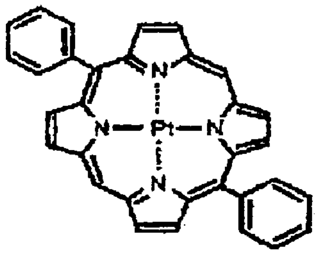

(D−5)

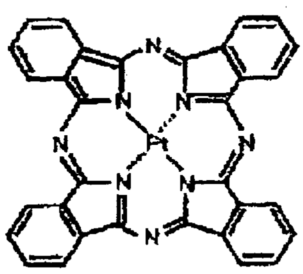

(D−6)

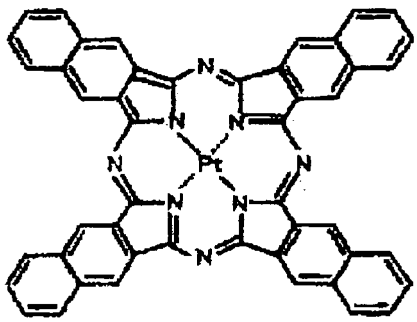

(D−7)

In the present invention, the molecular weight of a compound that is used as a luminescent material is typically 10000 or less, preferably 5000 or less, more preferably 4000 or less, still more preferably 3000 or less, and typically at least 100, preferably at least 200, more preferably at least 300, still more preferably at least 400. A molecular weight below 100 unfavorably results in very low heat resistance, gas generation, poor quality of the resulting film, or alteration in morphology of an organic electroluminescent element due to migration. A molecular weight above 10000 unfavorably results in difficult purification of an organic compound or a possibly long time required for dissolution in a solvent.

The light-emitting layer may contain any one of the various luminescent materials described above alone or at least two of the materials in any combination in any proportion.

Examples of a low-molecular-weight hole-transporting compound include various compounds exemplified as the hole-transporting compounds in the hole-transporting layer, aromatic diamines that contain at least two tertiary amines and in which nitrogen atoms are substituted with at least two fused aromatic rings, such as 4,4'-bis[N-(1-naphthyl)-N-phenylamino]biphenyl (Japanese Unexamined Patent Application Publication No. 5-234681), aromatic amine compounds having a starburst structure, such as 4,4',4''-tris((1-naphthyl)phenylamino)triphenylamine (Journal of Luminescence, 1997, Vol. 72-74, pp. 985), aromatic amine compounds composed of a triphenylamine tetramer (Chemical Communications, 1996, pp. 2175), and spirocompounds, such as 2,2',7,7'-tetrakis-(diphenylamino)-9,9'-spirobifluorene (Synthetic Metals, 1997, Vol. 91, pp. 209).

Examples of a low-molecular-weight electron-transporting compound include 2,5-bis(1-naphthyl)-1,3,4-oxadiazole (BND), 2,5-bis(6'-(2',2''-bipyridyl))-1,1-dimethyl-3,4-diphenylsilole (PyPySPyPy), bathophenanthroline (BPhen),

2,9-dimethyl-4,7-diphenyl-1,10-phenanthroline (BCP, bathocuproine), 2-(4-biphenylyl)-5-(p-tert-butylphenyl)-1,3,4-oxadiazole (tBu-PBD), and 4,4'-bit(9-carbazole)-biphenyl (CBP).

These hole-transporting compounds and electron-transporting compounds are preferably used as host materials in the light-emitting layer. More specifically, the following compounds can be used as host materials.

[Formula 66]

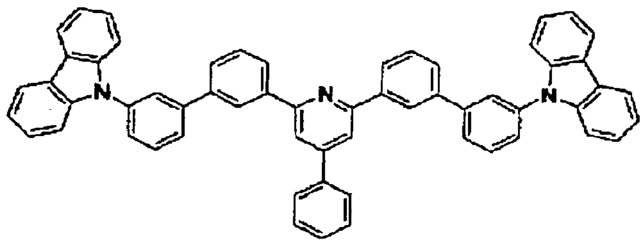

(C1)

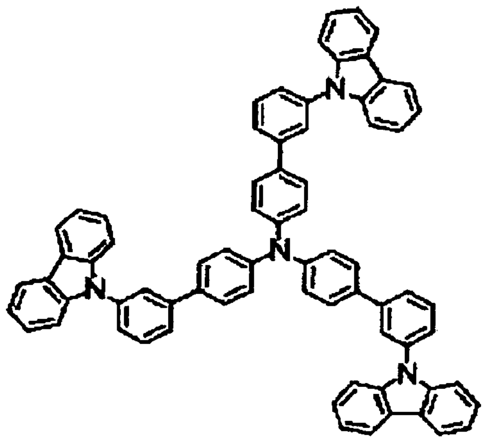

(C2)

A method for forming the organic light-emitting layer 5 may be a wet deposition method or a vacuum evaporation method. As described above, the wet deposition method is preferred because the wet deposition method can easily provide a uniform, defect-free thin film and requires only a short time to form the layer, and also because the wet deposition method can achieve the effect of insolubilization of the hole-transporting layer 4 using a composition for producing the at least one organic layer. In the wet deposition method, the organic light-emitting layer 5 is formed by dissolving the materials described above in an appropriate solvent to prepare a coating solution, applying the coating solution to the hole-transporting layer 4 formed as described above to form a film, and drying the film to remove the solvent. The forming method is the same as the forming method in the hole-transporting layer.

The thickness of the organic light-emitting layer 5 is typically at least 3 nm, preferably at least 5 nm, and typically 200 nm or less, preferably 100 nm or less.

[6] Hole-Blocking Layer

While the hole-blocking layer 6 is disposed between the organic light-emitting layer 5 and the electron-transporting layer 7 in Fig. 1, the hole-blocking layer 6 may be omitted.

The hole-blocking layer 6 is disposed on the organic light-emitting layer 5 such that the hole-blocking layer 6 is in contact with an interface of the organic light-emitting layer 5 adjacent to the cathode 9. The hole-blocking layer 6 is formed of a compound that can prevent positive holes moving from the anode 2 from reaching the cathode 9 and that can efficiently transport electrons injected from the cathode 9 toward the organic light-emitting layer 5.

Physical properties that are required for the materials of the hole-blocking layer 6 include high electron mobility and high hole mobility, a large energy gap (difference between HOMO and LUMO), and a high excited triplet level (T1).

Examples of the hole-blocking materials that satisfy these conditions include mixed ligand complexes, such as bis(2-methyl-8-quinolinolate),(phenolate)aluminum and bis (2-methyl-8-quinolinolate),(triphenylsilanolate)aluminum,

metal complexes, such as bis(2-methyl-8-quinolate)aluminum-μ-oxo-bis-(2-methyl-8-quinolilate)aluminum binuclear metal complexes, styryl compounds, such as distyrylbiphenyl derivatives (Japanese Unexamined Patent Application Publication No. 11-242996), triazole derivatives, such as 3-(4-biphenylyl)-4-phenyl-5(4-tert-butylphenyl)-1,2,4-triazole (Japanese Unexamined Patent Application Publication No. 7-41759), and phenanthroline derivatives, such as bathocuproine (Japanese Unexamined Patent Application Publication No. 10-79297). A compound having at least one pyridine ring substituted at positions 2, 4, and 6 described in International Publication WO 2005-022962 is also preferred as the hole-blocking material.

More specifically, the following compounds may be mentioned.

[Formula 67]

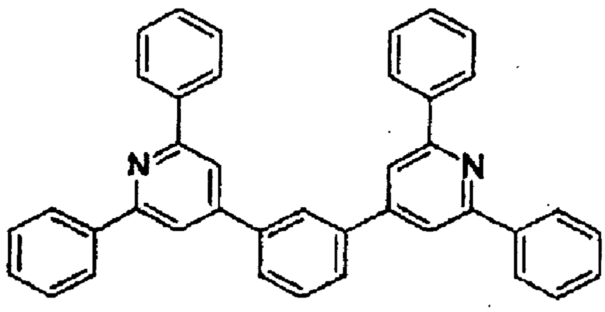

(C4)

In the same way as the hole-injection layer 3 and the organic light-emitting layer 5, the hole-blocking layer 6 may also be formed by a wet deposition method. However, the hole-blocking layer 6 is generally formed by a vacuum evaporation method. Detailed procedures of the vacuum evaporation method are the same as in the electron-injection layer 8 described later.

The thickness of the hole-blocking layer 6 is typically at least 0.5 nm, preferably at least 1 nm, and typically 100 nm or less, preferably 50 nm or less.

[7] Electron-Transporting Layer

The electron-transporting layer 7 is disposed between the light-emitting layer 5 and the electron-injection layer 8 to further improve the luminous efficacy of the element.

The electron-transporting layer 7 is formed of a compound that can efficiently transport electrons injected from the cathode 9 toward the light-emitting layer 5 between the electrodes to which an electric field is applied. An electron-transporting compound for use in the electron-transporting layer 7 should be a compound that has a high electron-injection efficiency from the cathode 9 or the electron-injection layer 8 and that has a high electron mobility to efficiently transport injected electrons.

Examples of the material that satisfies these conditions include metal complexes, such as an 8-hydroxyquinoline aluminum complex (Japanese Unexamined Patent Application Publication No. 59-194393), 10-hydroxybenzo[h]quinoline metal complexes, oxadiazole derivatives, distyrylbiphenyl derivatives, silole derivatives, 3- or 5-hydroxyflavone metal complexes, benzoxazole metal complexes, benzothiazole metal complexes, tris(benzimidazolyl)benzene (U.S. patent No. 5,645,948), quinoxaline compounds (Japanese Unexamined Patent Application Publication No. 6-207169), phenanthroline derivatives (Japanese Unexamined Patent Application Publication No. 5-331459), 2-t-butyl-9,10-N,N'-dicyanoanthraquinonediimine, n-type hydrogenated amorphous silicon carbide, n-type zinc sulfide, and n-type zinc selenide.

The electron-transporting layer 7 has a minimum thickness of typically 1 nm, preferably about 5 nm, and a maximum thickness of typically 300 nm, preferably about 100 nm.

The electron-transporting layer 7 may be formed on the hole-blocking layer 6 by a wet deposition method or a vacuum evaporation method in the same way as described above. In general, the vacuum evaporation method is used.

[8] Electron-Injection layer

The electron-injection layer 8 plays the role of efficiently injecting electrons injected from the cathode 9 into the electron-transporting layer 7 or the organic light-emitting layer 5.

To perform the electron injection efficiently, the material that forms the electron-injection layer 8 is preferably

a metal that has a low work function. Examples of the metal include alkali metals, such as sodium and cesium, and alkaline earth metals, such as barium and calcium. Preferably, the film thickness is typically at least 0.1 nm and 5 nm or less.

The after-mentioned organic electron-transporting materials, including nitrogen-containing heterocyclic compounds, such as bathophenanthroline, or metal complexes, such as 8-hydroxyquinoline aluminum complexes, are preferably doped with alkali metals, such as sodium, potassium, cesium, lithium, and rubidium (as described in, for example, Japanese Unexamined Patent Application Publications Nos. 10-270171, 2002-100478, and 2002-100482) to achieve improved electron injection and transport characteristics as well as high film quality. In this case, the film thickness is typically at least 5 nm, preferably at least 10 nm, and typically 200 nm or less, preferably 100 nm or less.

The electron-injection layer 8 is formed on the organic light-emitting layer 5 or the hole-blocking layer 6 disposed on the organic light-emitting layer 5 by a wet deposition method or a vacuum evaporation method.

Details of the wet deposition method are the same as in the hole-injection layer 3 and the organic light-emitting layer 5.

In the vacuum evaporation method, an evaporation source is charged into a crucible or a metal boat placed in a vacuum vessel, the vacuum vessel is evacuated to about $10^{-4}$ Pa with an appropriate vacuum pump, and then the crucible or metal boat is heated for evaporation, and thereby the electron-injection layer 8 is formed on the organic light-emitting layer 5, the hole-blocking layer 6, or the electron-transporting layer 7 on the substrate, which faces the crucible or the metal boat.

Vapor deposition of an alkali metal as an electron-injection layer is performed with an alkali metal dispenser in which nichrome is filled with an alkali metal chromate and a reducing agent. The dispenser is heated in a vacuum vessel to reduce the alkali metal chromate, evaporating the alkali metal. In co-evaporation of an organic electron-transporting material and an alkali metal, the organic electron-transporting material is charged into a crucible placed in a vacuum vessel, the vacuum vessel is evacuated to about $10^{-4}$ Pa with an appropriate vacuum pump, the crucible and the dispenser are simultaneously heated for evaporation, and thereby the electron-injection layer 8 is formed on a substrate, which faces the crucible and the dispenser.

While co-evaporation proceeds uniformly in the thickness direction of the electron-injection layer 8 in this case, concentration distribution may be present in the thickness direction.

[9] Cathode

The cathode 9 plays a role of injecting electrons into a layer (such as the electron-injection layer 8 or the organic light-emitting layer 5) adjacent to the organic light-emitting layer 5. The material for the cathode 9 may be the same as the material for the anode 2. To inject electrons efficiently, a low-work-function metal is preferred. An appropriate metal, such as tin, magnesium, indium, calcium, aluminum, or silver, or an alloy thereof is used. Specific examples include electrodes formed of low-work-function alloys, such as magnesium-silver alloys, magnesium-indium alloys, and aluminum-lithium alloys.

The cathode 9 generally has the same thickness as the anode 2.

To protect a cathode formed of the low-work-function metal, the cathode is preferably covered with a high-work-function metal layer that is stable in the air to improve the stability of the element. To this end, a metal, such as aluminum, silver, copper, nickel, chromium, gold, or platinum, is used.

[10] Others

While an organic electroluminescent element having the layer structure illustrated in Fig. 1 has been described, an organic electroluminescent element according to the present invention may have another structure. For example, any layer other than the layers described above may be disposed between the anode 2 and the cathode 9 provided that the performance does not deteriorate. Alternatively, any layer may be omitted.

In the present invention, use of a composition for producing the at least one organic layer in the hole-transporting layer 4 allows the lamination of all the hole-injection layer 3, the hole-transporting layer 4, and the organic light-emitting layer 5 by a wet deposition method. This allows the manufacture of large area displays.

The inverted structure of the structure illustrated in Fig. 1 is also possible. That is, a cathode, an electron-injection layer, an electron-transporting layer, a hole-blocking layer, a light-emitting layer, a hole-transporting layer, a hole-injection layer, and an anode may be disposed on the substrate 1 in this order. As described above, an organic electroluminescent element according to the present invention may be disposed between two substrates at least one of which is highly transparent.

The layer structure illustrated in Fig. 1 may be stacked one after another (structure in which a plurality of light-emitting units are stacked). In this case, an interface layer (when the anode is ITO and the cathode is Al, these two layers) between the layer structures (between the light-emitting units) may be replaced with, for example, $V_2O_5$ acting as a charge-generating layer (CGL) to lower the barrier between the layer structures. This is more preferred in terms of

the luminous efficiency and driving voltage.

The present invention can be applied to any of an element composed of a single organic electroluminescent element, an element composed of an array of organic electroluminescent elements, and a structure in which an anode and a cathode are arranged in an X-Y matrix.

EXAMPLES

The present invention will be more specifically described in the following examples. However, the present invention is not limited to the description of these examples.

[Synthesis Example]

The following are Synthesis Examples of cross-linking compounds.

(SYNTHESIS EXAMPLE 1)

Synthesis of Target Compound 1

[Formula 68]

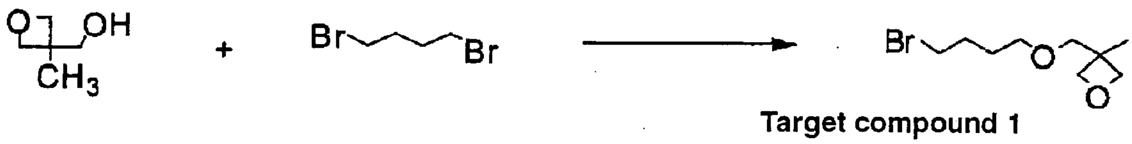

Target compound 1

A mixed solution of 50% by weight aqueous NaOH solution (300 g) and hexane (250 mL) was charged into a four-neck flask equipped with a DC stirrer, a dropping funnel, and a condenser tube. Tetra-n-butylammonium bromide (TBABr) (4.98 g, 15.5 mmol) was added to the mixed solution. After cooling the mixture to 5°C, a mixture of oxetane (31 g) and dibromobutane (200 g) was added dropwise with vigorous stirring. After the dropwise addition, the resulting product was stirred at room temperature for 15 minutes, was stirred under reflux for another 15 minutes, and was stirred for 15 minutes while being cooled to room temperature. An organic layer was isolated, was washed with water, and was dried over magnesium sulfate. After the solvent was removed under reduced pressure, distillation under reduced pressure (0.42 mmHg, 72°C) yielded a target compound 1 (52.2 g).

Synthesis of Target Compound 2

[Formula 69]

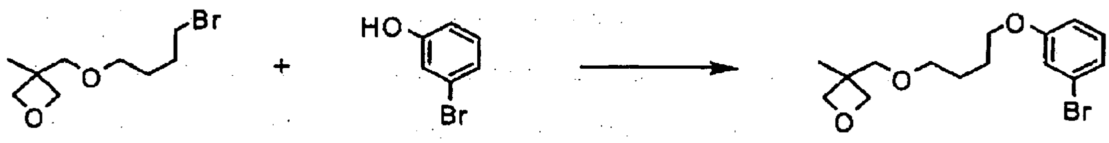

Target compound 1 Target compound 2

In a nitrogen stream, pulverized potassium hydroxide (8.98 g) and m-bromophenol (6.92 g) were added to a dimethyl sulfoxide (50 ml) solution. After stirring the solution for 30 minutes, the target compound 1 (12.33 g) was added to the solution. The solution was stirred at room temperature for six hours. After a precipitate was filtered off, an oil phase was extracted with methylene chloride and concentrated. The oil phase was subjected to column purification using hexane:methylene chloride = 2:1 to yield a target compound 2 (11.4 g).

Synthesis of Target Compound 3

[Formula 70]

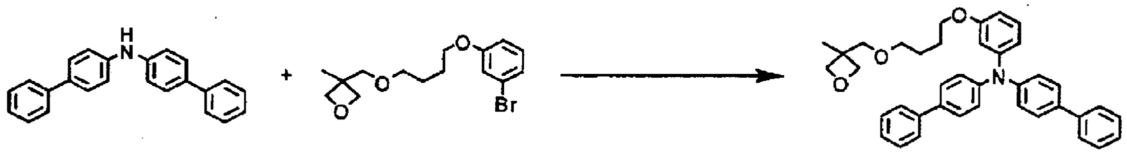

Target compound 2

Target compound 3

In a nitrogen stream, a solution prepared by stirring tris(dibenzylideneacetone)dipalladium (0) chloroform complex (0.063 g), tri-tert-butylphosphine (0.098 g), and toluene (10 ml) at 60°C for 15 minutes in a nitrogen atmosphere was added to a solution of N,N'-bis(4-biphenyl)amine (4.69 g), a target compound 2 (4.00 g), sodium tert-butoxide (1.63 g), and toluene (90 ml). The resulting product was stirred at 85°C for four hours. After cooling the product, toluene and activated clay were added to the product. After stirring the product at room temperature for 15 minutes, insoluble matter was filtered off. The filtrate was concentrated, was purified by silica gel column chromatography (methylene chloride solvent), and was treated with activated clay in a toluene solvent, thus yielding a target compound 3 (2.61 g).

The target compound 3 was identified by DEI-MS (m/z = 569 ($M^+$)).

(SYNTHESIS EXAMPLE 2)

Synthesis of Target Compound 4

[Formula 71]

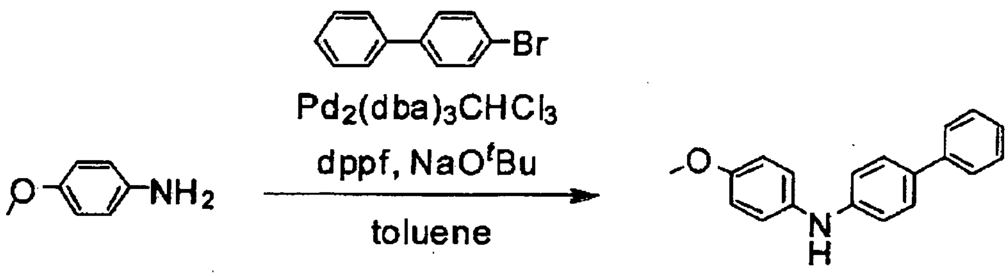


Target compound 4

In a nitrogen stream, a solution prepared by stirring tris(dibenzylideneacetone)dipalladium (0) chloroform complex (0.104 g), bis(triphenylphosphino)ferrocene (0.222 g), and toluene (5 ml) at 60°C for 15 minutes in a nitrogen atmosphere was added to a solution of p-anisidine (5.42 g), 4-bromobiphenyl (9.32 g), sodium tert-butoxide (5.38 g), and toluene (80 ml). The resulting product was stirred under reflux for 10 hours. After cooling the product, activated clay and toluene (100 ml) were added to the product. The product was stirred under reflux for 15 minutes. After cooling the product, insoluble matter was filtered off. Activated clay was added to the filtrate. The filtrate was stirred under reflux for 15 minutes. After cooling the filtrate, insoluble matter was filtered off, and the filtrate was concentrated. The resulting precipitate was subjected to recrystallization in toluene to yield a target compound 1 (6.59 g).

Synthesis of Target Compound 5

[Formula 72]

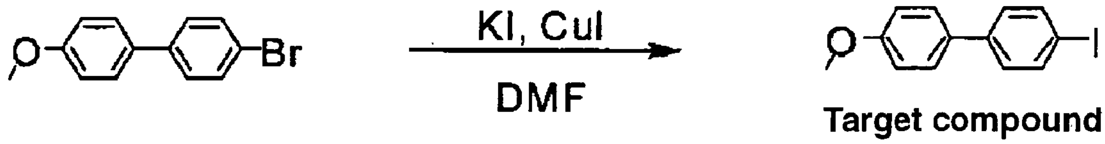


Target compound 5

In a nitrogen stream, 4-bromo-4'-methoxybiphenyl (10.0 g), potassium iodide (63.1 g), copper (I) iodide (36.2 g), and dimethylformamide (DMF) (64 ml) were stirred under reflux for eight hours. The reaction mixture was added to 0.1 N hydrochloric acid (360 ml) and stirred. A precipitate was filtered off and washed with ethanol. Chloroform (150 ml) was added to the resulting solid. The resulting product was stirred under reflux for one hour to dissolve a soluble component. A solution component was filtered and concentrated. The resulting solid was purified by recrystallization in methanol to yield a target compound 5 (9.56 g).

Synthesis of Target Compound 6

[Formula 73]

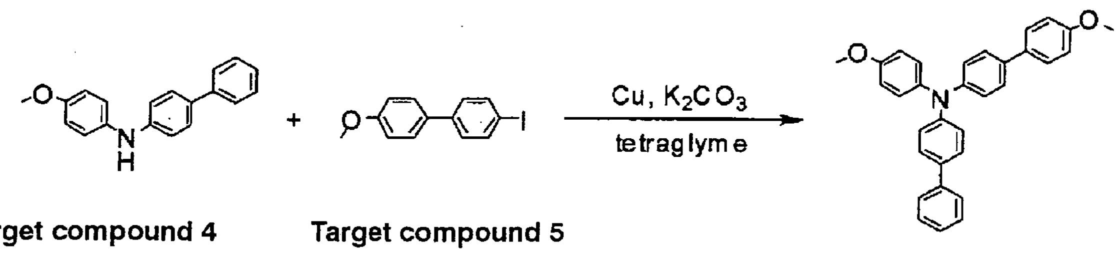


Target compound 4 Target compound 5

Target compound 6

In a nitrogen stream, the target compound 4 (5.78 g), the target compound 5 (7.16 g), copper (1.87 g), potassium carbonate (5.80 g), and tetraglyme (15 ml) were stirred at 200°C for 10 hours. After cooling the resulting product, chloroform (200 ml) was added to the product. After stirring the product, insoluble matter was filtered off, and the filtrate was concentrated. The resulting solid was washed in suspension with ethanol to yield a target compound 6 (7.10 g).

Synthesis of Target Compound 7

[Formula 74]

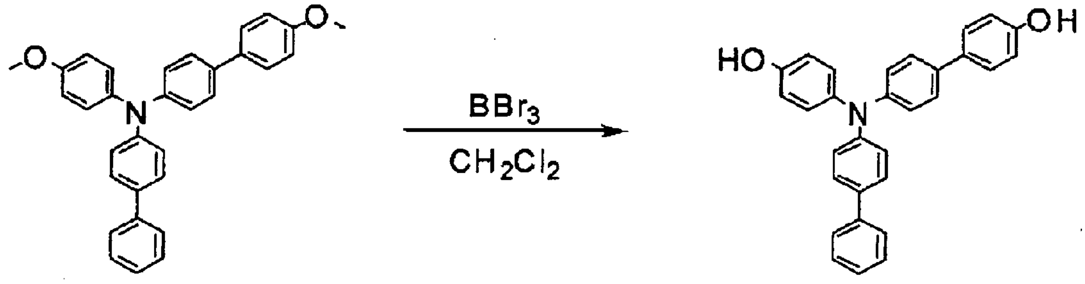


Target compound 6 Target compound 7

In a nitrogen stream, the target compound 6 (6.86 g) and dichloromethane (100 ml) were cooled to 0°C. One mole methylene chloride solution of boron tribromide (35 ml) was added dropwise to the resulting product. The product was heated to room temperature and stirred for two hours. After aqueous sodium hydrogen carbonate was added to the product, an organic layer was extracted with ethyl acetate, was concentrated, and was purified by silica gel column chromatography (hexane/ethyl acetate = 1/1) to yield a target compound 7 (3.68 g).

The target compound 7 was identified by EI-MS (m/z = 429 ($M^+$)).

[Formula 75]

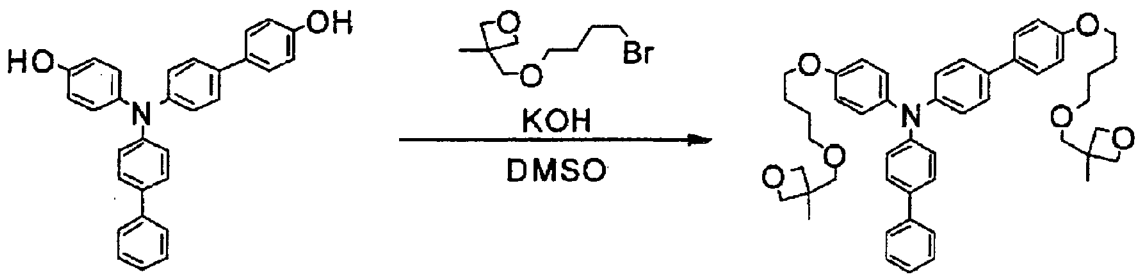


Target compound 7 Target compound 8

In a nitrogen stream, potassium hydroxide (3.25 g) and dimethyl sulfoxide (100 ml) were stirred at room temperature for 15 minutes. The target compound 7 (5.00 g) was added to the resulting product. The product was stirred at room temperature for 15 minutes. 3-(4-bromobutoxymethyl)-3-methyloxetane (6.90 g) was added to the product. The product was stirred at room temperature for eight hours. Methylene chloride (200 ml) and water (200 ml) were added to the product. After stirring the product, an organic layer was dried over magnesium sulfate, was concentrated, and was purified by silica gel chromatography (a liquid mixture of hexane/ethyl acetate), yielding a target compound 8 (4.2 g).

The target compound 8 was identified by DEI-MS (m/z = 741 ($M^+$)).

(SYNTHESIS EXAMPLE 3)

Synthesis of Target Compound 9

[Formula 76]

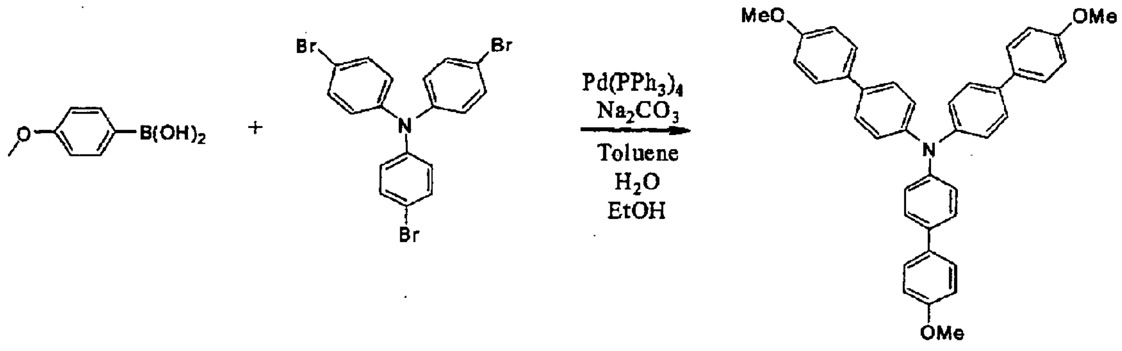


(Target compound 9)

In a nitrogen stream, p-methoxyphenylboronic acid (20.51 g), tris(4-bromophenyl)amine (14.46 g), sodium carbonate (28.62 g), toluene (200 ml), ethanol (50 ml), and desalted water (100 ml) was charged into a system. The system was purged with nitrogen by nitrogen bubbling. After 3.12 g of tetrakis(triphenylphosphine)palladium was added, the system was stirred in an oil bath at 80°C for 5.5 hours in a nitrogen stream. After cooling the system, the resulting precipitate was filtered off and washed in suspension with water and methanol to remove an inorganic substance, yielding a target compound 9 (14.12 g) as white crystals.

Synthesis of Target Compound 10

[Formula 77]

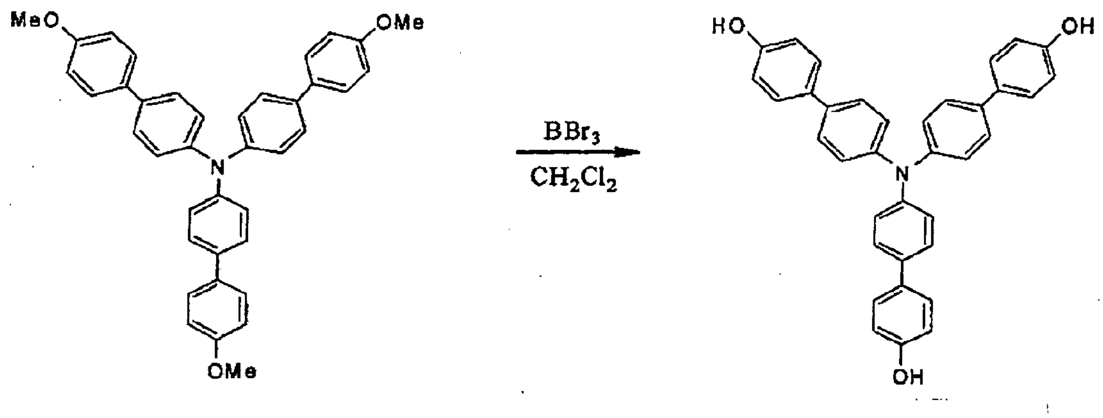


(Target compound 10)

In a nitrogen stream, a mixture of the target compound 9 (13.53 g) and methylene chloride (200 ml) was stirred and cooled to 0°C in an ice bath. Boron tribromide (100 ml of 1 mol/l dichloromethane solution) was added dropwise to the mixture. After the dropwise addition, the mixture was stirred at room temperature overnight to allow the reaction to proceed. The resulting product was poured into 100 ml of ice water in a beaker. A precipitate was filtered off. The resulting solid was purified by silica gel column chromatography (hexane:ethyl acetate) and was subjected to reprecipitation in ethyl acetate and hexane to yield a target compound 10 (9.6 g).

Synthesis of Target Compound 11

[Formula 78]

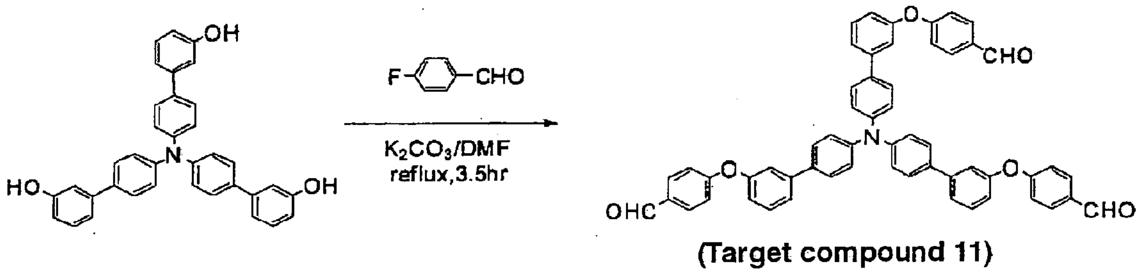


(Target compound 11)

In a nitrogen stream, the target compound 10 (5.0 g), p-fluorobenzaldehyde (3.69 g), potassium carbonate (3.98 g), and N,N-dimethylformamide (50 ml) was heated under reflux for 3.5 hours and then cooled to room temperature. Twenty percent by weight aqueous methanol was added to the reaction mixture. Insoluble matter was filtered off. The resulting crude crystals were washed in suspension with 80% by weight aqueous methanol to yield a target compound 11 (7.53 g).

Synthesis of Target Compound 12

[Formula 79]

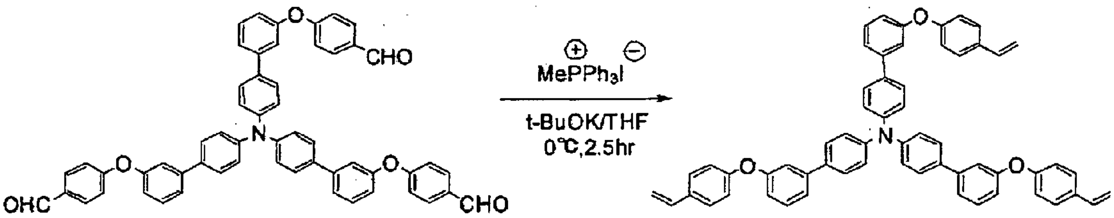


(Target compound 12)

In a nitrogen stream, potassium tert-butoxide (3.53 g) was slowly added to the target compound 11 (8.45 g), methyltriphenylphosphine iodide (12.7 g), and dehydrated tetrahydrofuran (170 ml) under ice-cold conditions. After stirring the resulting product at that temperature for 2.5 hours, water was added to the reaction mixture. The reaction mixture was subjected to extraction with ethyl acetate. An organic layer was washed with water, was concentrated, was purified by silica gel column chromatography (hexane/ethyl acetate, and then toluene), and was washed with methanol, yielding a target compound 12 (3.09 g).
The target compound 12 was identified by DEI-MS (m/z = 828 ($M^+$)).

(SYNTHESIS EXAMPLE 4)

Synthesis of Target Compound 13

[Formula 80]

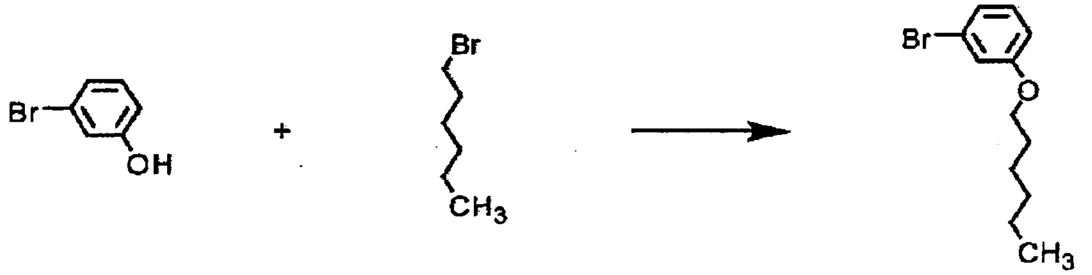

(Target compound 13)

In a nitrogen stream, 1-bromohexane (28.1 ml) and then 3-bromophenol (36.3 g) were added to a mixed solution of potassium hydroxide (49.4 g) and dimethyl sulfoxide (220 ml). The resulting product was stirred at room temperature for eight hours. 350 ml of water was added to the reaction solution. The resulting solution was subjected to extraction with methylene chloride (450 ml). The extract was washed twice with saline, was dried over anhydrous magnesium sulfate, and was concentrated. Purification by silica gel column chromatography (hexane) yielded a target compound 13 (44.3 g) as colorless liquid.

Synthesis of Target Compound 14

[Formula 81]

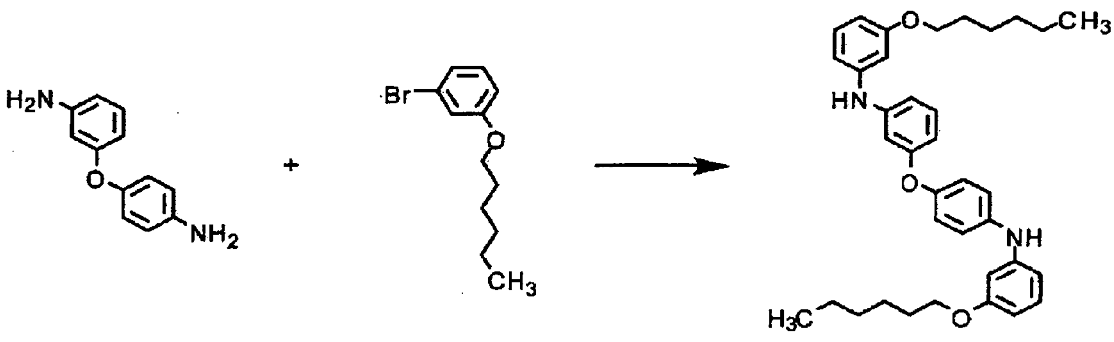

(Target compound 13) (Target compound 14)

In a nitrogen stream, 3,4'-diaminodiphenyl ether (13.02 g), the target compound 13 (33.10 g), and sodium tert-butoxide (14.99 g) were sequentially added to a solution prepared by stirring a tris(dibenzylideneacetone)dipalladium (0) chloroform complex (0.673 g), bis(triphenylphosphino)ferrocene (0.708 g), and toluene (455 ml) at room temperature for 10 minutes. The resulting product was stirred in an oil bath at 90°C for six hours. After cooling the product, one liter of ethyl acetate and 500 ml of saline were added to the product. After shaking the product, an organic layer was dried over anhydrous magnesium sulfate, was concentrated, and was purified by silica gel column chromatography (a liquid mixture of hexane/methylene chloride) and recrystallization in methylene chloride/methanol to yield a target compound 14 as white crystals (21.44 g).

Synthesis of Target Compound 15

[Formula 82]

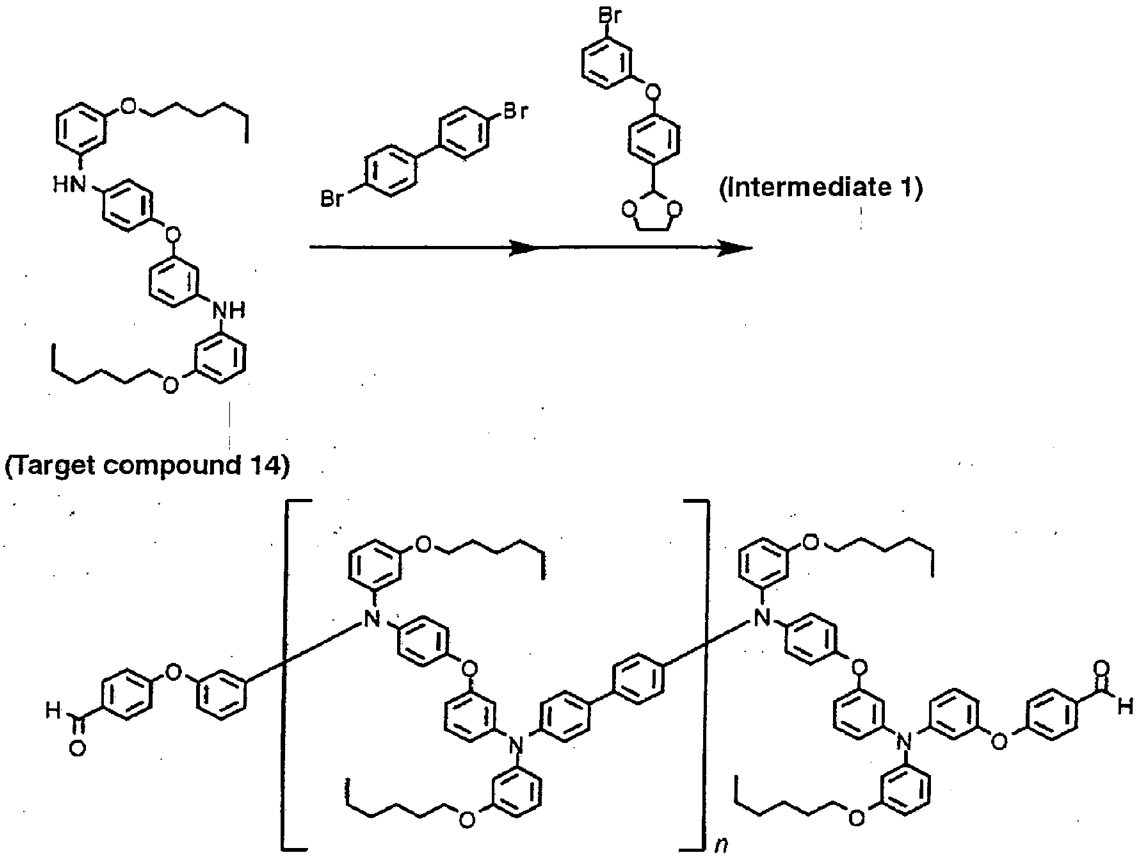


(Target compound 14)

(Target compound 15)

A solution prepared by stirring a tris(dibenzylideneacetone)dipalladium (0) chloroform complex (0.046 g), bis(triphenylphosphino)ferrocene (0.048 g), and toluene (10 ml) at room temperature for 30 minutes in a nitrogen atmosphere was charged into a mixed solution of the target compound 14 (3.663 g), 4,4'-dibromobiphenyl (1.378 g), and sodium tert-butoxide (1.02 g). The resulting product was stirred under reflux for 4.5 hours. An intermediate 1 (0.922 g) and sodium tert-butoxide (1.02 g) were added to the product. After four hours, a solution prepared by stirring tris(dibenzylideneacetone)dipalladium (0) chloroform complex (0.065 g), bis(triphenylphosphino)ferrocene (0.072 g), and toluene (7 ml) at room temperature for 15 minutes in a nitrogen atmosphere was added to the product. After stirring the product for one hour, the intermediate 1 (3 g) was added to the product. After stirring the product for 1.5 hours, a solution prepared by stirring tris(dibenzylideneacetone)dipalladium (0) chloroform complex (0.100 g), bis(triphenylphosphino)ferrocene (0.115 g), and toluene (8 ml) at 50°C for 15 minutes in a nitrogen atmosphere was added to the product. The product was stirred for 1.5 hours. After cooling the product, activated clay was added to the product with sufficient stirring. After filtration, the filtrate was washed with 2 N aqueous hydrochloric acid and then with saline, was dried over anhydrous magnesium sulfate, and was concentrated. The resulting product was purified by silica gel column chromatography (methylene chloride/hexane and methylene chloride/ethyl acetate) and was dissolved in toluene. Activated clay was added to the toluene solution. The toluene solution was stirred sufficiently and then filtered. The filtrate was concentrated and was dried by heating under reduced pressure to yield a target compound 15 (4.44 g).

Synthesis of Target Compound 16

[Formula 83]

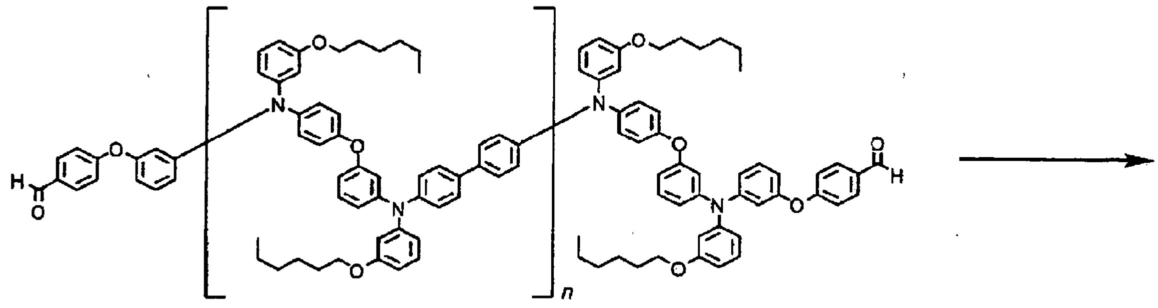

(Target compound 15)

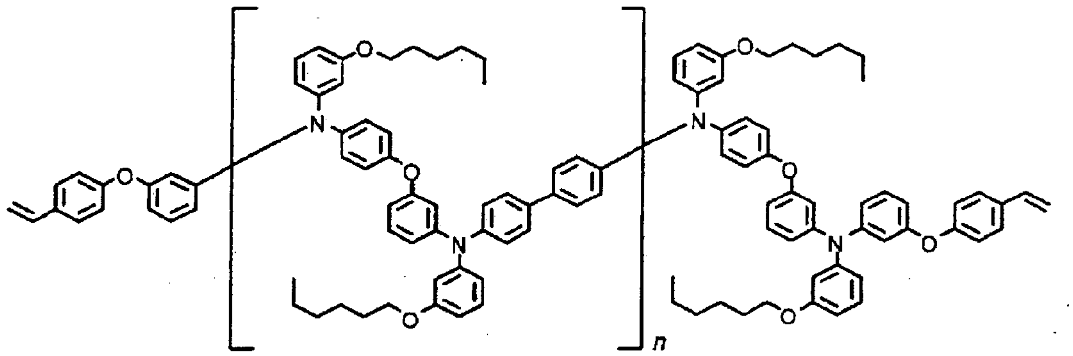

(Target compound 16)

In a nitrogen stream, a tetrahydrofuran solution (10 ml) of potassium tert-butoxide (0.668 g) was added dropwise to a solution of methyltriphenylphosphonium iodide (2.292 g) and tetrahydrofuran (10 ml) under ice-cold conditions for 10 minutes. The resulting product was stirred for 15 minutes and then added to a tetrahydrofuran solution (20 ml) of the target compound 15 (4.44 g) under ice-cold conditions. The resulting product was stirred for one hour and then stirred at room temperature for another one hour. Ice water and sodium chloride were added to the resulting solution. The solution was subjected to extraction with methylene chloride. The extract was dried over anhydrous magnesium sulfate, was concentrated, was purified by silica gel column chromatography (methylene chloride/hexane), and was dissolved in toluene. Activated clay was added to the resulting solution with sufficient stirring. After insoluble matter was removed, the solution was concentrated. The concentrate was again purified by silica gel column chromatography (methylene chloride/hexane). The resulting solid was heat-dried at 70°C under reduced pressure to yield a target compound 16 (1.40 g) (n = 0 to 4).

(SYNTHESIS EXAMPLE 5)

Synthesis of Target Compound 17

[Formula 84]

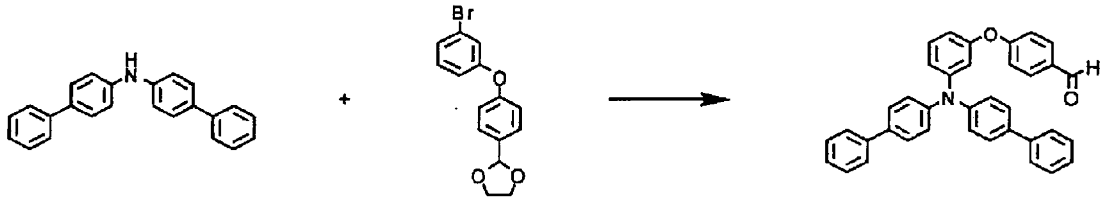

(Intermediate 1) (Target compound 17)

In a nitrogen stream, a solution prepared by stirring tris(dibenzylideneacetone)dipalladium (0) chloroform complex (0.078 g), tri-tert-butylphosphine (0.121 g), and toluene (10 ml) at 60°C for 15 minutes in a nitrogen atmosphere was added to a solution of N,N'-bis(4-biphenyl)amine (4.82 g), the intermediate 1 (5.06 g), sodium tert-butoxide (2.02 g), and toluene (90 ml). The resulting product was stirred at 85°C for four hours. After cooling the product, toluene and activated clay was added to the product. After stirring the product at room temperature for 15 minutes, insoluble matter was filtered off. The filtrate was concentrated, was purified by silica gel column chromatography (a methylene chloride solvent), and was dissolved in methylene chloride (200 ml). The resulting solution was washed with 1 N aqueous hydrochloric acid and then with saline and was dried over anhydrous magnesium sulfate. The resulting solution was concentrated to 50 ml. The concentrate was subjected to reprecipitation in methanol to yield a target compound 17 (6.50 g).

Synthesis of Target Compound 18

[Formula 85]

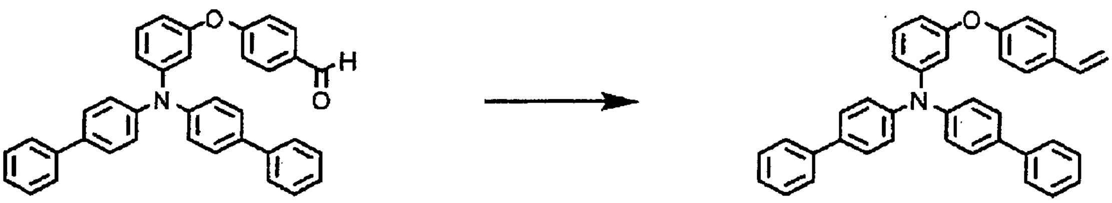

(Target compound 17) (Target compound 18)

In a nitrogen stream, a dehydrated tetrahydrofuran solution (20 ml) of potassium tert-butoxide (1.19 g) was slowly added to the target compound 17 (5.00 g), methyltriphenylphosphine iodide (4.23 g), and dehydrated tetrahydrofuran (80 ml) under ice-cold conditions. After stirring the reaction mixture at that temperature for 50 minutes, water and toluene were added to the reaction mixture with stirring. After an organic layer was washed with saline, magnesium sulfate and activated clay were added to the organic layer. After stirring the organic layer, insoluble matter was filtered off. The filtrate was concentrated, was purified by silica gel column chromatography (hexane/toluene), and was subjected to reprecipitation in methylene chloride/methanol and recrystallization in ethyl acetate/ethanol to yield a target compound 18 (2.83 g).

The target compound 18 was identified by DEI-MS (m/z = 515 ($M^+$)).

(SYNTHESIS EXAMPLE 6)

Synthesis of Target Compound 19

[Formula 86]

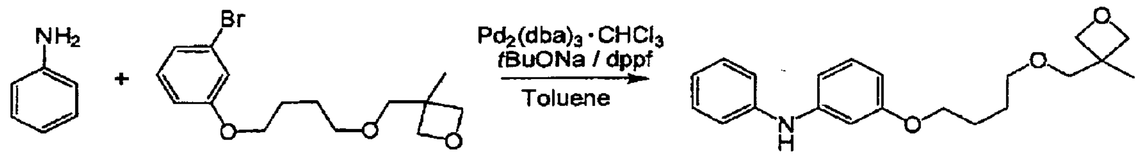


(Target compound 2) (Target compound 19)

A tris(dibenzylideneacetone)dipalladium (0) chloroform complex (0.185 g), bis(triphenylphosphino)ferrocene (0.198 g), and toluene (200 ml) were stirred at room temperature for 10 minutes in a nitrogen atmosphere. Aniline (7.15 g), the target compound 2 (8.425 g), and sodium tert-butoxide (2.951 g) were added to the resulting product. The product was stirred at 100°C for nine hours. The product was cooled and then subjected to suction filtration. The filtrate was concentrated. The residue was refined by silica gel column chromatography (hexane/methylene chloride = 1/10 to methylene chloride/ethyl acetate = 10/1) to yield a target compound 19 (8.28 g).

Synthesis of Target Compound 20

[Formula 87]

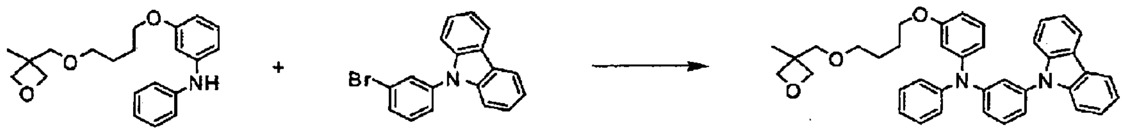

(Target compound 19) (Target compound 20)

In a nitrogen stream, a solution prepared by stirring a tris(dibenzylideneacetone)dipalladium (0) chloroform complex (0.10 g), tri-tert-butylphosphine (0.11 g), and toluene (7 ml) at 50°C for 15 minutes in a nitrogen atmosphere was added to a solution of the target compound 19 (2.67 g), N-(3-bromophenyl)carbazole (3.28 g), sodium tert-butoxide (0.82 g), and toluene (50 ml). The resulting product was stirred at 100°C for two hours. The reaction solution was cooled and then washed with water. An oil layer was dried over sodium sulfate and concentrated. The resulting oily component was purified by silica gel column chromatography (methylene chloride:ethyl acetate = 20:1) and concentrated. Toluene and activated clay were added to the resulting product. After stirring the product for 30 minutes, insoluble matter was filtered off. The filtrate was concentrated to yield a target compound 20 (4.04 g).

The target compound 20 had a glass transition temperature of 35.7°C and a starting temperature of weight loss of 452°C in a nitrogen stream.

The target compound 20 was identified by DEI-MS (m/z = 722 ($M^+$)).

(SYNTHESIS EXAMPLE 7)

Synthesis of Target Compound 21

[Formula 88]

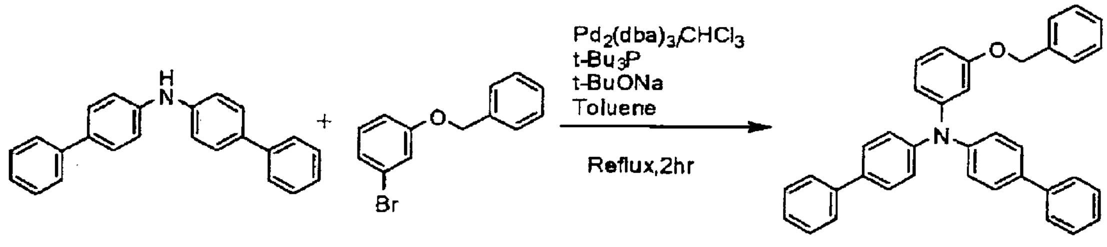


(Target compound 21)

N,N'-bis(4-biphenyl)amine (16.5 g), 1-benzyloxy-3-bromobenzene (14.86 g), sodium t-butoxide (10.85 g), and toluene (220 ml) were charged into a reactor. The reactor was purged with nitrogen and heated to 60°C (solution A). Tri-t-butylphosphine (1.25 g) was added to 20 ml of toluene solution of a tris(dibenzylideneacetone)dipalladium chloroform complex (1.06 g). The solution was heated to 60°C (solution B). In a nitrogen stream, the solution B was added to the solution A. The mixed solution was heated under reflux for 3.5 hours. After the mixed solution was cooled to room temperature, insoluble matter was filtered off, and the filtrate was concentrated. The resulting crude product was washed twice in suspension with a hexane/methylene chloride (1/1) solution and then with methanol to yield a target compound 21 (18.4 g).

Synthesis of Target Compound 22

[Formula 89]

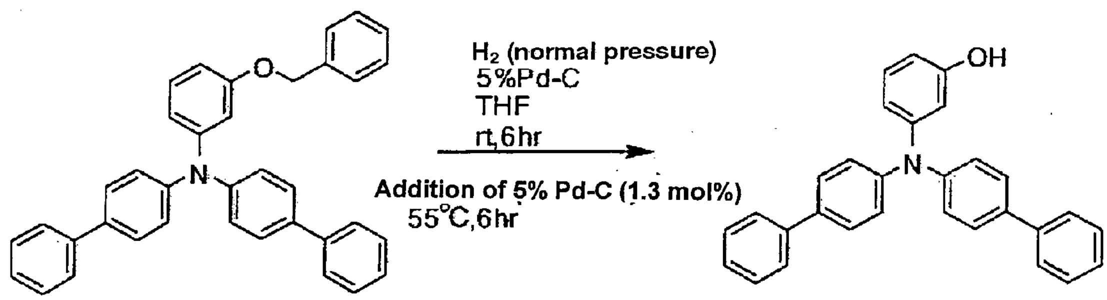


(Target compound 21) (Target compound 22)

The target compound 21 (18 g) was dissolved in tetrahydrofuran (120 ml). Five percent Pd/C (2.52 g) was added to the resulting product. After hydrogen purge, the reduction reaction was performed at 55°C for six hours. After the completion of the reaction, the system was purged with nitrogen, the catalyst was filtered off, and the filtrate was concentrated. Purification by silica gel column chromatography (hexane/methylene chloride) yielded a target compound 22 (14.33 g).

Synthesis of Target Compound 23

[Formula 90]

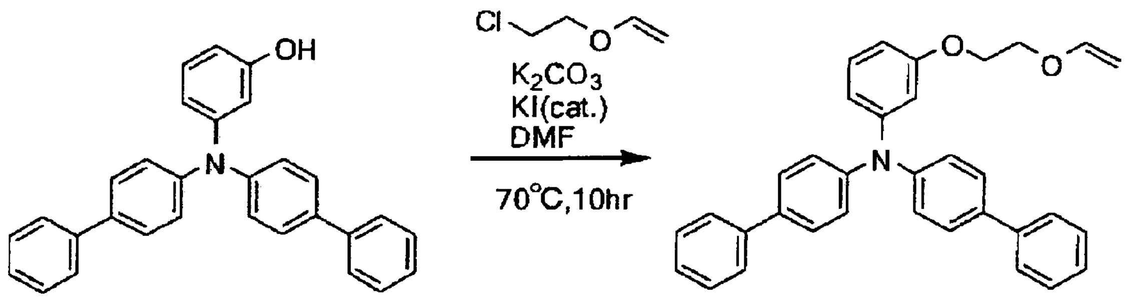


(Target compound 22) (Target compound 23)

The target compound 22 (3.06 g), 2-chloroethyl vinyl ether (0.9 g), potassium carbonate (2.05 g), and N,N-dimethylformamide (30 ml) were charged into a reactor. A small amount of potassium iodide was charged into the reactor. The mixture was allowed to react at 70°C for 10 hours. After cooling the reaction solution, water was added to the reaction solution. The reaction solution was subjected to extraction with ethyl acetate. The resulting organic layer was washed twice with water and then with saturated saline. Sodium sulfate was added to the organic layer for dehydration. The organic layer was then concentrated. A crude product was purified by silica gel column chromatography (hexane/methylene chloride) to yield a target compound 23 (1.46 g).

The target compound 23 was identified by DEI-MS (m/z = 483 ($M^+$)).

(SYNTHESIS EXAMPLE 8)

Synthesis of Target Compound 24

[Formula 91]

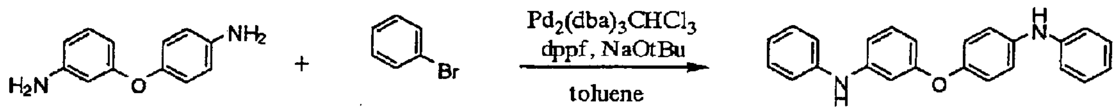


(Target compound 24)

3,4'-diphenylamino ether (24.03 g), bromobenzene (37.68 g), sodium tert-butoxide (25.37 g), and toluene (190 ml) were charged into a reactor. The reactor was sufficiently purged with nitrogen and heated to 50°C (solution A). Bis(triphenylphosphino)ferrocene (1.35 g) was added to 10 ml of toluene solution of a tris(dibenzylideneacetone)dipalladium chloroform complex (0.62 g). The solution was heated to 50°C (solution B). In a nitrogen stream, the solution B was added to the solution A. The mixed solution was heated to react at 100°C for 6.5 hours and was then cooled and subjected to suction filtration. The filtrate was concentrated. Purification by silica gel column chromatography (hexane/methylene chloride = 1:1) yielded a compound 24 (23.60 g).

Synthesis of Target Compound 25

[Formula 92]

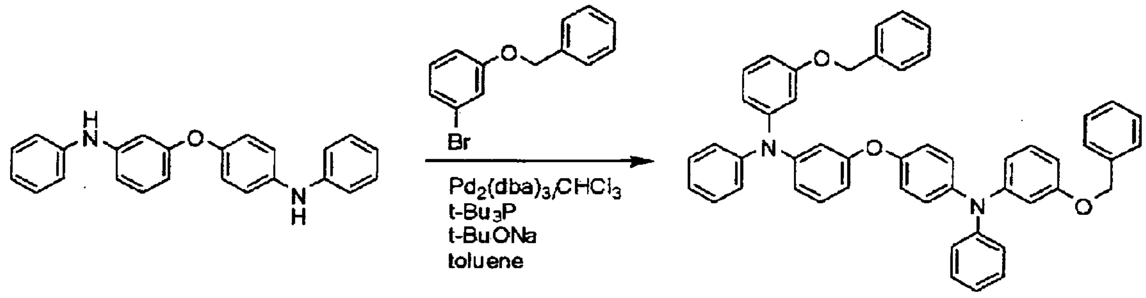


Target compound 24 Target compound 25

The target compound 24 (7.8 g), 1-benzyloxy-3-bromobenzene (12.88 g), sodium t-butoxide (9.36 g), and toluene (190 ml) were charged into a reactor. The reactor was sufficiently purged with nitrogen and heated to 60°C (solution A). Tri-t-butylphosphine (1.1 g) was added to 15 ml of toluene solution of a tris(dibenzylideneacetone)dipalladium chloroform complex (0.92 g). The solution was heated to 60°C (solution B). In a nitrogen stream, the solution B was added to the solution A. The mixed solution was heated under reflux for 5 hours. After the mixed solution was cooled to room temperature, insoluble matter was filtered off. The filtrate was concentrated. The resulting crude product was purified by silica gel column chromatography (hexane/methylene chloride) to yield a target compound 25 (14.8 g).

Synthesis of Target Compound 26

[Formula 93]

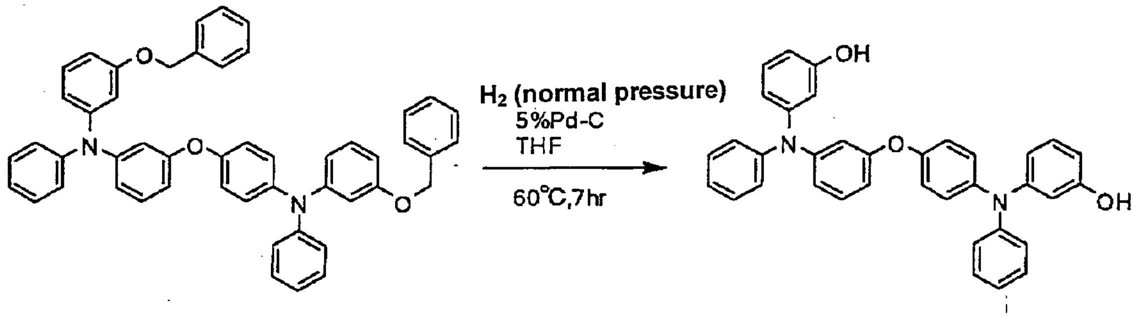


Target compound 25 Target compound 26

The target compound 25 (14.8 g) was dissolved in tetrahydrofuran (100 ml). Five percent Pd/C (2.20 g) was added to the tetrahydrofuran solution. The system was purged with hydrogen. Reduction was performed at 60°C for seven hours. After the completion of the reaction, the system was purged with nitrogen, the catalyst was filtered off, and the filtrate was concentrated. Purification by silica gel column chromatography (hexane/methylene chloride) yielded a target compound 26 (10.00 g).

Synthesis of Target Compound 27

[Formula 94]

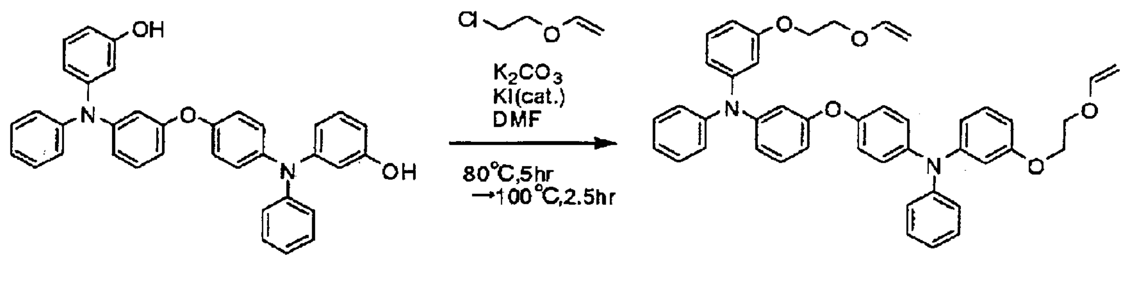


Target compound 26

Target compound 27

The target compound 26 (3.05 g), 2-chloroethyl vinyl ether (2.42 g), potassium carbonate (3.53 g), and N,N-dimethylformamide (25 ml) were charged into a reactor. A small amount of potassium iodide was charged into the reactor. The mixture was stirred at 80°C for 5 hours and at 100°C for 2.5 hours. After the completion of the reaction, water was added to the reaction solution. The reaction solution was subjected to extraction with ethyl acetate. The resulting organic layer was washed twice with water and then with saturated saline. Sodium sulfate was added to the organic layer for dehydration. After concentration, a crude product was purified by silica gel column chromatography (hexane/methylene chloride and then hexane/ethyl acetate) to yield a target compound 27 (1.91 g).

The target compound 27 was identified by DEI-MS (m/z = 67 6 ($M^+$)).

(SYNTHESIS EXAMPLE 9)

Synthesis of Target Compound 28

[Formula 95]

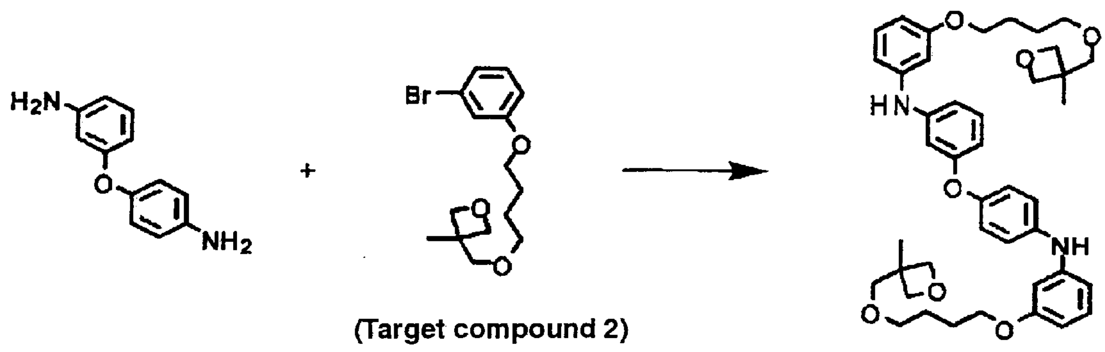

(Target compound 2)

(Target compound 28)

In a nitrogen stream, a solution prepared by stirring tris(dibenzylideneacetone)dipalladium (0) chloroform complex (0.071 g), bis(triphenylphosphino)ferrocene (0.152 g), and toluene (5 ml) at 60°C for 15 minutes in a nitrogen atmosphere was added to a solution of 3,4'-diaminodiphenyl ether (2.74 g), the target compound 2 (9.00 g), sodium tert-butoxide (3.69 g), and toluene (50 ml). The resulting product was stirred at 85°C for two hours. After cooling the product, toluene and activated clay were added to the product. After stirring the product for 15 minutes, insoluble matter was filtered off. The filtrate was concentrated and purified by silica gel chromatography (a liquid mixture of ethyl acetate/methylene chloride) to yield a target compound 28 (6.52 g).

Synthesis of Target Compound 29

[Formula 96]

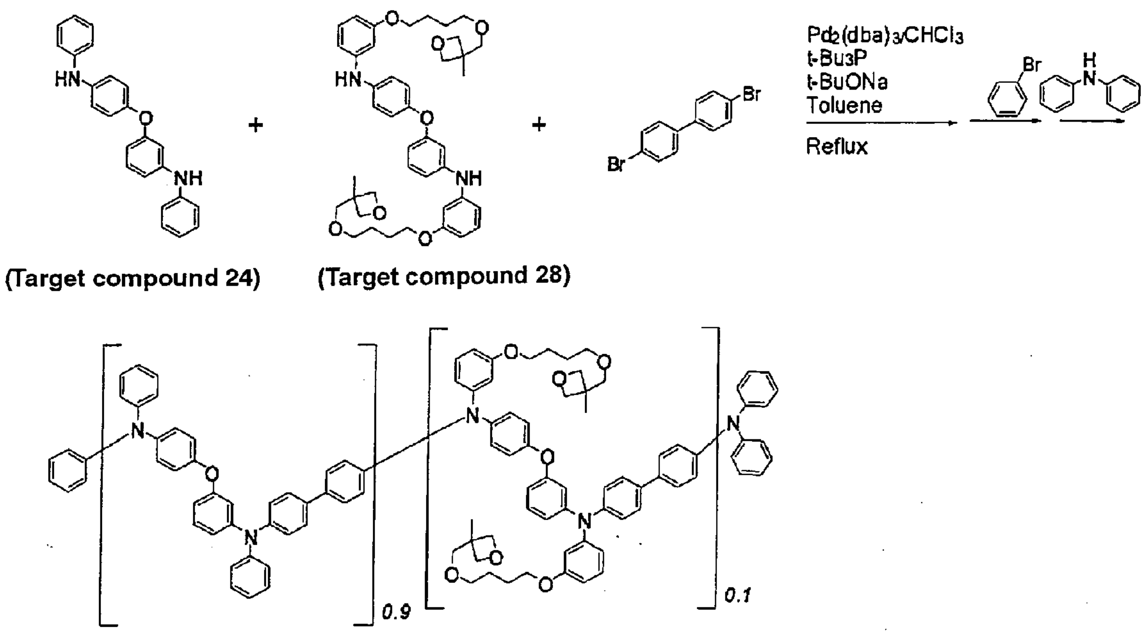


(Target compound 24) (Target compound 28)

(Target compound 29)

In a nitrogen stream, a solution prepared by stirring a tris(dibenzylideneacetone)dipalladium (0) chloroform complex (0.098 g), tri-tert-butylphosphine (0.153 g), and toluene (10 ml) at 60°C for 15 minutes in a nitrogen atmosphere was added to a solution of the target compound 24 (3.06 g), the target compound 28 (0.659 g), 4,4'-dibromobiphenyl (2.95 g), sodium tert-butoxide (2.91 g), and toluene (30 ml). The resulting product was stirred under reflux for one hour. 4,4'-dibromobiphenyl (0.030 g) was then added to the product. The product was stirred under reflux for one hour. 4,4'-dibromobiphenyl (0.029 g) and toluene (10 ml) were then added to the product. The product was stirred under reflux for one hour. Bromobenzene (0.149 g) was then added to the product. The product was stirred under reflux for one hour. Diphenylamine (0.320 g) and toluene (5 ml) were then added to the product. A solution prepared by stirring a tris(dibenzylideneacetone)dipalladium (0) chloroform complex (0.049 g), tri-tert-butylphosphine (0.077 g), and toluene (5 ml) at 60°C for 15 minutes in a nitrogen atmosphere was added to the product. The product was stirred under reflux for 3.5 hours. The reaction solution was cooled and then added to methanol. Precipitated solid was washed in suspension with a methanol/water mixture and was filtered off. The resulting solid was dissolved in toluene and subjected to suction filtration. The filtrate was subjected to reprecipitation in acetone. Precipitated solid was filtered off and dissolved in toluene. The toluene solution was subjected to reprecipitation in acetone. Precipitated solid was filtered off and dissolved in toluene. The toluene solution was subjected to reprecipitation in methanol to yield a target compound 29 (3.09 g).

This polymer compound had a weight-average molecular weight (Mw) of 144000 and a number-average molecular weight (Mn) of 31100.

The target compound 29 had an average number of cross-linking groups per constitutional repeating unit of 0.2.

(SYNTHESIS EXAMPLE 10)

Synthesis of Target Compound 30

[Formula 97]

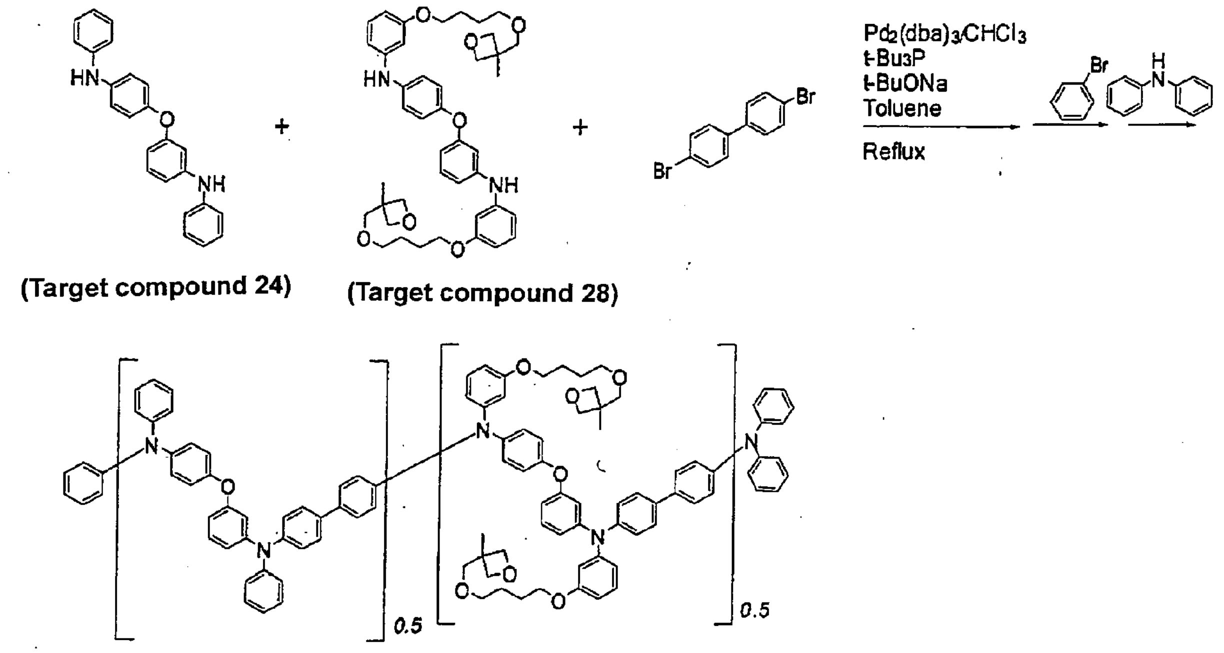


(Target compound 24) (Target compound 28)

(Target compound 30)

The target compound 24 (3.00 g), the target compound 28 (5.93 g), 4,4'-dibromobiphenyl (5.02 g), sodium tert-butoxide (4.49 g), and toluene (35 ml) were charged. The system was sufficiently purged with nitrogen and heated to 50°C (solution A). Tri-t-butylphosphine (0.31 g) was added to 5 ml of toluene solution of a tris(dibenzylideneacetone)dipalladium chloroform complex (0.20 g). The solution was heated to 50°C (solution B). In a nitrogen stream, the solution B was added to the solution A. The mixed solution was allowed to react under reflux for two hours. The reaction solution was cooled and added dropwise to 200 ml of methanol/ethanol to crystallize a crude polymer.

The resulting crude polymer was dissolved in 240 ml of toluene. Bromobenzene (0.53 g) and sodium tert-butoxide (0.82 g) were added to the toluene solution. The system was sufficiently purged with nitrogen and heated to 60°C (solution C). Tri-tert-butylphosphine (0.138 g) was added to 10 ml of toluene solution of a tris(dibenzylideneacetone)dipalladium (0) chloroform complex (0.088 g). The solution was heated to 60°C (solution D). In a nitrogen stream, the solution D was added to the solution C. The mixed solution was allowed to react under reflux for one hour. N,N-diphenylamine (0.85 g) was added to the reaction solution. The reaction solution was allowed to react under reflux for two hours. The reaction solution was cooled and added dropwise to ethanol to yield a crude polymer. The crude polymer was dissolved in toluene. The toluene solution was subjected to reprecipitation in acetone. A precipitated polymer was filtered off. The resulting polymer was dissolved in toluene. The toluene solution was washed with diluted hydrochloric acid and subjected to reprecipitation in ethanol containing ammonia. A filtered polymer was purified by column chromatography to yield a target compound 30 (4.36 g).

This polymer compound had a weight-average molecular weight (Mw) of 92400 and a number-average molecular weight (Mn) of 39800.

The target compound 30 had an average number of cross-linking groups per constitutional repeating unit of 1.0.

[Manufacture of Organic Electroluminescent Element]

EXAMPLE 1

An organic electroluminescent element illustrated in Fig. 1 was manufactured.

An indium tin oxide (ITO) transparent electroconductive film having a thickness of 120 nm deposited on a glass substrate 1 (a sputtered film manufactured by Sanyo Vacuum Industries Co., Ltd.) was patterned into stripes each having a width of 2 mm by a common photolithography technique and hydrochloric acid etching to form an anode 2. The patterned ITO substrate was washed by ultrasonic cleaning with an aqueous surfactant solution, washing with ultrapure water, ultrasonic cleaning with ultrapure water, and washing with ultrapure water in this order, was dried with compressed

air, and was finally subjected to ultraviolet-ozone cleaning.

A coating solution for forming a hole-injection layer was first prepared. The coating solution contained a hole-transporting polymeric material having a repeating structure of the following structural formula (P1) (weight-average molecular weight: 26500, number-average molecular weight: 12000), 4-isopropyl-4'-methyldiphenyliodoniumtetrakis(pentafluorophenyl)borate having the structural formula (A1), and ethyl benzoate. The coating solution had the following composition. The coating solution was applied to the anode 2 by spin coating under the following conditions to form a hole-injection layer 3 having a thickness of 30 nm.

[Formula 98]

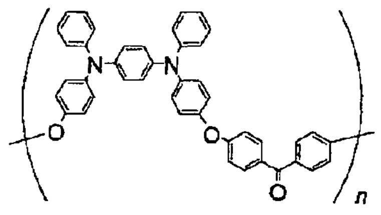

P1

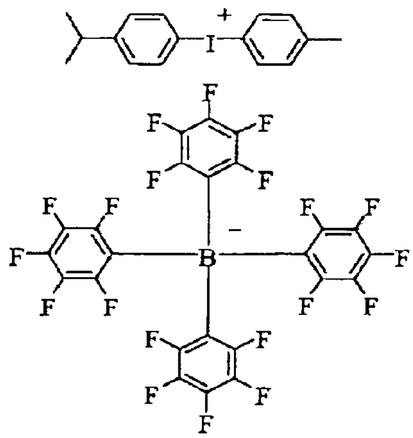

A1

<Composition of Coating Solution for Forming Hole-Injection Layer>

Solvent ethyl benzoate
Concentration of coating solutionP1: 2.0% by weight
A1: 0.8% by weight

<Deposition Conditions for Hole-Injection Layer>

Number of revolutions of spinner 1500 rpm
Time of rotation of spinner 30 seconds
Spin coating atmosphere in the atmosphere
Heating conditions at 230°C for three hours in the atmosphere
Subsequently, a hole-transporting layer 4 having a thickness of 16 nm was formed by applying a composition for use in an organic device by spin coating under the following conditions and heating the composition to polymerize. The composition for use in an organic device contained a cross-linking compound having one cross-linking group (H1) (the target compound 3 synthesized in Synthesis Example 1), a cross-linking compound having two cross-linking groups (H2) (the target compound 8 synthesized in Synthesis Example 2), and xylene in the following composition. H1 and H2 had the following structural formulae.

[Formula 99]

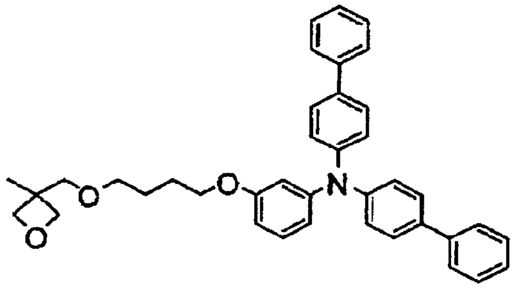

(H1)

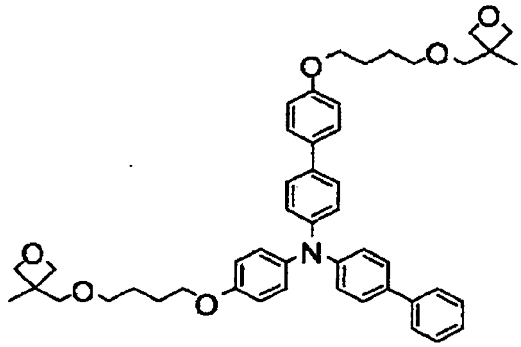

(H2)

<Composition for use in Organic Device>

Solvent xylene
Solid content 1.0% by weight
Composition of solid contents (H1):(H2) = 90:10 (molar ratio)

<Deposition Conditions for Hole-Transporting Layer>

Number of revolutions of spinner 1500 rpm
Time of rotation of spinner 30 seconds
Spin coating atmosphere in nitrogen
Heating conditions at 200°C for one hour in nitrogen
A coating solution for forming a light-emitting layer was then prepared. The coating solution contained compounds (C1), (C2), and (C3) having the following structural formulae and xylene, and had the following composition. The coating solution was applied by spin coating under the following conditions to form a light-emitting layer 5 having a thickness of 40 nm.

[Formula 100]

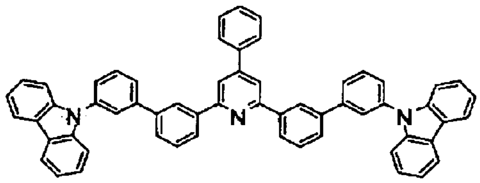

(C1)

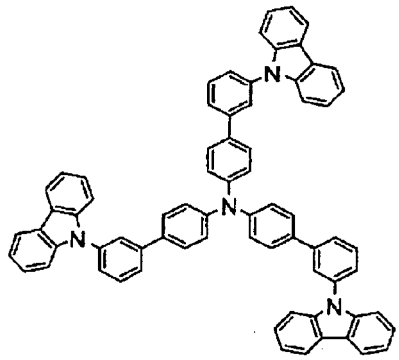

(C2)

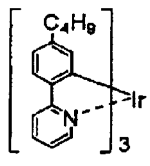

(C3)

<Composition of Coating Solution for Forming Light-Emitting Layer>

Solvent xylene
Concentration of coating solutionC1: 1.0% by weight
C2: 1.0% by weight
C3: 0.1% by weight

<Deposition Conditions for Light-Emitting Layer>

Number of revolutions of spinner 1500 rpm
Time of rotation of spinner 30 seconds
Spin coating atmosphere in nitrogen
Baking conditions at 130°C for one hour in a vacuum
The substrate on which the hole-injection layer 3, the hole-transporting layer 4, and the light-emitting layer 5 were formed was placed in a multi-chamber vacuum evaporator coupled with a glove box without exposing the substrate to the air. The vacuum evaporator was roughly evacuated with an oil-sealed rotary pump and was then evacuated with a cryopump to a vacuum of 5.3 x $10^{-5}$ Pa or less. A compound having the following structural formula (C4) was deposited by a vacuum evaporation method to form a hole-blocking layer 6. During the vapor deposition, the degree of vacuum was controlled in the range of 3.1 to 4.8 x $10^{-5}$ Pa, and the vapor-deposition rate was controlled in the range of 0.6 to 1.1 angstroms/second. The hole-blocking layer 6 having a thickness of 5 nm was formed on the light-emitting layer 5.

[Formula 101]

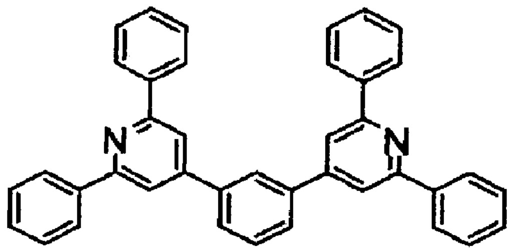

(C4)

Tris(8-hydroxyquinolinate)aluminum (Alq3) having the following structural formula (C5) was then heated for vapor deposition, forming an electron-transporting layer 7. During the vapor deposition, the degree of vacuum was controlled in the range of 2.9 to 4.9 x $10^{-5}$ Pa, and the vapor-deposition rate was controlled in the range of 0.7 to 1.3 angstroms/second. The electron-transporting layer 7 having a thickness of 30 nm was formed on the hole-blocking layer 6.

[Formula 102]

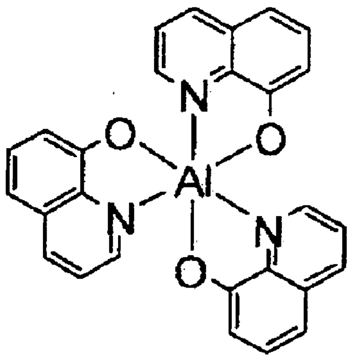

(C5)

An element on which layers up to the electron-transporting layer 7 were deposited was conveyed from an organic layer evaporation chamber in which layers up to the electron-transporting layer were deposited into a metallization chamber in a vacuum. As a mask used in vapor deposition of a cathode, a shadow mask having stripes each 2 mm in width was brought into close contact with the element such that the stripes intersect with the ITO stripes of the anode 2 at right angles. The metallization chamber was installed in another vacuum evaporator. The vacuum evaporator was evacuated to a vacuum of 8.7 x $10^{-5}$ Pa or less, as in the vapor deposition of the organic layer.

Lithium fluoride (LiF) having a thickness of 0.5 nm was first deposited as an electron-injection layer 8 on the

electron-transporting layer 7 using a molybdenum boat at a vapor-deposition rate in the range of 0.07 to 0.15 angstroms/second and a vacuum in the range of 4.7 to 10.0 x $10^{-5}$ Pa. Aluminum was then heated on a molybdenum boat in the same manner to form an aluminum layer having a thickness of 80 nm as a cathode 9 at a vapor-deposition rate in the range of 0.6 to 16.0 angstroms/second and a vacuum in the range of 2.0 to 13.0 x $10^{-5}$ Pa. The substrate temperature in the vapor deposition of these two layers was kept at room temperature.

Subsequently, to prevent the element from deteriorating owing to water in the atmosphere during storage, sealing was performed by the following method.

A photocurable resin (30Y-437 manufactured by ThreeBond Co., Ltd.) was applied at a width of about 1 mm to an outer area of a glass plate 23 mm x 23 mm in size in a nitrogen glove box coupled with a vacuum evaporator. A water getter sheet (Dynic Co.) was placed in the central part of the glass plate. A substrate on which a cathode had been formed was stuck on the glass plate such that the deposited layer faced the drying agent sheet. Only the area to which the photocurable resin was applied was irradiated with ultraviolet light to cure the resin.

Through these processes, an organic electroluminescent element having a luminous area 2 mm x 2 mm in size was manufactured.

Table 1 shows the normalized operation life of the organic electroluminescent element thus manufactured at an initial luminance of 2500 cd/$m^2$.

As shown in Table 1, a composition for producing the at least one organic layer can be used to provide a long-life element.

EXAMPLE 2

An organic electroluminescent element illustrated in Fig. 1 was manufactured in the same manner as Example 1, except that the composition ratio of the cross-linking compounds (H1) and (H2) in the composition for use in an organic device for forming a hole-transporting layer 4 in Example 1 was altered as described below to form a hole-transporting layer 4 having a thickness of 21 nm.

<Composition for use in Organic Device>

Solvent xylene
Solid content 1.0% by weight
Composition of solid contents (H1):(H2) = 70:30 (molar ratio)

<Deposition Conditions for Hole-Transporting Layer>

Number of revolutions of spinner 1500 rpm
Time of rotation of spinner 30 seconds
Spin coating atmosphere in nitrogen
Heating conditions at 200°C for one hour in nitrogen
Table 1 shows the normalized operation life of the organic electroluminescent element thus manufactured at an initial luminance of 2500 cd/$m^2$.

As shown in Table 1, a composition for producing the at least one organic layer can be used to provide a long-life element.

EXAMPLE 3

An organic electroluminescent element illustrated in Fig. 1 was manufactured in the same manner as Example 1, except that the composition ratio of the cross-linking compounds (H1) and (H2) in the composition for use in an organic device for forming a hole-transporting layer 4 in Example 1 was altered as described below to form a hole-transporting layer 4 having a thickness of 14 nm.

<Composition for use in Organic Device>

Solvent xylene
Solid content 1.0% by weight
Composition of solid contents (H1):(H2) = 95:5 (molar ratio)
Table 1 shows the normalized operation life of the organic electroluminescent element thus manufactured at an initial luminance of 2500 cd/$m^2$.

As shown in Table 1, a composition for use in an organic device according to the present invention can be used

to provide a long-life element.

EXAMPLE 4

An organic electroluminescent element illustrated in Fig. 1 was manufactured in the same manner as Example 1, except that a composition having the following composition and containing the aforementioned cross-linking compounds (H1) and (H2), a cross-linking compound (H3) having the following structure (the target compound 20 synthesized in Synthesis Example 5), and xylene was used as a composition for use in an organic device for forming a hole-transporting layer 4 to form a film by spin coating under the following conditions, the film was heated for polymerization, and the film after polymerization was subjected to xylene rinse to form a hole-transporting layer 4 having a thickness of 17 nm, and except that a coating solution for forming a light-emitting layer for forming a light-emitting layer 5 was replaced by a coating solution having the following composition.

[Formula 103]

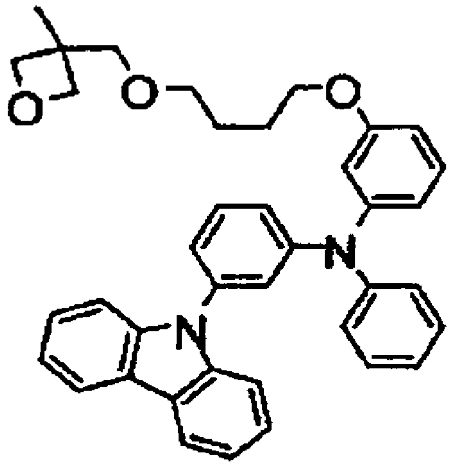

(H3)

<Composition for use in Organic Device>

Solvent xylene
Solid content 1.0% by weight
Composition of solid contents (H1):(H2):(H3) = 50:40:10 (molar ratio)

<Deposition Conditions for Hole-Transporting Layer>

Number of revolutions of spinner 1500 rpm
Time of rotation of spinner 30 seconds
Spin coating atmosphere in nitrogen
Heating conditions at 200°C for one hour in nitrogen

<Composition of Coating Solution for Forming Light-Emitting Layer>

Solvent xylene
Concentration of coating solutionC1: 1.8% by weight
C2: 0.2% by weight
C3: 0.1% by weight

Table 1 shows the normalized operation life of the organic electroluminescent element thus manufactured at an initial luminance of 5000 cd/$m^2$.

As shown in Table 1, a composition for use in an organic device according to the present invention can be used to provide a long-life element.

COMPARATIVE EXAMPLE 1

An organic electroluminescent element illustrated in Fig. 1 was manufactured in the same manner as Example 1, except that only the aforementioned cross-linking compound (H2) was used in the following composition as a cross-linking compound contained in a composition for use in an organic device for forming a hole-transporting layer 4 to form a film by spin coating under the following conditions. The film was heated for polymerization, forming a hole-transporting layer 4 having a thickness of 18 nm.

<Composition for use in Organic Device>

Solvent xylene
Solid content 0.8% by weight
Composition of solid contents (H2)

<Deposition Conditions for Hole-Transporting Layer>

Number of revolutions of spinner 1500 rpm
Time of rotation of spinner 30 seconds Spin coating atmosphere in nitrogen
Heating conditions at 130°C for one hour in a vacuum

Table 1 shows the normalized operation life of the organic electroluminescent element thus manufactured at an initial luminance of 2500 cd/$m^2$.

[Table 1]

| | Composition of a cross-linking compound in a composition for use in an organic device for forming a hole-transporting layer (molar ratio) | Operation life normalized to Comparative Example 1, which was set at 1 | Initial luminance in operation test (cd/$m^2$) |
|---|---|---|---|
| Example1 | (H1):(H2)=90:10 | 5.55 | 2500 |
| Example2 | (H1):(H2)=70:30 | 2.90 | 2500 |
| Example3 | (H1):(H2)=95:5 | 5.85 | 2500 |
| Example4 | (H1):(H2):(H3)= 50:10:40 | 0.95 | 5000 |
| Comparative Example1 | (H2)alone | 1 | 2500 |

EXAMPLE 5

An organic electroluminescent element illustrated in Fig. 1 was manufactured in the same manner as Example 1, except that a composition having the following composition and containing cross-linking compounds (H4) (the target compound 16 synthesized in Synthesis Example 4) and (H5) (the target compound 12 synthesized in Synthesis Example 3) having the following structures and toluene was used as a composition for use in an organic device for forming a hole-transporting layer 4 to form a hole-transporting layer 4 having a thickness of 24 nm, and except that the composition of a coating solution for forming a light-emitting layer for forming a light-emitting layer 5 was replaced by the composition having the following conditions.

[Formula 104]

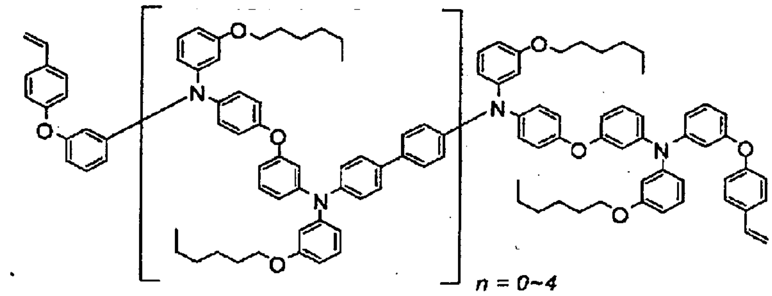

n = 0~4

(H4)

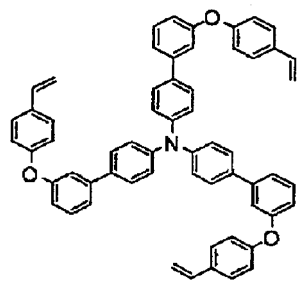

(H5)

<Composition for use in Organic Device>

Solvent toluene
Solid content 0.5% by weight
Composition of solid contents (H4):(H5) = 95:5 (molar ratio)

<Composition of Coating Solution for Forming Light-Emitting Layer>

Solvent xylene
Concentration of coating solutionC1: 1.8% by weight
C2: 0.2% by weight
C3: 0.1% by weight
Table 2 shows the normalized operation life of the organic electroluminescent element thus manufactured at an initial luminance of 2500 cd/$m^2$.

As shown in Table 2, a composition for use in an organic device according to the present invention can be used to provide a long-life element.

EXAMPLE 6

An organic electroluminescent element illustrated in Fig. 1 was manufactured in the same manner as Example 5, except that a composition for use in an organic device having the following composition and containing the aforementioned cross-linking compound (H4), a cross-linking compound having the following structure (H6) (the target compound 18 synthesized in Synthesis Example 5), and xylene was used to form a film by spin coating under the following conditions, and the film was irradiated with ultraviolet rays and then heated for polymerization to form a hole-transporting layer 4 having a thickness of 22 nm.

[Formula 105]

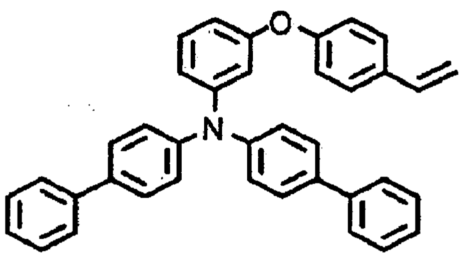

(H6)

<Composition for use in Organic Device>

Solvent xylene
Solid content 1.0% by weight
Composition of solid contents (H4):(H6) = 95:5 (molar ratio)

<Deposition Conditions for Hole-Transporting Layer>

Number of revolutions of spinner 1500 rpm
Time of rotation of spinner 30 seconds
Spin coating atmosphere in nitrogen
UV exposure conditions 5 $J/cm^2$ in nitrogen
Heating conditions at 200°C for one hour in nitrogen
Table 2 shows the normalized operation life of the organic electroluminescent element thus manufactured at an initial luminance of 2500 $cd/m^2$.

As shown in Table 2, a composition for use in an organic device according to the present invention can be used to provide a long-life element.

COMPARATIVE EXAMPLE 2

An organic electroluminescent element illustrated in Fig. 1 was manufactured in the same manner as Example 5, except that only the aforementioned cross-linking compound (H4) was used in the following composition as a cross-linking compound contained in a composition for use in an organic device for forming a hole-transporting layer 4 to form a hole-transporting layer 4 having a thickness of 22 nm.

<Composition for use in Organic Device>

Solvent xylene
Solid content 1.0% by weight
Composition of solid contents (H4)
Table 2 shows the normalized operation life of the organic electroluminescent element thus manufactured at an initial luminance of 2500 $cd/m^2$.

[Table 2]

| | Composition of a cross-linking compound in a composition for use in an organic device for forming a hole-transporting layer (molar ratio) | Operation life normalized to Comparative Example 1, which was set at 1 | Initial luminance in operation test ($cd/m^2$) |
|---|---|---|---|
| Example5 | (H4) : (H5) =95: 5 | 1.61 | 2500 |
| Example6 | (H4) : (H6)=90: 10 | 1.06 | 2500 |
| Comparative Example2 | (H4) alone | 1 | 2500 |

REFERENCE EXAMPLE 7 (not part of the claimed invention)

An organic electroluminescent element was manufactured in the same manner as Example 1, except that a composition containing cross-linking compounds (H7) (the target compound 23 synthesized in Synthesis Example 7) and (H8) (the target compound 27 synthesized in Synthesis Example 8) having the following structures and xylene was used as a composition for use in an organic device for forming a hole-transporting layer 4 to form a hole-transporting layer 4 having a thickness of 19 nm, and except that a coating solution for forming a light-emitting layer for forming a light-emitting layer 5 was replaced by a coating solution having the following conditions.

[Formula 106]

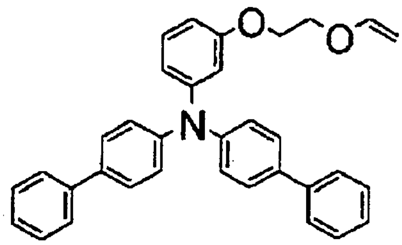

(H7)

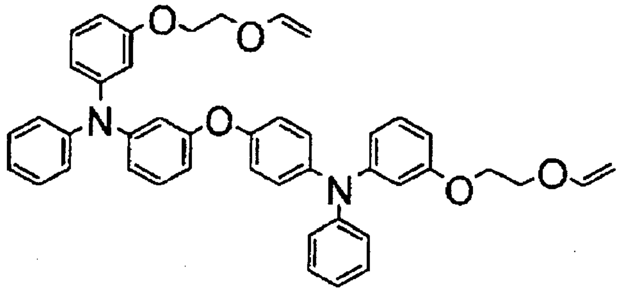

(H8)

<Composition for use in Organic Device>

Solvent xylene
Solid content 1.0% by weight
Composition of solid contents (H7):(H8) = 70:30 (molar ratio)

<Composition of Coating Solution for Forming Light-Emitting Layer>

Solvent xylene
Concentration of coating solutionC1: 1.8% by weight
C2: 0.2% by weight
C3: 0.1% by weight
Table 3 shows the time at which the luminance became 90% of the initial luminance of 2500 cd/$m^2$ in the organic electroluminescent element thus manufactured during direct-current operation. The time was normalized to the time in Comparative Example 3.

COMPARATIVE EXAMPLE 3

An organic electroluminescent element was manufactured in the same manner as Reference Example 7, except that only the aforementioned cross-linking compound (H8) was used as a cross-linking compound in a composition for use in an organic device for forming a hole-transporting layer 4 to form a hole-transporting layer 4 having a thickness of 16 nm.

<Composition for use in Organic Device>

Solvent xylene
Solid content 0.7% by weight
Composition of solid contents (H8) alone
Table 3 shows the time at which the luminance became 90% of the initial luminance of 2500 cd/$m^2$ in the organic electroluminescent element thus manufactured during direct-current operation. The time was normalized to the time in Comparative Example 3.

[Table 3]

| | Composition of a cross-linking compound in a composition for use in an organic device for forming a hole-transporting layer (molar ratio) | Operation life time at which the luminance became 90% of the initial luminance, normalized to Comparative Example 3, which was set at 1 | Initial luminance in operation test (cd/$m^2$) |
|---|---|---|---|
| Example 7 | (H7) : (H8) =70:30 | 2. 15 | 2500 |
| Comparative Example 3 | (H8) alone | 1 | 2500 |

Note: Example 7 is a Reference Example outside the scope of the claims.

EXAMPLE 8

An organic electroluminescent element illustrated in Fig. 1 was manufactured.

Layers up to a hole-injection layer 3 were formed in the same manner as Example 1. A composition having the following composition and containing cross-linking compounds (H9) (the target compound 29 synthesized in Synthesis Example 9) and (H10) (the target compound 30 synthesized in Synthesis Example 10) having the following structures and toluene was used as a composition for use in an organic device for forming a hole-transporting layer 4 to form a film by spin coating under the following conditions. The film was heated for polymerization, forming a hole-transporting layer 4 having a thickness of 20 nm.

[Formula 107]

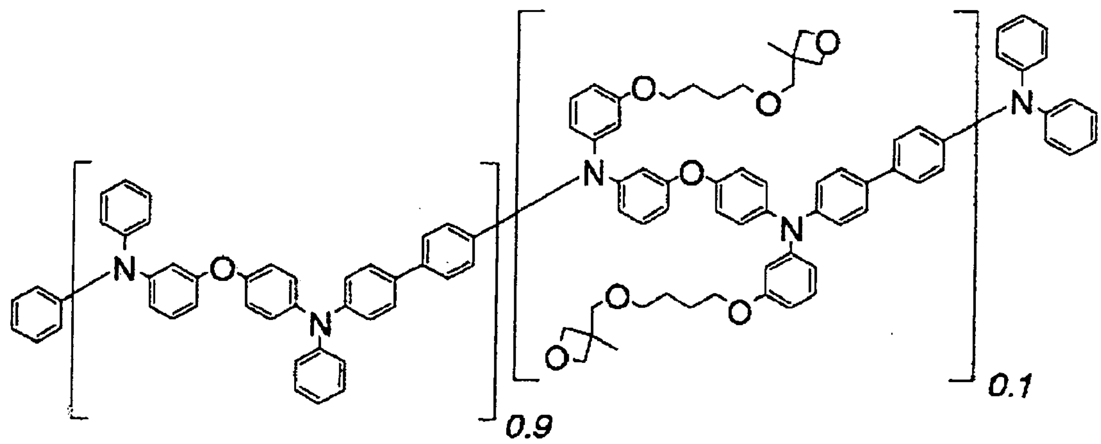

(H9)

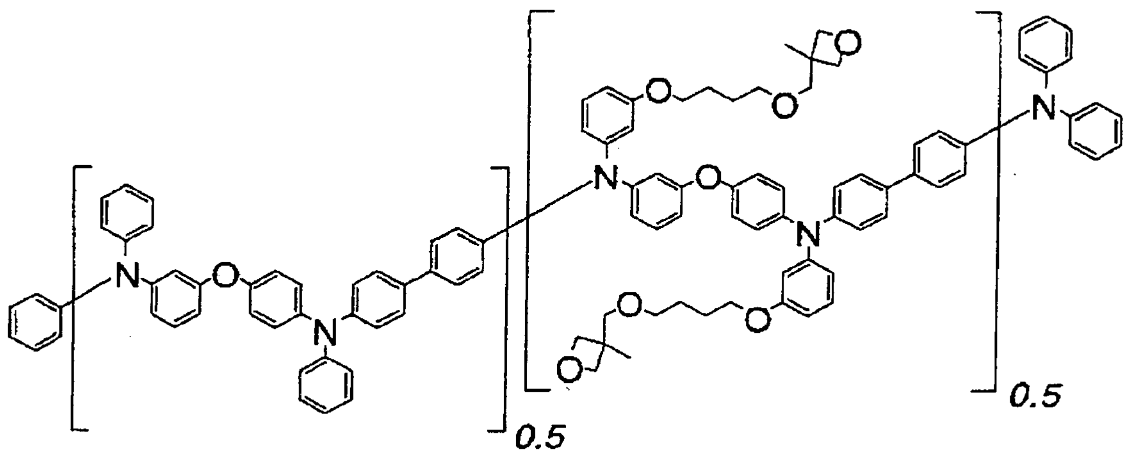

(H10)

<Composition for use in Organic Device>

Solvent toluene

Concentration of coating solutionH9: 0.2% by weight

H10: 0.2% by weight

<Deposition Conditions for Hole-Transporting Layer>

Number of revolutions of spinner 1500 rpm
Time of rotation of spinner 30 seconds
Spin coating atmosphere in nitrogen
Heating conditions at 180°C for 15 minutes in nitrogen
The compounds (C1), (C2), and (C3) used in Example 1 were used to prepare a coating solution for forming a light-emitting layer. The coating solution had the following composition. The coating solution was applied to the hole-transporting layer 4 by spin coating under the following conditions to form a light-emitting layer 5 having a thickness of 60 nm.

<Composition of Coating Solution for Forming Light-Emitting Layer>

Solvent xylene
Concentration of coating solutionC1: 1.8% by weight
C2: 0.2% by weight
C1: 0.1% by weight

<Deposition Conditions for Light-Emitting Layer>

Number of revolutions of spinner 1500 rpm
Time of rotation of spinner 30 seconds
Spin coating atmosphere in nitrogen
Baking conditions at 130°C for one hour in a vacuum
The substrate on which layers up to the light-emitting layer 5 were formed was conveyed into a vacuum evaporator. The vacuum evaporator was roughly evacuated with an oil-sealed rotary pump and was then evacuated with a cryopump to a vacuum of 2.4 x $10^{-4}$ Pa or less. A compound having the following structural formula (C6) was deposited by a vacuum evaporation method to form a hole-blocking layer 6. The vapor-deposition rate was controlled in the range of 0.7 to 0.8 angstroms/second. The hole-blocking layer 6 having a thickness of 10 nm was formed on the light-emitting layer 5. The degree of vacuum in the vapor deposition ranged from 2.4 to 2.7 x $10^{-4}$ Pa.

[Formula 108]

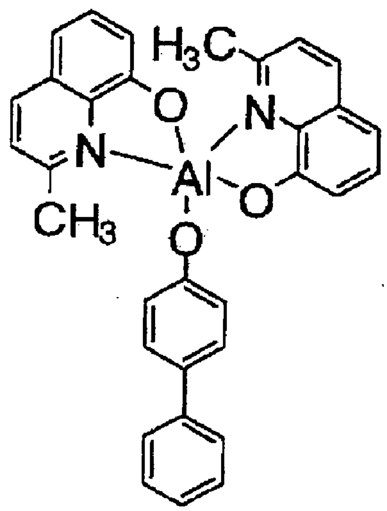

(C6)

Tris(8-hydroxyquinolinate)aluminum (Alq3) used in Example 1 was then heated for vapor deposition, forming an electron-transporting layer 7. During the vapor deposition, the degree of vacuum was controlled in the range of 0.4 to 1.6 x $10^{-4}$ Pa, and the vapor-deposition rate was controlled in the range of 1.0 to 1.5 angstroms/second. The electron-transporting layer 7 having a thickness of 10 nm was formed on the hole-blocking layer 6.

An element on which layers up to the electron-transporting layer 7 were deposited was transferred from the

vacuum evaporator into the atmosphere. As a mask used in vapor deposition of a cathode, a shadow mask having stripes each 2 mm in width was brought into close contact with the element such that the stripes intersect with the ITO stripes of the anode 2 at right angles. The element was placed in another vacuum evaporator. The vacuum evaporator was evacuated to a vacuum of 6.4 x $10^{-4}$ Pa or less, as in the vapor deposition of the organic layer.

Lithium fluoride (LiF) having a thickness of 0.5 nm was first deposited as an electron-injection layer 8 on the electron-transporting layer 7 using a molybdenum boat at a vapor-deposition rate in the range of 0.1 to 0.4 angstroms/second and a vacuum in the range of 3.2 to 6.7 x $10^{-4}$ Pa. Aluminum was then heated on a molybdenum boat in the same manner to form an aluminum layer having a thickness of 80 nm as a cathode 9 at a vapor-deposition rate in the range of 0.7 to 5.3 angstroms/second and a vacuum in the range of 2.8 to 11.1 x $10^{-4}$ Pa. The substrate temperature in the vapor deposition of these two layers was kept at room temperature.

Subsequently, to prevent the element from deteriorating owing to water in the atmosphere during storage, sealing was performed in the same manner as Example 1.

Through these processes, an organic electroluminescent element having a luminous area 2 mm x 2 mm in size was manufactured. Table 4 shows some characteristics (the normalized half-life at which the luminance became half the initial luminance of 2500 cd/$m^2$ during direct-current operation, and the current efficiency at 100 cd/$m^2$. The normalized half-life was a half-life normalized to the half-life in Comparative Example 4.) of the element thus manufactured.

COMPARATIVE EXAMPLE 4

An organic electroluminescent element illustrated in Fig. 1 was manufactured in the same manner as Example 8, except that only the aforementioned cross-linking compound (H10) was used in the following composition as a cross-linking compound contained in a composition for use in an organic device for forming a hole-transporting layer 4 to form a hole-transporting layer 4 having a thickness of 20 nm. Table 4 shows some characteristics of the element thus manufactured.

<Composition for use in Organic Device>

Solvent toluene
Concentration of coating solutionH10: 0.4% by weight

[Table 4]

| | Composition of a cross-linking compound in a composition for use in an organic device for forming a hole-transporting layer (weight ratio) | Luminance half-life normalized to Comparative Example 4, which was set at 1 | Current efficiency at 100 cd/$m^2$ [cd/A] |
|---|---|---|---|
| Example 8 | (H9) : (H10)=50:50 | 3.5 | 26.0 |
| Comparative Example 4 | (H10) alone | 1 | 21.9 |

As is clear from these results, organic electroluminescent elements according to Examples in which the hole-transporting layer was formed using a composition that contained at least two cross-linking compounds having different numbers of cross-linking groups were more efficient, had less luminance deterioration during operation, and were more stable than elements according to Comparative Examples in which the hole-transporting layer was formed using a composition that contained a single cross-linking compound.

The present invention can be suitably used in various fields in which organic electroluminescent elements are used, for example, flat-panel displays (for example, for use in office automation computers and wall-mounted television sets), light sources that utilize the characteristics of a surface illuminant (for example, light sources for use in copying machines and backlight sources for use in liquid crystal displays and measuring instruments), display boards, and marker lamps.

## Claims

1. An organic electroluminescent element that comprises an anode and a cathode on a substrate and at least one organic layer disposed between the anode and the cathode,
wherein the at least one organic layer is a layer that is produced by forming a film of a composition that comprises

at least two cross-linking compounds and polymerizing the cross-linking compounds,
wherein at least two of the cross-linking compounds have different numbers of cross-linking groups selected from

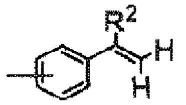
and
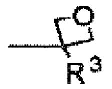

wherein $R^2$ to $R^3$ each independently denote a hydrogen atom or an alkyl group, and wherein the crosslinking compounds are compounds having a partial structure of the following formula [109]:

[Formula 109]

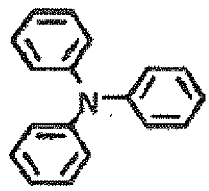

2. A method for producing an organic electroluminescent element that comprises an anode and a cathode on a substrate and at least one organic layer disposed between the anode and the cathode, the method comprising producing the at least one organic layer by forming a film of a composition that comprises at least two cross-linking compounds and polymerizing the cross-linking compounds,
wherein at least two of the cross-linking compounds have different numbers of cross-linking groups selected from

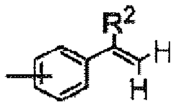
and
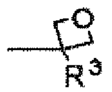

wherein $R^2$ to $R^3$ each independently denote a hydrogen atom or an alkyl group, and wherein the crosslinking compounds are compounds having a partial structure of the following formulae [109]:

[Formula 109]

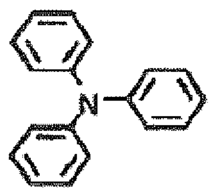

## Patentansprüche

1. Organisches Elektrolumineszenzelement, das eine Anode und eine Kathode auf einem Substrat und zumindest eine organische Schicht, die zwischen der Anode und der Kathode angeordnet ist, umfasst,
wobei die zumindest eine organische Schicht eine Schicht ist, die durch Bilden eines Films aus einer Zusammensetzung, die zumindest zwei vernetzende Verbindungen umfasst, und Polymerisieren der vernetzenden Verbindungen hergestellt ist,
wobei zumindest zwei der vernetzenden Verbindungen eine unterschiedliche Anzahl an vernetzenden Gruppen, ausgewählt aus

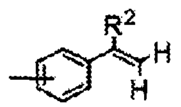
und
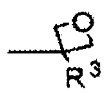
,

aufweisen, worin $R^2$ bis $R^3$ jeweils unabhängig ein Wasserstoffatom oder eine Alkylgruppe bezeichnen, und wobei die vernetzenden Verbindungen Verbindungen sind, die eine Teilstruktur der nachstehenden Formel [109] aufweisen:

[Formel 109]

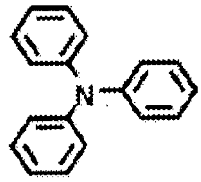

2. Verfahren zur Herstellung eines organischen Elektrolumineszenzelements, das eine Anode und eine Kathode auf einem Substrat und zumindest eine organische Schicht, die zwischen der Anode und der Kathode angeordnet ist, umfasst, wobei das Verfahren die Herstellung von zumindest einer organischen Schicht durch Bilden eines Films aus einer Zusammensetzung, die zumindest zwei vernetzende Verbindungen umfasst, und Polymerisieren der vernetzenden Verbindungen umfasst,
wobei zumindest zwei der vernetzenden Verbindungen eine unterschiedliche Anzahl an vernetzenden Gruppen, ausgewählt aus

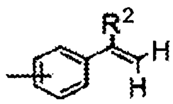 und 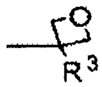 ,

aufweisen, worin $R^2$ bis $R^3$ jeweils unabhängig ein Wasserstoffatom oder eine Alkylgruppe bezeichnen, und wobei die vernetzenden Verbindungen Verbindungen sind, die eine Teilstruktur der nachstehenden Formel [109] aufweisen:

[Formel 109]

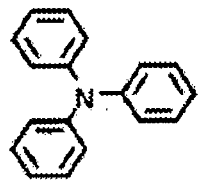

## Revendications

1. Elément électroluminescent organique comprenant une anode et une cathode sur un substrat et au moins une couche organique disposée entre l'anode et la cathode,
dans lequel la au moins une couche organique est une couche qui est fabriquée en formant un film d'une composition qui comprend au moins deux composés de réticulation et en polymérisant les composés de réticulation,
dans lequel au moins deux des composés de réticulation ont des nombres différents de groupes de réticulation choisis parmi

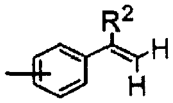 et 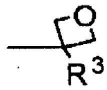

où $R^2$ à $R^3$ désignent chacun indépendamment un atome d'hydrogène ou un groupe alkyle, et
dans lequel les composés de réticulation sont des composés ayant une structure partielle de la formule [109] suivante :

[Formule 109]

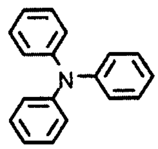

2. Procédé de fabrication d'un élément électroluminescent organique qui comprend une anode et une cathode sur un substrat et au moins une couche organique disposée entre l'anode et la cathode, le procédé comprenant la fabrication de la au moins une couche organique en formant un film d'une composition qui comprend au moins deux composés de réticulation et en polymérisant les composés de réticulation,
dans lequel au moins deux des composés de réticulation ont des nombres différents de groupes de réticulation choisis parmi

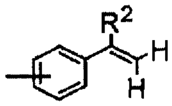

et

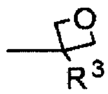

où $R^2$ à $R^3$ désignent chacun indépendamment un atome d'hydrogène ou un groupe alkyle, et
dans lequel les composés de réticulation sont des composés ayant une structure partielle de la formule [109]suivant :

[Formule 109]

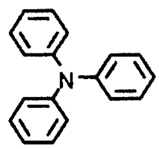

Fig. 1

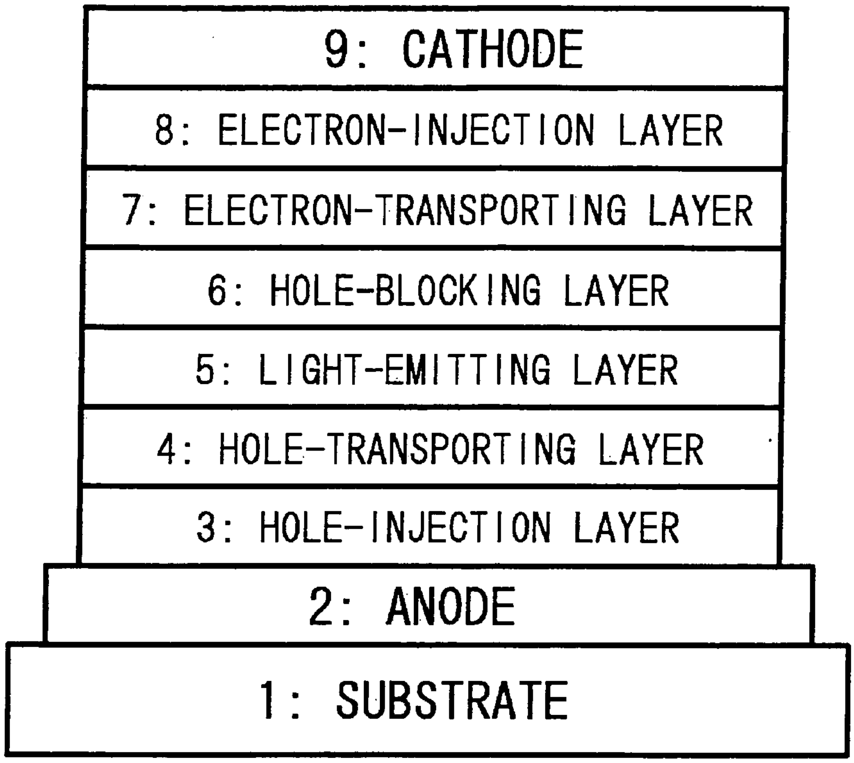
9: CATHODE
8: ELECTRON-INJECTION LAYER
7: ELECTRON-TRANSPORTING LAYER
6: HOLE-BLOCKING LAYER
5: LIGHT-EMITTING LAYER
4: HOLE-TRANSPORTING LAYER
3: HOLE-INJECTION LAYER
2: ANODE
1: SUBSTRATE

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004199935 A
- WO 2005089024 A
- WO 2005019373 A
- JP 5234681 A
- JP 11242996 A
- JP 7041759 A
- JP 10079297 A
- WO 2005022962 A
- JP 59194393 A
- US 5645948 A
- JP 6207169 A
- JP 5331459 A
- JP 10270171 A
- JP 2002100478 A
- JP 2002100482 A


### Non-patent literature cited in the description


- **BACHER.** Synthesis and Characterization of Photo-Cross-Linkable Hole-Conducting Polymers. *Macromolecules,* 2005, vol. 38, 1640-1647
- **SOLOMESHCH.** Electronic Formulations - Photopatterning of Luminescent Conjugated Polymers. *Adv. Funct. Mater.,* 2006, vol. 16, 2095-2102
- *Applied Physics Letters,* 1992, vol. 60, 2711
- *Journal of Luminescence,* 1997, vol. 72-74, 985
- *Chemical Communications,* 1996, 2175
- *Synthetic Metals,* 1997, vol. 91, 209